# EUROPÄISCHE PATENTSCHRIFT

(11) **EP 3 559 078 B1**
(45) Veröffentlichungstag und Bekanntmachung des Hinweises auf die Patenterteilung: **25.10.2023**
(21) Anmeldenummer: 17821585.1
(22) Anmeldetag: 19.12.2017
(51) Int. Cl.: H10K 50/15, H10K 85/60, H10K 85/10, C08G 61/12, H01B 1/12, C09D 165/00

(54) **MATERIALIEN FÜR ELEKTRONISCHE VORRICHTUNGEN**
MATERIALS FOR ELECTRONIC DEVICES
MATÉRIAUX POUR DISPOSITIFS ÉLECTRONIQUES

(30) Priorität: 22.12.2016 EP 16206079
(43) Veröffentlichungstag der Anmeldung: 30.10.2019
(73) Patentinhaber: Merck Patent GmbH, 64293 Darmstadt (DE)
(72) Erfinder: BURKHART, Beate, 64293 Darmstadt (DE); SCHEIBLE, Katja Maria, 64287 Darmstadt (DE); KOENEN, Nils, 64347 Griesheim (DE); HEIL, Holger, 60316 Frankfurt am Main (DE)
(86) Internationale Anmeldenummer: PCT/EP2017/083436
(87) Internationale Veröffentlichungsnummer: WO 2018/114882

(56) Entgegenhaltungen:
- WO-A1-2006/063852
- WO-A1-2013/156130
- WO-A1-2015/144298
- US-A1- 2012 056 170

## Beschreibung

Die vorliegende Anmeldung betrifft ein Polymer enthaltend mindestens eine Struktureinheit einer Formel (I) und mindestens eine weitere Struktureinheit, die gewählt ist aus Struktureinheiten A, B und C. Das Polymer eignet sich zur Verwendung in einer elektronischen Vorrichtung.

Unter elektronischen Vorrichtungen im Sinne dieser Anmeldung werden sogenannte organische elektronische Vorrichtungen verstanden (organic electronic devices), die organische Halbleitermaterialien als Funktionsmaterialien enthalten. Insbesondere werden darunter OLEDs verstanden. Unter der Bezeichnung OLEDs werden elektronische Vorrichtungen verstanden, welche eine oder mehrere Schichten enthaltend organische Verbindungen aufweisen und unter Anlegen von elektrischer Spannung Licht emittieren. Der Aufbau und das allgemeine Funktionsprinzip von OLEDs sind dem Fachmann bekannt.

Bei elektronischen Vorrichtungen, insbesondere OLEDs, besteht großes Interesse an der Verbesserung der Leistungsdaten, insbesondere Lebensdauer, Effizienz und Betriebsspannung. In diesen Punkten konnte noch keine vollständig zufriedenstellende Lösung gefunden werden.

Daher werden weiterhin neue Materialien, insbesondere Polymere, zur Verwendung in OLEDs gesucht.

Bei OLEDs sind zwei wichtige Verfahren zur Aufbringung der Materialien in Schichtform bekannt: die Aufbringung aus der Gasphase, durch Sublimation, sowie die Aufbringung aus Lösung. Für letzteres Verfahren sind als Materialien unter anderem Polymere geeignet.

In diesem speziellen Fall der Aufbringung des Materials aus Lösung sind eine Vielzahl von Eigenschaften von Bedeutung, darunter insbesondere Löslichkeit des Materials in den verwendeten Lösungsmitteln und Filmbildungseigenschaften.

Von besonderer Bedeutung ist bei der Verwendung von Polymeren in einer lochtransportierenden Schicht der OLED, dass diese eine hohe Lebensdauer und Effizienz der Vorrichtung bewirken. Dies gilt insbesondere bei der Verwendung von Polymeren in der lochtransportierenden Schicht, in Kombination mit einer folgenden blau emittierenden Schicht, die ebenfalls aus Lösung aufgetragen wird. Hierfür werden insbesondere Polymere mit einem großen band gap, d.h. einem großen Abstand zwischen HOMO und LUMO, benötigt.

In der US 2012/056170 A1 werden Zusammensetzungen offenbart, die eine Emitterverbindung und mindestens ein Polymer mit konjugationsunterbrechenden Einheiten aufweisen. Diese Zusammensetzungen finden insbesondere Verwendung in der Emitterschicht von organischen Elektrolumineszenzvorrichtungen.

In der WO 2013/156130 A1 werden Polymere mit Triarylamin-Einheiten offenbart, die in ortho-Position substituiert sind. Diese Polymere finden insbesondere Verwendung in der Lochtransportschicht von organischen Elektrolum ineszenzvorrichtungen.

In der WO 2006/063852 A1 werden Polymere mit Binaphthyl-Einheiten offenbart. Diese Polymere finden insbesondere Verwendung in der Emitterschicht von organischen Elektrolumineszenzvorrichtungen.

In der WO 2015/144298 A1 werden Licht-emittierende Vorrichtungen offenbart, mit mehreren Licht-emittierenden Elementen, die eine gemeinsame Lochtransportschicht aufweisen, in der insbesondere Polymere mit Triarylamin-Einheiten Verwendung finden.

Es wurde nun gefunden, dass wenigstens eine, bevorzugt mehrere der oben genannten technischen Aufgaben durch die Bereitstellung eines neuen Polymers enthaltend bestimmte Struktureinheiten gelöst werden kann.

Gegenstand der vorliegenden Anmeldung ist damit ein Polymer, enthaltend mindestens eine Struktureinheit der Formel (I) 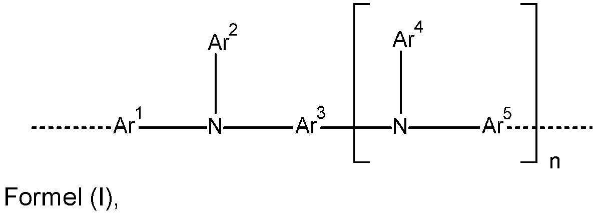 wobei für die auftretenden Variablen gilt:
Ar¹, Ar², Ar³, Ar⁴ und Ar⁵ sind gleich oder verschieden gewählt aus heteroaromatischen Ringsystemen mit 5 bis 40 aromatischen Ringatomen, die mit einem oder mehreren Resten R¹ substituiert sein können, und aus aromatischen Ringsystemen mit 6 bis 40 aromatischen Ringatomen, die mit einem oder mehreren Resten R¹ substituiert sein können; mit der Maßgabe, dass mindestens eine der beiden Gruppen Ar² und Ar⁴ jeweils in mindestens einer ortho-Position zur Bindung an N mit einer Gruppe R⁴ substituiert ist, wobei die Gruppe R⁴ mit der entsprechenden Gruppe Ar² bzw. Ar⁴, an die sie gebunden ist, einen Ring bilden kann, und wobei R⁴ direkt oder über eine Linkergruppe X an die Gruppe gewählt aus Gruppen Ar² und Ar⁴ gebunden ist;
R¹ ist bei jedem Auftreten gleich oder verschieden gewählt aus H, D, F, C(=O)R², CN, Si(R²)₃, N(R²)₂, P(=O)(R²)₂, OR², S(=O)R², S(=O)₂R², geradkettigen Alkyl- oder Alkoxygruppen mit 1 bis 20 C-Atomen, verzweigten oder cyclischen Alkyl- oder Alkoxygruppen mit 3 bis 20 C-Atomen, Alkenyl- oder Alkinylgruppen mit 2 bis 20 C-Atomen, aromatischen Ringsystemen mit 6 bis 40 aromatischen Ringatomen, und heteroaromatischen Ringsystemen mit 5 bis 40 aromatischen Ringatomen; wobei zwei oder mehr Reste R¹ miteinander verknüpft sein können und einen Ring bilden können; wobei die genannten Alkyl-, Alkoxy-, Alkenyl- und Alkinylgruppen und die genannten aromatischen Ringsysteme und heteroaromatischen Ringsysteme jeweils mit einem oder mehreren Resten R² substituiert sein können; und wobei eine oder mehrere CH₂-Gruppen in den genannten Alkyl-, Alkoxy-, Alkenyl- und Alkinylgruppen durch -R²C=CR²-, -C=C-, Si(R²)₂, C=O, C=NR², -C(=O)O-, -C(=O)NR²-, NR², P(=O)(R²), -O-, -S-, SO oder SO₂ ersetzt sein können;
R² ist bei jedem Auftreten gleich oder verschieden gewählt aus H, D, F, C(=O)R³, CN, Si(R³)₃, N(R³)₂, P(=O)(R³)₂, OR³, S(=O)R³, S(=O)₂R³, geradkettigen Alkyl- oder Alkoxygruppen mit 1 bis 20 C-Atomen, verzweigten oder cyclischen Alkyl- oder Alkoxygruppen mit 3 bis 20 C-Atomen, Alkenyl- oder Alkinylgruppen mit 2 bis 20 C-Atomen, aromatischen Ringsystemen mit 6 bis 40 aromatischen Ringatomen, und heteroaromatischen Ringsystemen mit 5 bis 40 aromatischen Ringatomen; wobei zwei oder mehr Reste R¹ bzw. R² miteinander verknüpft sein können und einen Ring bilden können; wobei die genannten Alkyl-, Alkoxy-, Alkenyl- und Alkinylgruppen und die genannten aromatischen Ringsysteme und heteroaromatischen Ringsysteme jeweils mit einem oder mehreren Resten R³ substituiert sein können; und wobei eine oder mehrere CH₂-Gruppen in den genannten Alkyl-, Alkoxy-, Alkenyl- und Alkinylgruppen durch -R³C=CR³-, -C=C-, Si(R³)₂, C=O, C=NR³, -C(=O)O-, -C(=O)NR³-, NR³, P(=O)(R³), -O-, -S-, SO oder SO₂ ersetzt sein können;
R³ ist bei jedem Auftreten gleich oder verschieden gewählt aus H, D, F, CN, Alkyl- oder Alkoxygruppen mit 1 bis 20 C-Atomen, Alkenyl- oder Alkinylgruppen mit 2 bis 20 C-Atomen, aromatischen Ringsystemen mit 6 bis 40 aromatischen Ringatomen und heteroaromatischen Ringsystemen mit 5 bis 40 aromatischen Ringatomen; wobei zwei oder mehr Reste R³ miteinander verknüpft sein können und einen Ring bilden können; und wobei die genannten Alkyl-, Alkoxy-, Alkenyl- und Alkinylgruppen, aromatischen Ringsysteme und heteroaromatischen Ringsysteme mit F oder CN substituiert sein können;
R⁴ ist bei jedem Auftreten gleich oder verschieden gewählt aus heteroaromatischen Ringsystemen mit 5 bis 40 aromatischen Ringatomen, die mit einem oder mehreren Resten R² substituiert sein können, und aus aromatischen Ringsystemen mit 6 bis 40 aromatischen Ringatomen, die mit einem oder mehreren Resten R² substituiert sein können;
X ist bei jedem Auftreten gleich oder verschieden gewählt aus C(R²)₂, Si(R²)₂, NR², O, S, und C=O;
n ist gleich 0 oder 1;
und mindestens eine Struktureinheit gewählt aus
- Struktureinheiten A der Formel (II-A) 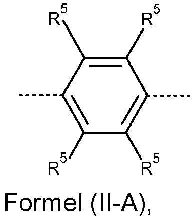
wobei in Formel (II-A) mindestens eine Gruppe R⁵ vorhanden ist, die gewählt ist aus geradkettigen Alkyl- oder Alkoxygruppen mit 1 bis 20 C-Atomen, verzweigten oder cyclischen Alkyl- oder Alkoxygruppen mit 3 bis 20 C-Atomen, Alkenyl- oder Alkinylgruppen mit 2 bis 20 C-Atomen, aromatischen Ringsystemen mit 6 bis 40 aromatischen Ringatomen, und heteroaromatischen Ringsystemen mit 5 bis 40 aromatischen Ringatomen, wobei die genannten Alkyl-, Alkoxy-, Alkenyl- und Alkinylgruppen und die genannten aromatischen Ringsysteme und heteroaromatischen Ringsysteme jeweils mit einem oder mehreren Resten R² substituiert sein können;
- Struktureinheiten B der Formel (II-B) 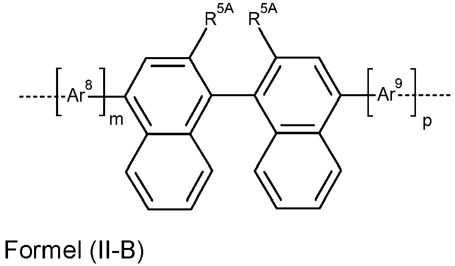 wobei
R^{5A} bei jedem Auftreten gleich oder verschieden gewählt ist aus H, D, F, C(=O)R², CN, Si(R²)₃, N(R²)₂, P(=O)(R²)₂, OR², S(=O)R², S(=O)₂R², geradkettigen Alkyl- oder Alkoxygruppen mit 1 bis 20 C-Atomen, verzweigten oder cyclischen Alkyl- oder Alkoxygruppen mit 3 bis 20 C-Atomen, Alkenyl- oder Alkinylgruppen mit 2 bis 20 C-Atomen, aromatischen Ringsystemen mit 6 bis 40 aromatischen Ringatomen, und heteroaromatischen Ringsystemen mit 5 bis 40 aromatischen Ringatomen; wobei die genannten Alkyl-, Alkoxy-, Alkenyl- und Alkinylgruppen und die genannten aromatischen Ringsysteme und heteroaromatischen Ringsysteme jeweils mit einem oder mehreren Resten R² substituiert sein können; und wobei eine oder mehrere CH₂-Gruppen in den genannten Alkyl-, Alkoxy-, Alkenyl- und Alkinylgruppen durch -R²C=CR²-, -C=C-, Si(R²)₂, C=O, C=NR², -C(=O)O-, -C(=O)NR²-, NR², P(=O)(R²), -O-, -S-, SO oder SO₂ ersetzt sein können;
Ar⁸ und Ar⁹ bei jedem Auftreten gleich oder verschieden gewählt sind aus aromatischen Ringsystemen mit 6 bis 40 aromatischen Ringatomen, die mit einem oder mehreren Resten R⁵ substituiert sein können, und heteroaromatischen Ringsystemen mit 5 bis 40 aromatischen Ringatomen, die mit einem oder mehreren Resten R⁵ substituiert sein können;
m und p bei jedem Auftreten gleich oder verschieden gewählt sind aus 0 und 1;
und die Naphthylgruppen an den unsubstituiert dargestellten Positionen jeweils mit einem Rest R⁵ substituiert sein können; und
- Struktureinheiten C, die der Formel (II-C) entsprechen 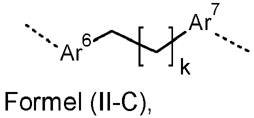 wobei
Ar⁶ und Ar⁷ bei jedem Auftreten gleich oder verschieden gewählt sind aus aromatischen Ringsystemen mit 6 bis 40 aromatischen Ringatomen, die mit einem oder mehreren Resten R⁵ substituiert sein können, und heteroaromatischen Ringsystemen mit 5 bis 40 aromatischen Ringatomen, die mit einem oder mehreren Resten R⁵ substituiert sein können;
R⁵ bei jedem Auftreten gleich oder verschieden gewählt ist aus H, D, F, C(=O)R², CN, Si(R²)₃, N(R²)₂, P(=O)(R²)₂, OR², S(=O)R², S(=O)₂R², geradkettigen Alkyl- oder Alkoxygruppen mit 1 bis 20 C-Atomen, verzweigten oder cyclischen Alkyl- oder Alkoxygruppen mit 3 bis 20 C-Atomen, Alkenyl- oder Alkinylgruppen mit 2 bis 20 C-Atomen, aromatischen Ringsystemen mit 6 bis 40 aromatischen Ringatomen, und heteroaromatischen Ringsystemen mit 5 bis 40 aromatischen Ringatomen; wobei die genannten Alkyl-, Alkoxy-, Alkenyl- und Alkinylgruppen und die genannten aromatischen Ringsysteme und heteroaromatischen Ringsysteme jeweils mit einem oder mehreren Resten R² substituiert sein können; und wobei eine oder mehrere CH₂-Gruppen in den genannten Alkyl-, Alkoxy-, Alkenyl- und Alkinylgruppen durch -R²C=CR²-, -C=C-, Si(R²)₂, C=O, C=NR², -C(=O)O-, -C(=O)NR²-, NR², P(=O)(R²), -O-, -S-, SO oder SO₂ ersetzt sein können;
k einen Wert von 0 bis 9 hat, und
wobei eine oder mehrere Einheiten CH₂ in der Alkylenkette von Formel (II-C) durch eine divalente Einheit gewählt aus C=O,
C=NR⁵, -C(=O)O-, -C(=O)NR⁵-, Si(R⁵)₂, NR⁵, P(=O)(R⁵), O, S, SO und SO₂ ersetzt sein können; und
wobei ein oder mehrere H-Atome in der Alkylenkette von Formel (II-C) jeweils durch einen Rest R⁵ ersetzt sein können;
wobei die Summe der Anteile derjenigen Struktureinheiten, die einer Struktureinheit der Formel (I) entsprechen, im Polymer zwischen 20 und 50 Mol-%, bezogen auf 100 Mol-% aller copolymerisierten Monomere, die im Polymer als Struktureinheiten enthalten sind, beträgt; und
wobei die Summe der Anteile derjenigen Struktureinheiten, die einer Struktureinheit A, B oder C entsprechen, im Polymer zwischen 20 und 75 Mol-%, bezogen auf 100 Mol-% aller copolymerisierten Monomere, die im Polymer als Struktureinheiten enthalten sind, beträgt.

In den Formeln für Struktureinheiten kennzeichnen die gestrichelten Linien die Bindungen zu benachbarten Struktureinheiten des Polymers.

Unter dem Begriff Struktureinheit wird in der vorliegenden Anmeldung eine Einheit verstanden, die im Polymer mehrfach mit der angegebenen Struktur auftritt. Sie kann dabei repetitiv, d.h. mehrfach hintereinander, und/oder vereinzelt im Polymer auftreten. Bevorzugt treten eine Vielzahl Struktureinheiten mit der angegebenen Struktur im Polymer auf, besonders bevorzugt 10 bis 1000, ganz besonders bevorzugt 50 bis 500. Wird eine Einheit als eine Struktureinheit des Polymers angegeben, liegt ihr Anteil im Polymer bevorzugt im Bereich von 0,01 bis 50 mol%, besonders bevorzugt im Bereich von 0,1 bis 30 mol%, und ganz besonders bevorzugt im Bereich von 0,5 bis 20 mol%, bezogen auf 100 mol% aller polymerisierten Monomere, die im Polymer als Struktureinheiten enthalten sind.

Weiterhin bevorzugt ist eine Struktureinheit im Sinne der vorliegenden Anmeldung von einem in der Polymerisation eingesetzten Monomer dadurch abgeleitet, dass die reaktiven Gruppen des Monomers entsprechend ihrer chemischen Reaktivität und Bestimmung reagiert haben. Beispielsweise ist bei einem Monomer enthaltend zwei Bromatome als reaktive Gruppen in einer Suzuki-Polymerisationsreaktion die entstehende Struktureinheit im Polymer dadurch gekennzeichnet, dass sie der Monomerstruktur entspricht, mit dem Unterschied, dass die Bromatome fehlen und die Bindungen zu den Bromatomen nun Bindungen zu den benachbarten Struktureinheiten sind. Im Fall von Monomeren enthaltend Vernetzergruppen oder Vorläufergruppen für Vernetzergruppen können dabei eine oder mehrere weitere Reaktionen der Vernetzergruppe bzw. der entsprechenden Vorläufergruppen der Vernetzergruppe erfolgen, bis die entsprechende endgültige Struktureinheit des Polymers erhalten wird.

Unter der Formulierung, dass die Gruppe R⁴ mit der entsprechenden Gruppe Ar² bzw. Ar⁴, an die sie gebunden ist, einen Ring bilden kann, wird verstanden, dass die entsprechende Gruppe R⁴ zusätzlich zur Bindung an die Gruppe Ar² bzw. Ar⁴ auch durch eine Brücke, bevorzugt gewählt aus Einfachbindung, C(R²)₂, Si(R²)₂, NR², O, S, und C=O, besonders bevorzugt gewählt aus Einfachbindung und C(R²)₂, an die Gruppe Ar² bzw. Ar⁴ gebunden ist. Dies wird durch das folgende Schema verdeutlicht, in dem die Gruppe Ar² eine Phenylgruppe ist, in dem die Gruppe R⁴ eine Phenylgruppe ist, und in dem die Brücke gleich C(R²)₂ ist:

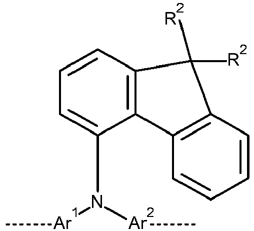

Unter dem Begriff Konjugationsebene von Aryl- bzw. Heteroarylgruppen wird in der vorliegenden Anmeldung die Ebene verstanden, in der die entsprechenden planaren Ringe der Aryl- bzw. Heteroarylgruppen liegen. Unter Verdrehung der Konjugationsebene einer Gruppe gegen die Konjugationsebene der anderen Gruppe, mit der die erste Gruppe direkt verbunden ist, wird dabei verstanden, dass die entsprechenden planaren Ringe gegeneinander verdreht sind, um die Achse der Bindung zwischen den beiden Gruppen. Die Verdrehung kann dabei einen beliebigen Wert in Grad annehmen, der nicht vernachlässigbar klein ist und der definitionsgemäß bis zu 90° betragen kann. Bevorzugt sind Werte zwischen 35° und 90°.

Eine Arylgruppe im Sinne dieser Erfindung enthält 6 bis 40 aromatische Ringatome, von denen keines ein Heteroatom darstellt. Unter einer Arylgruppe im Sinne dieser Erfindung wird entweder ein einfacher aromatischer Cyclus, also Benzol, oder ein kondensierter aromatischer Polycyclus, beispielsweise Naphthalin, Phenanthren oder Anthracen, verstanden. Ein kondensierter aromatischer Polycyclus besteht im Sinne der vorliegenden Anmeldung aus zwei oder mehr miteinander kondensierten einfachen aromatischen Cyclen. Unter Kondensation zwischen Cyclen ist dabei zu verstehen, dass die Cyclen mindestens eine Kante miteinander teilen.

Eine Heteroarylgruppe im Sinne dieser Erfindung enthält 5 bis 40 aromatische Ringatome, von denen mindestens eines ein Heteroatom darstellt. Die Heteroatome der Heteroarylgruppe sind bevorzugt ausgewählt aus N, O und S. Unter einer Heteroarylgruppe im Sinne dieser Erfindung wird entweder ein einfacher heteroaromatischer Cyclus, beispielsweise Pyridin, Pyrimidin oder Thiophen, oder ein kondensierter heteroaromatischer Polycyclus, beispielsweise Chinolin oder Carbazol, verstanden. Ein kondensierter heteroaromatischer Polycyclus besteht im Sinne der vorliegenden Anmeldung aus zwei oder mehr miteinander kondensierten einfachen heteroaromatischen Cyclen. Unter Kondensation zwischen Cyclen ist dabei zu verstehen, dass die Cyclen mindestens eine Kante miteinander teilen.

Unter einer Aryl- oder Heteroarylgruppe, die jeweils mit den oben genannten Resten substituiert sein kann und die über beliebige Positionen am Aromaten bzw. Heteroaromaten verknüpft sein kann, werden insbesondere Gruppen verstanden, welche abgeleitet sind von Benzol, Naphthalin, Anthracen, Phenanthren, Pyren, Dihydropyren, Chrysen, Perylen, Triphenylen, Fluoranthen, Benzanthracen, Benzphenanthren, Tetracen, Pentacen, Benzpyren, Furan, Benzofuran, Isobenzofuran, Dibenzofuran, Thiophen, Benzothiophen, Isobenzothiophen, Dibenzothiophen, Pyrrol, Indol, Isoindol, Carbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, Pyrazin, Phenazin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol.

Ein aromatisches Ringsystem im Sinne dieser Erfindung enthält 6 bis 40 C-Atome im Ringsystem und umfasst keine Heteroatome als aromatische Ringatome. Ein aromatisches Ringsystem im Sinne dieser Erfindung enthält daher keine Heteroarylgruppen. Unter einem aromatischen Ringsystem im Sinne dieser Erfindung soll ein System verstanden werden, das nicht notwendigerweise nur Arylgruppen enthält, sondern in dem auch mehrere Arylgruppen durch eine Einfachbindung oder durch eine nicht-aromatische Einheit, wie beispielsweise ein oder mehrere wahlweise substituierte C-, Si-, N-, O- oder S-Atome, verbunden sein können. Dabei umfasst die nicht-aromatische Einheit bevorzugt weniger als 10 % der von H verschiedenen Atome, bezogen auf die Gesamtzahl der von H verschiedenen Atome des Systems. So sollen beispielsweise auch Systeme wie 9,9'-Spirobifluoren, 9,9'-Diarylfluoren, Triarylamin, Diarylether und Stilben als aromatische Ringsysteme im Sinne dieser Erfindung verstanden werden, und ebenso Systeme, in denen zwei oder mehr Arylgruppen beispielsweise durch eine lineare oder cyclische Alkyl-, Alkenyl- oder Alkinylgruppe oder durch eine Silylgruppe verbunden sind. Weiterhin werden auch Systeme, in denen zwei oder mehr Arylgruppen über Einfachbindungen miteinander verknüpft sind, als aromatische Ringsysteme im Sinne dieser Erfindung verstanden, wie beispielsweise Systeme wie Biphenyl und Terphenyl.

Ein heteroaromatisches Ringsystem im Sinne dieser Erfindung enthält 5 bis 40 aromatische Ringatome, von denen mindestens eines ein Heteroatom darstellt. Die Heteroatome des heteroaromatischen Ringsystems sind bevorzugt ausgewählt aus N, O und/oder S. Ein heteroaromatisches Ringsystem entspricht der oben genannten Definition eines aromatischen Ringsystems, weist jedoch mindestens ein Heteroatom als eines der aromatischen Ringatome auf. Es unterscheidet sich dadurch von einem aromatischen Ringsystem im Sinne der Definition der vorliegenden Anmeldung, welches gemäß dieser Definition kein Heteroatom als aromatisches Ringatom enthalten kann.

Unter einem aromatischen Ringsystem mit 6 bis 40 aromatischen Ringatomen oder einem heteroaromatischen Ringsystem mit 5 bis 40 aromatischen Ringatomen, werden insbesondere Gruppen verstanden, die abgeleitet sind von den oben unter Arylgruppen und Heteroarylgruppen genannten Gruppen sowie von Biphenyl, Terphenyl, Quaterphenyl, Fluoren, Spirobifluoren, Dihydrophenanthren, Dihydropyren, Tetrahydropyren, Indenofluoren, Truxen, Isotruxen, Spirotruxen, Spiroisotruxen, Indenocarbazol, oder von Kombinationen dieser Gruppen.

Im Rahmen der vorliegenden Erfindung werden unter einer geradkettigen Alkylgruppe mit 1 bis 20 C-Atomen bzw. einer verzweigten oder cyclischen Alkylgruppe mit 3 bis 20 C-Atomen bzw. einer Alkenyl- oder Alkinylgruppe mit 2 bis 40 C-Atomen, in der auch einzelne H-Atome oder CH₂-Gruppen durch die oben bei der Definition der Reste genannten Gruppen substituiert sein können, bevorzugt die Reste Methyl, Ethyl, n-Propyl, i-Propyl, n-Butyl, i-Butyl, s-Butyl, t-Butyl, 2-Methylbutyl, n-Pentyl, s-Pentyl, Cyclopentyl, neoPentyl, n-Hexyl, Cyclohexyl, neo-Hexyl, n-Heptyl, Cycloheptyl, n-Octyl, Cyclooctyl, 2-Ethylhexyl, Trifluormethyl, Pentafluorethyl, 2,2,2-Trifluorethyl, Ethenyl, Propenyl, Butenyl, Pentenyl, Cyclopentenyl, Hexenyl, Cyclohexenyl, Heptenyl, Cycloheptenyl, Octenyl, Cyclooctenyl, Ethinyl, Propinyl, Butinyl, Pentinyl, Hexinyl oder Octinyl verstanden.

Unter einer Alkoxy- oder Thioalkylgruppe mit 1 bis 20 C-Atomen, in der auch einzelne H-Atome oder CH₂-Gruppen durch die oben bei der Definition der Reste genannten Gruppen substituiert sein können, werden bevorzugt Methoxy, Trifluormethoxy, Ethoxy, n-Propoxy, i-Propoxy, n-Butoxy, i-Butoxy, s-Butoxy, t-Butoxy, n-Pentoxy, s-Pentoxy, 2-Methylbutoxy, n-Hexoxy, Cyclohexyloxy, n-Heptoxy, Cycloheptyloxy, n-Octyloxy, Cyclooctyloxy, 2-Ethylhexyloxy, Pentafluorethoxy, 2,2,2-Trifluorethoxy, Methylthio, Ethylthio, n-Propylthio, i-Propylthio, n-Butylthio, i-Butylthio, s-Butylthio, t-Butylthio, n-Pentylthio, s-Pentylthio, n-Hexylthio, Cyclohexylthio, n-Heptylthio, Cycloheptylthio, n-Octylthio, Cyclooctylthio, 2-Ethylhexylthio, Trifluormethylthio, Pentafluorethylthio, 2,2,2-Trifluorethylthio, Ethenylthio, Propenylthio, Butenylthio, Pentenylthio, Cyclopentenylthio, Hexenylthio, Cyclohexenylthio, Heptenylthio, Cycloheptenylthio, Octenylthio, Cyclooctenylthio, Ethinylthio, Propinylthio, Butinylthio, Pentinylthio, Hexinylthio, Heptinylthio oder Octinylthio verstanden.

Unter der Formulierung, dass zwei oder mehr Reste miteinander einen Ring bilden können, soll im Rahmen der vorliegenden Anmeldung unter anderem verstanden werden, dass die beiden Reste miteinander durch eine chemische Bindung verknüpft sind. Weiterhin soll unter der oben genannten Formulierung aber auch verstanden werden, dass für den Fall, dass einer der beiden Reste Wasserstoff darstellt, der zweite Rest unter Bildung eines Rings an die Position, an die das Wasserstoffatom gebunden war, bindet.

Bevorzugt sind Ar¹, Ar², Ar³, Ar⁴ und Ar⁵ bei jedem Auftreten gleich oder verschieden gewählt aus aromatischen Ringsystemen mit 6 bis 25 aromatischen Ringatomen, die mit einem oder mehreren Resten R¹ substituiert sein können. Besonders bevorzugt sind Ar¹, Ar², Ar³, Ar⁴ und Ar⁵ bei jedem Auftreten gleich oder verschieden gewählt aus Benzol, Biphenyl, Terphenyl, Fluoren, Naphthalin, Phenanthren, Indenofluoren und Spirobifluoren, die mit einem oder mehreren Resten R¹ substituiert sein können. Ganz besonders bevorzugt sind Ar¹, Ar², Ar³, Ar⁴ und Ar⁵ gleich Benzol, das mit einem oder mehreren Resten R¹ substituiert sein kann.

Bevorzugt ist R¹ bei jedem Auftreten gleich oder verschieden gewählt aus H, D, F, CN, Si(R²)₃, N(R²)₂, geradkettigen Alkyl- oder Alkoxygruppen mit 1 bis 20 C-Atomen, verzweigten oder cyclischen Alkyl- oder Alkoxygruppen mit 3 bis 20 C-Atomen, aromatischen Ringsystemen mit 6 bis 40 aromatischen Ringatomen, und heteroaromatischen Ringsystemen mit 5 bis 40 aromatischen Ringatomen; wobei die genannten Alkyl- und Alkoxygruppen, die genannten aromatischen Ringsysteme und die genannten heteroaromatischen Ringsysteme jeweils mit einem oder mehreren Resten R² substituiert sein können; und wobei in den genannten Alkyl- oder Alkoxygruppen eine oder mehrere CH₂-Gruppen durch -C=C-, - R²C=CR²-, Si(R²)₂, C=O, C=NR², -NR²-, -O-, -S-, -C(=O)O- oder - C(=O)NR²- ersetzt sein können.

Bevorzugt ist R² bei jedem Auftreten gleich oder verschieden gewählt aus H, D, F, CN, Si(R³)₃, N(R³)₂, geradkettigen Alkyl- oder Alkoxygruppen mit 1 bis 20 C-Atomen, verzweigten oder cyclischen Alkyl- oder Alkoxygruppen mit 3 bis 20 C-Atomen, aromatischen Ringsystemen mit 6 bis 40 aromatischen Ringatomen, und heteroaromatischen Ringsystemen mit 5 bis 40 aromatischen Ringatomen; wobei die genannten Alkyl- und Alkoxygruppen, die genannten aromatischen Ringsysteme und die genannten heteroaromatischen Ringsysteme jeweils mit einem oder mehreren Resten R³ substituiert sein können; und wobei in den genannten Alkyl- oder Alkoxygruppen eine oder mehrere CH₂-Gruppen durch -C=C-, - R³C=CR³-, Si(R³)₂, C=O, C=NR³, -NR³-, -O-, -S-, -C(=O)O- oder - C(=O)NR³- ersetzt sein können.

Bevorzugt ist R⁴ bei jedem Auftreten gleich oder verschieden gewählt aus aromatischen Ringsystemen mit 6 bis 20 aromatischen Ringatomen, die mit einem oder mehreren Resten R² substituiert sein können.

Bevorzugt ist X gleich C(R²)₂.

Bevorzugt ist n gleich 0. Eine bevorzugte Struktureinheit der Formel (I) entspricht damit der Formel (I-1) 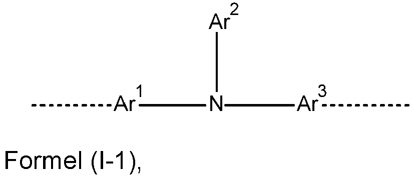 wobei die auftretenden Variablen wie oben für Formel (I) definiert sind.

Falls n = 1 ist, was ebenfalls bevorzugt sein kann, entspricht die Struktureinheit der Formel (I) der Formel (I-2) 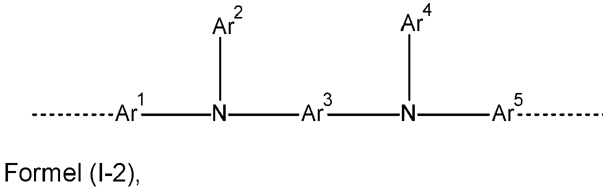 wobei die auftretenden Variablen wie oben für Formel (I) definiert sind.

Bevorzugt enthält mindestens eine Gruppe gewählt aus Gruppen Ar² und Ar⁴ genau eine oder genau zwei Gruppen R⁴ in ortho-Position zum Stickstoffatom, besonders bevorzugt genau eine Gruppe R⁴ in ortho-Position zum Stickstoffatom, wobei R⁴ direkt oder über eine Linkergruppe X an die Gruppe gewählt aus Gruppen Ar² und Ar⁴ gebunden ist.

Gemäß einer bevorzugten Ausführungsform der Erfindung bildet die Gruppe R⁴ mit der Gruppe Ar² bzw. Ar⁴, an die sie gebunden ist, keinen Ring.

Gemäß dieser Ausführungsform entsprechen bevorzugte Struktureinheiten der Formel (I) einer der Formeln (1-1-A), (I-2-A-1), (I-2-A-2) und (I-2-A-3) 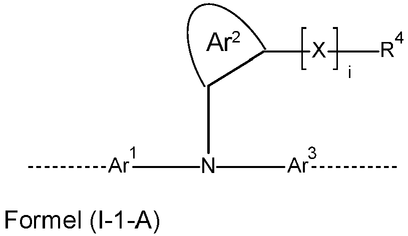 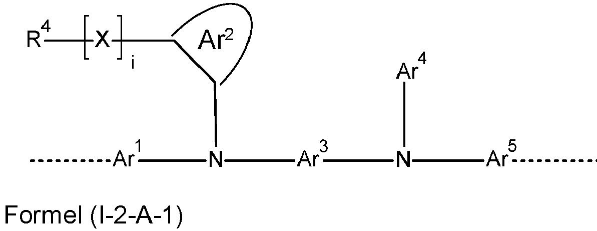 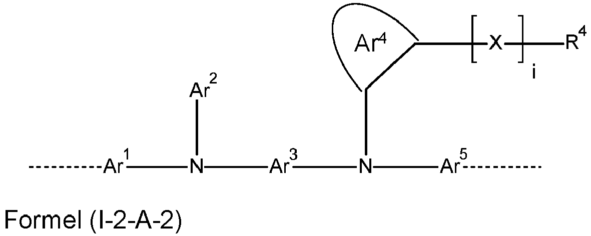 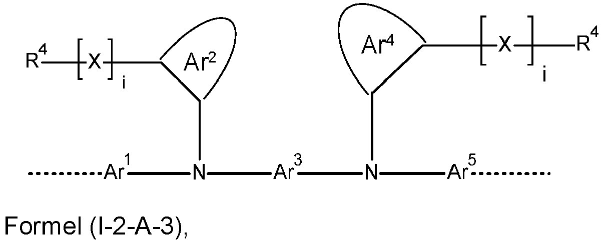 wobei i gleich 0 oder 1 ist, und bevorzugt gleich 0 ist, und die sonstigen Variablen definiert sind wie oben. Bevorzugt sind in den obenstehenden Formeln Ar² und Ar⁴ gleich Phenyl, das jeweils mit einem oder mehreren Resten R¹ substituiert sein kann. Die Gruppen Ar² bzw. Ar⁴ können dabei auch zusätzlich zur eingezeichneten ersten Gruppe [X]ᵢ-R⁴ mit einer weiteren ortho-ständigen Gruppe [X]ᵢ-R⁴ substituiert sein.

Wenn i gleich 0 ist, sind die betreffenden Einheiten R⁴ und Ar² bzw. Ar⁴ direkt miteinander verbunden.

Besonders bevorzugt unter den oben genannten Formeln ist die Formel (I-1-A).

Die Bindungsposition von [X]ᵢ - R⁴ und N am zeichnerisch angedeuteten Ring Ar² bzw. Ar⁴ in den obenstehenden Formeln kennzeichnet dabei, dass diese beiden Gruppen jeweils in ortho-Position zueinander stehen.

Gemäß einer alternativen, ebenfalls bevorzugten Ausführungsform der Erfindung bildet die Gruppe R⁴ mit der Gruppe Ar² bzw. Ar⁴, an die sie gebunden ist, einen Ring.

Entsprechende bevorzugte Ausführungsformen der Formel (I) in diesem Fall entsprechen den folgenden Formeln (1-1-B), (I-2-B-1), (I-2-B-2) und (I-2-B-3) 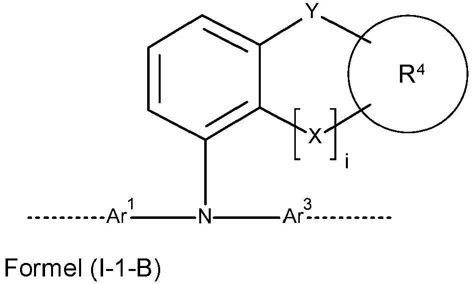 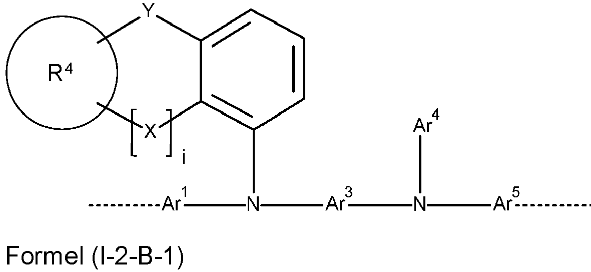 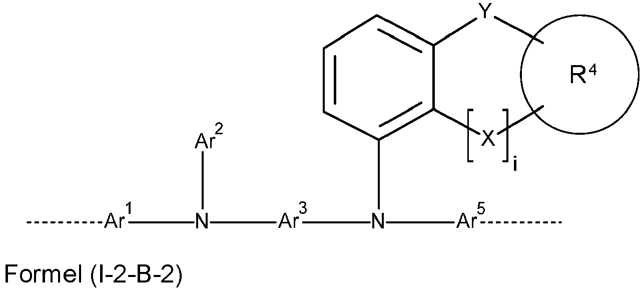 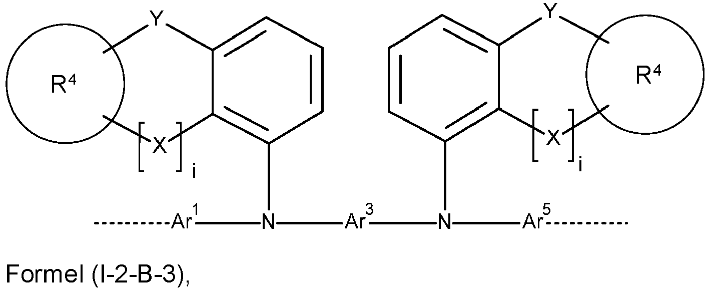
wobei i gleich 0 oder 1 ist, und bevorzugt gleich 0 ist,
wobei Y bei jedem Auftreten gleich oder verschieden gewählt ist aus Einfachbindung, C(R²)₂, Si(R²)₂, NR², O, S und C=O, und bevorzugt gewählt ist aus Einfachbindung und C(R²)₂,
und die sonstigen Variablen definiert sind wie oben.

Gemäß einer bevorzugten Ausführungsform bilden die beiden Reste R² an einer Gruppe Y gleich C(R²)₂ einen Ring, so dass eine Spiro-Einheit entsteht. Bevorzugt wird dabei ein Spirobifluoren gebildet, indem die Reste R² gleich Phenyl sind, die beiden Reste R² durch eine Einfachbindung miteinander verbunden sind, R⁴ gleich Phenyl ist, und der Index i gleich Null ist, so dass R⁴ direkt mit der betreffenden Gruppe, an die es bindet, verbunden ist.

Besonders bevorzugt unter den oben genannten Formeln ist die Formel (I-1-B).

Besonders bevorzugt entspricht die Struktureinheit der Formel (I) einer der Formeln (I-1-A-A), (I-1-A-B) und (I-1-B-A) 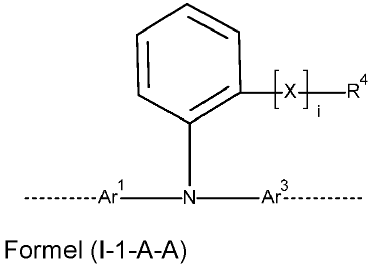 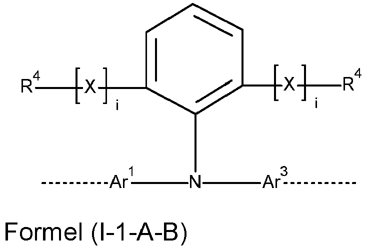 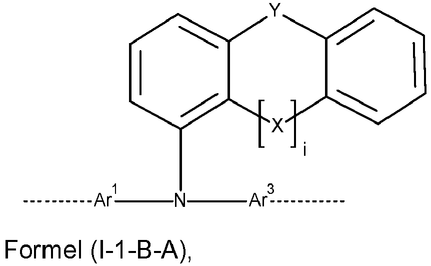
wobei i gleich 0 oder 1 ist, und bevorzugt gleich 0 ist,
wobei die aromatischen Sechsringe jeweils an den unsubstituiert gezeichneten Positionen mit einem Rest R¹ bzw. R² substituiert sein können, und wobei die auftretenden Variablen definiert sind wie oben. Die Formeln (I-1-A-A) und (I-1-B-A) sind unter den oben genannten Formeln besonders bevorzugt.

Bevorzugt ist in Formel (I-1-A-A) und (I-1-A-B) i gleich 0, so dass R⁴ und die Phenylgruppe direkt miteinander verbunden sind.

Bevorzugt ist in Formel (I-1-B-A) i gleich 0, so dass die beiden Phenylgruppen direkt miteinander verbunden sind, und Y ist gleich C(R²)₂. Dabei entspricht es einer bevorzugten Ausführungsform, dass R² in einer Gruppe Y, die C(R²)₂ entspricht, gleich Phenyl ist, und die beiden Gruppen R² miteinander über eine Einfachbindung verbunden sind, so dass eine Spirobifluoren-Einheit an das Stickstoffatom gebunden ist.

Bevorzugte Ausführungsformen der Formel (I) entsprechen den in WO 2013/156130 offenbarten Formeln (Vllla) bis (VIIIh), (IXa) bis (IXg), und (Xa) bis (Xc), wobei R durch R¹ bzw. R² zu ersetzen ist, k, m, n und p die jeweils mögliche Zahl an Substituenten am betreffenden Ring kennzeichnen und v gleich 1 bis 20 ist, vorzugsweise 1 bis 10. Weiterhin sind bevorzugte Ausführungsformen der Formel (I) die in WO 2013/156129 offenbarten Formeln in den Tabellen der S. 26 - 34, wobei R durch R¹ bzw. R² zu ersetzen ist, k, m, n und p die jeweils mögliche Zahl an Substituenten am betreffenden Ring kennzeichnen, s gleich 1 bis 20 ist, vorzugsweise 1 bis 10, und X gleich C(R⁵)₂ ist.

Besonders bevorzugte Struktureinheiten der Formel (I) sind in der folgenden Tabelle abgebildet:

| | | | |
|---|---|---|---|
| 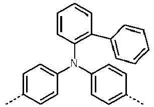 | 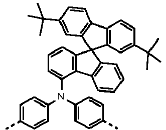 | 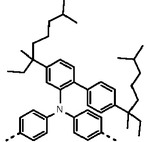 | 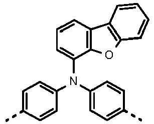 |
| (I-a) | (I-b) | (I-c) | (I-d) |
| 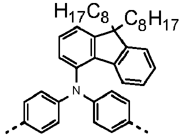 | 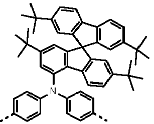 | 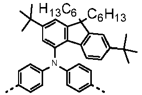 | 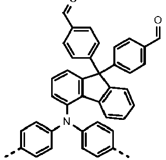 (*) |
| (I-e) | (I-f) | (I-g) | (I-h) |
| 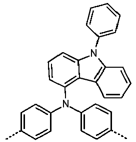 | 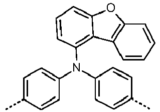 | 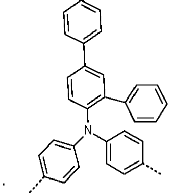 | 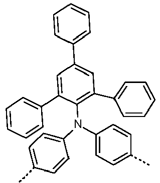 |
| (I-i) | (I-j) | (I-k) | (I-l) |
| 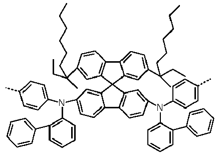 | 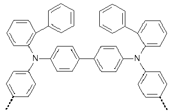 | 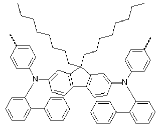 | 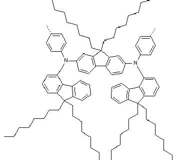 |
| (I-m) | (I-n) | (I-o) | (I-p) |
| 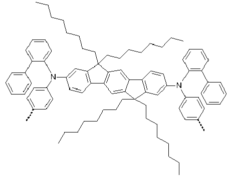 | | | |
| (I-q) | | | |

Erfindungsgemäß enthält das Polymer mindestens eine Struktureinheit gewählt aus Struktureinheiten A der Formel (II-A), Struktueinheiten B der Formel (II-B) und Struktureinheiten C der Formel (II-C).

Die Struktureinheiten A entsprechen der Formel (II-A) 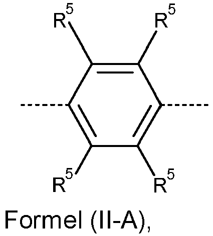 wobei R⁵ definiert ist wie oben und mindestens eine Gruppe R⁵ vorhanden ist. Bevorzugt sind in Formel (II-A) mindestens zwei Gruppen R⁵ vorhanden, die ungleich H oder D sind. Besonders bevorzugt sind in Formel (II-A) genau zwei Gruppen R⁵ vorhanden, die ungleich H oder D sind.

Erfindungsgemäß ist in Formel (II-A) mindestens eine Gruppe R⁵ vorhanden, die gewählt ist aus geradkettigen Alkyl- oder Alkoxygruppen mit 1 bis 20 C-Atomen, verzweigten oder cyclischen Alkyl- oder Alkoxygruppen mit 3 bis 20 C-Atomen, Alkenyl- oder Alkinylgruppen mit 2 bis 20 C-Atomen, aromatischen Ringsystemen mit 6 bis 40 aromatischen Ringatomen, und heteroaromatischen Ringsystemen mit 5 bis 40 aromatischen Ringatomen, wobei die genannten Alkyl-, Alkoxy-, Alkenyl- und Alkinylgruppen und die genannten aromatischen Ringsysteme und heteroaromatischen Ringsysteme jeweils mit einem oder mehreren Resten R² substituiert sein können. Bevorzugt sind genau zwei derartige Gruppen R⁵ vorhanden.

Eine bevorzugte Ausführungsform der Formel (II-A) entspricht der Formel (II-A-1) 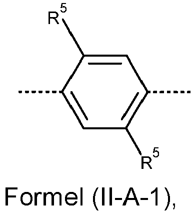 wobei R⁵ bei jedem Auftreten gleich oder verschieden gewählt ist aus geradkettigen Alkyl- oder Alkoxygruppen mit 1 bis 20 C-Atomen, verzweigten oder cyclischen Alkyl- oder Alkoxygruppen mit 3 bis 20 C-Atomen, Alkenyl- oder Alkinylgruppen mit 2 bis 20 C-Atomen, aromatischen Ringsystemen mit 6 bis 40 aromatischen Ringatomen, und heteroaromatischen Ringsystemen mit 5 bis 40 aromatischen Ringatomen, wobei die genannten Alkyl-, Alkoxy-, Alkenyl- und Alkinylgruppen und die genannten aromatischen Ringsysteme und heteroaromatischen Ringsysteme jeweils mit einem oder mehreren Resten R² substituiert sein können.

Besonders bevorzugte Struktureinheiten der Formel (II-A) sind im Folgenden gezeigt:

| | | | |
|---|---|---|---|
| 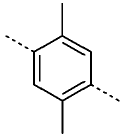 | 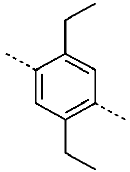 | 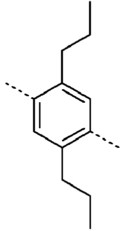 | 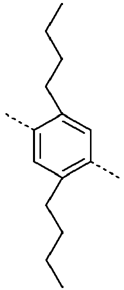 |
| (II-A-a) | (II-A-b) | (II-A-c) | (II-A-d) |

| | | | |
|---|---|---|---|
| 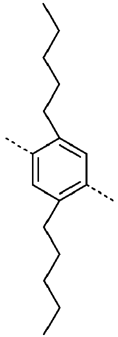 | 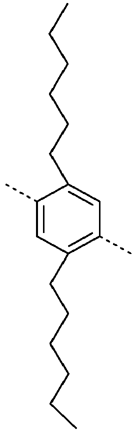 | 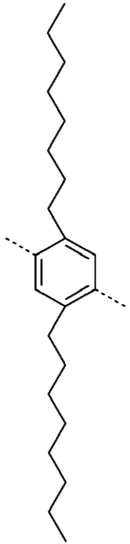 | 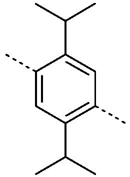 |
| (II-A-e) | (II-A-f) | (II-A-g) | (II-A-h) |
| 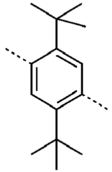 | 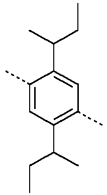 | 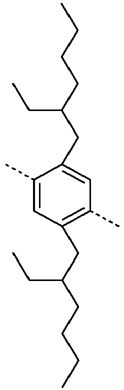 | 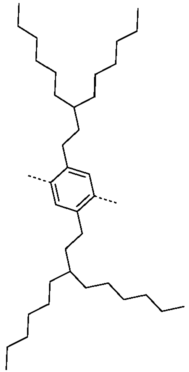 |
| (II-A-i) | (II-A-j) | (II-A-k) | (II-A-l) |

| | | | |
|---|---|---|---|
| 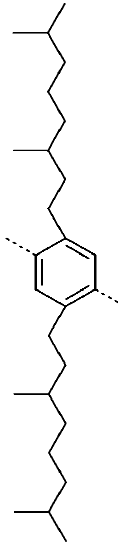 | 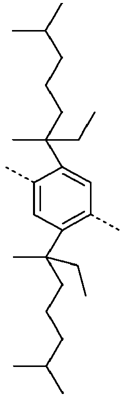 | 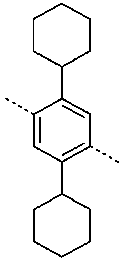 | 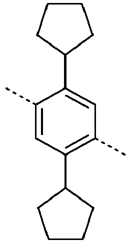 |
| (II-A-m) | (II-A-n) | (II-A-o) | (II-A-p) |
| 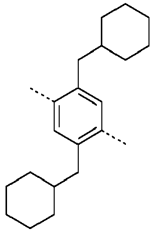 | 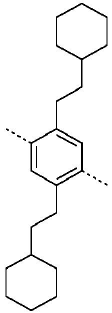 | 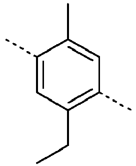 | 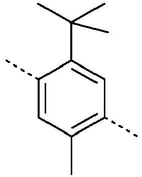 |
| (II-A-q) | (II-A-r) | (II-A-s) | (II-A-t) |

| | | | |
|---|---|---|---|
| 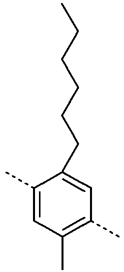 | 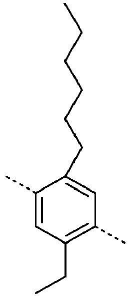 | 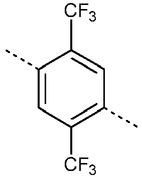 | 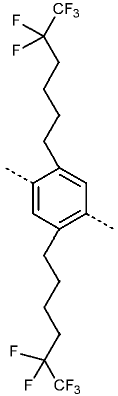 |
| (II-A-u) | (II-A-v) | (II-A-w) | (II-A-x) |
| 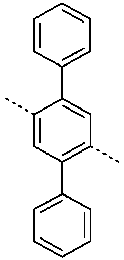 | 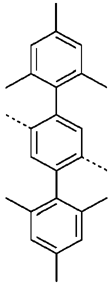 | 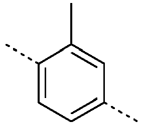 | 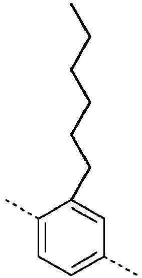 |
| (II-A-y) | (II-A-z) | (II-A-aa) | (II-A-ab) |
| 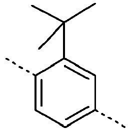 | 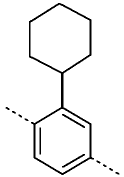 | 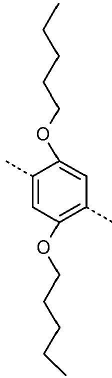 | 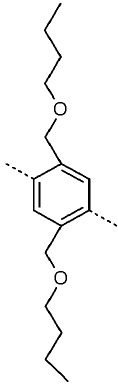 |
| (II-A-ac) | (II-A-ad) | (II-A-ae) | (II-A-af) |

Die Struktureinheiten B entsprechen der Formel (II-B) 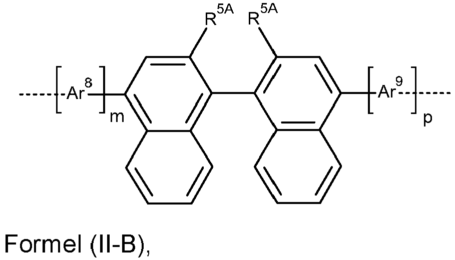 wobei
R^{5A} bei jedem Auftreten gleich oder verschieden gewählt ist aus H, D, F, C(=O)R², CN, Si(R²)₃, N(R²)₂, P(=O)(R²)₂, OR², S(=O)R², S(=O)₂R², geradkettigen Alkyl- oder Alkoxygruppen mit 1 bis 20 C-Atomen, verzweigten oder cyclischen Alkyl- oder Alkoxygruppen mit 3 bis 20 C-Atomen, Alkenyl- oder Alkinylgruppen mit 2 bis 20 C-Atomen, aromatischen Ringsystemen mit 6 bis 40 aromatischen Ringatomen, und heteroaromatischen Ringsystemen mit 5 bis 40 aromatischen Ringatomen; wobei die genannten Alkyl-, Alkoxy-, Alkenyl- und Alkinylgruppen und die genannten aromatischen Ringsysteme und heteroaromatischen Ringsysteme jeweils mit einem oder mehreren Resten R² substituiert sein können; und wobei eine oder mehrere CH₂-Gruppen in den genannten Alkyl-, Alkoxy-, Alkenyl- und Alkinylgruppen durch -R²C=CR²-, -C=C-, Si(R²)₂, C=O, C=NR², -C(=O)O-, -C(=O)NR²-, NR², P(=O)(R²), -O-, -S-, SO oder SO₂ ersetzt sein können;
Ar⁸ und Ar⁹ bei jedem Auftreten gleich oder verschieden gewählt sind aus aromatischen Ringsystemen mit 6 bis 40 aromatischen Ringatomen, die mit einem oder mehreren Resten R⁵ substituiert sein können, und heteroaromatischen Ringsystemen mit 5 bis 40 aromatischen Ringatomen, die mit einem oder mehreren Resten R⁵ substituiert sein können;
m und p bei jedem Auftreten gleich oder verschieden gewählt sind aus 0 und 1;
und die Naphthylgruppen an den unsubstituiert dargestellten Positionen jeweils mit einem Rest R⁵ substituiert sein können.

Bevorzugt sind in Formel (II-B) m und p gleich 0.

Weiterhin bevorzugt sind in Formel (II-B) die Gruppen R⁵ gleich H.

Weiterhin bevorzugt ist mindestens eine Gruppe R^{5A} in der Verbindung der Formel (II-B) ungleich H oder D.

Weiterhin bevorzugt ist in Formel (II-B) mindestens eine der beiden Gruppen R^{5A}, besonders bevorzugt beide der beiden Gruppen R^{5A} bei jedem Auftreten gleich oder verschieden gewählt aus geradkettigen Alkyl- oder Alkoxygruppen mit 1 bis 20 C-Atomen, verzweigten oder cyclischen Alkyl- oder Alkoxygruppen mit 3 bis 20 C-Atomen, Alkenyl- oder Alkinylgruppen mit 2 bis 20 C-Atomen, aromatischen Ringsystemen mit 6 bis 40 aromatischen Ringatomen, und heteroaromatischen Ringsystemen mit 5 bis 40 aromatischen Ringatomen, wobei die genannten Alkyl-, Alkoxy-, Alkenyl- und Alkinylgruppen und die genannten aromatischen Ringsysteme und heteroaromatischen Ringsysteme jeweils mit einem oder mehreren Resten R² substituiert sein können. Besonders bevorzugt sind in Formel (II-B) die beiden Gruppen R^{5A} gleich gewählt.

Besonders bevorzugte Struktureinheiten der Formel (II-B) sind in der folgenden Tabelle gezeigt:

| | | | |
|---|---|---|---|
| 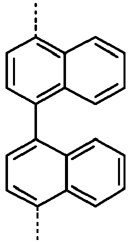 | 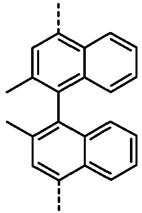 | 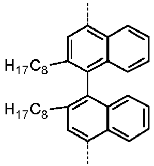 | 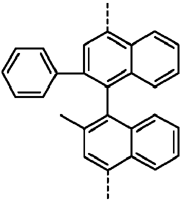 |
| (II-B-a) | (II-B-b) | (II-B-c) | (II-B-d) |
| 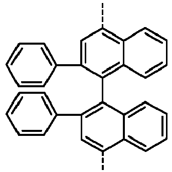 | 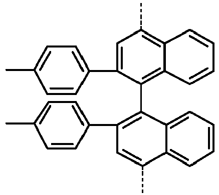 | 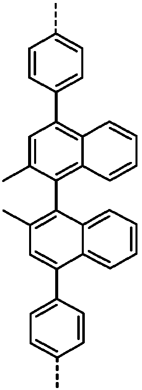 | 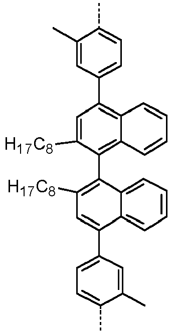 |
| (II-B-e) | (II-B-f) | (II-B-g) | (II-B-h) |
| 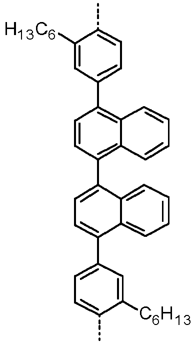 | 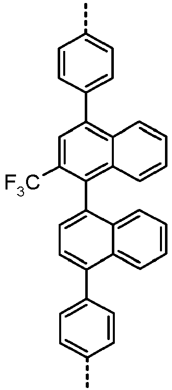 | 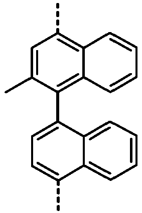 | 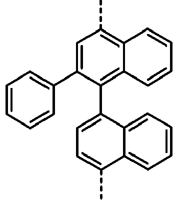 |
| (II-B-i) | (II-B-j) | (II-B-k) | (II-B-l) |

Bevorzugt hat in der Struktureinheit der Formel (II-C) k einen Wert von 1 bis 9, besonders bevorzugt von 3 bis 8, ganz besonders bevorzugt von 4 bis 8.

Weiterhin ist es bevorzugt, dass die Alkylenkette von Formel (II-C) unsubstituiert ist, das heißt, dass keine H-Atome in der Alkylenkette durch Reste R⁵ ersetzt sind.

Weiterhin ist es bevorzugt, dass in der Alkylenkette von Formel (II-C) keine Gruppen CH₂ durch die oben genannten divalenten Gruppen ersetzt sind. Sofern Gruppen CH₂ durch die oben genannten Gruppen ersetzt sind, sind dies bevorzugt eine, zwei oder drei Gruppen CH₂. Die divalenten Gruppen, welche Gruppen CH₂ ersetzen können, sind bevorzugt gleich O.

Bevorzugte Struktureinheiten C entsprechen der Formel (II-C-1) 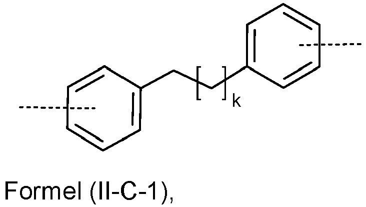 wobei die unsubstituiert gezeichneten Positionen an den Benzolringen und an der Alkylenkette jeweils mit einem Rest R⁵ substituiert sein können, und wobei k einen Wert von 0 bis 9 hat, und wobei Gruppen CH₂ in der Alkylenkette jeweils durch eine divalente Gruppe O ersetzt sein können.

Bevorzugt hat dabei k einen Wert, wie er oben allgemein als bevorzugt angegeben ist.

Besonders bevorzugte Struktureinheiten der Formel (II-C) sind in der folgenden Tabelle gezeigt:

| | |
|---|---|
| 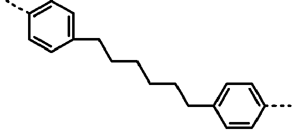 | 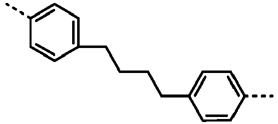 |
| (II-C-1-a) | (II-C-1-b) |
| 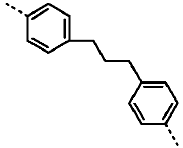 | 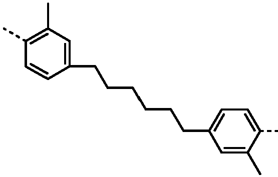 |
| (II-C-1-c) | (II-C-1-d) |
| 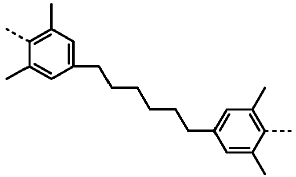 | 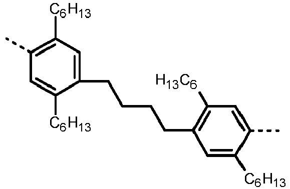 |
| (II-C-1-e) | (II-C-1-f) |
| 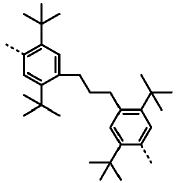 | 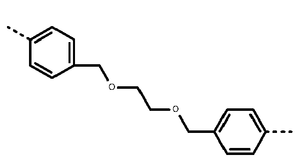 |
| (II-C-1-g) | (II-C-1-h) |
| 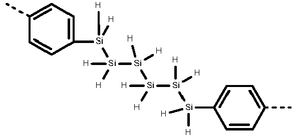 | 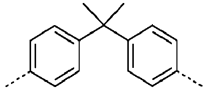 |
| (II-C-1-i) | (II-C-1-j) |

Bevorzugt beträgt die Summe der Anteile derjenigen Struktureinheiten, die einer Struktureinheit A, B oder C entsprechen, im Polymer zwischen 30 und 60 Mol-%, bezogen auf 100 Mol-% aller copolymerisierten Monomere, die im Polymer als Struktureinheiten enthalten sind.

Bevorzugt beträgt die Summe der Anteile derjenigen Struktureinheiten, die einer Struktureinheit der Formel (I) entsprechen, im Polymer zwischen 25 und 45 Mol-%, bezogen auf 100 Mol-% aller copolymerisierten Monomere, die im Polymer als Struktureinheiten enthalten sind.

Bevorzugt enthält das Polymer mindestens eine Struktureinheit, die eine vernetzbare Gruppe Q aufweist. Die Struktureinheit enthaltend die vernetzbare Gruppe Q kann eine Struktureinheit der Formel (I), eine Struktureinheit A, eine Struktureinheit B, eine Struktureinheit C oder eine andere Struktureinheit sein. Andere Struktureinheiten, die eine vernetzbare Gruppe Q aufweisen, sind bevorzugt gewählt aus Struktureinheiten der weiter unten genannten Gruppe 1 (=Einheiten, welche die Lochinjektions- und/oder Lochtransporteigenschaften der Polymere beeinflussen), insbesondere Triarylamin-Struktureinheiten, und Struktureinheiten der weiter unten genannten Gruppe 4 (=Einheiten, welche typischerweise als Polymergrundgerüst (Backbone) verwendet werden), insbesondere Fluoren-, Indenofluoren, und Spirobifluoren-Struktureinheiten.

Vernetzbare Gruppe im Sinne der vorliegenden Anmeldung bedeutet eine funktionelle Gruppe, die in der Lage ist, im Polymer eine Reaktion einzugehen und so eine unlösliche Verbindung zu bilden. Die Reaktion kann dabei mit einer weiteren, gleichen Gruppe Q, einer weiteren, verschiedenen Gruppe Q oder einem beliebigen anderen Teil derselben oder einer anderen Polymerkette erfolgen. Bei der vernetzbaren Gruppe handelt es sich somit um eine reaktive Gruppe. Dabei erhält man als Ergebnis der chemischen Reaktion der vernetzbaren Gruppe ein entsprechend vernetztes Polymer.

Die Vernetzungsreaktion kann in einer Polymerschicht enthaltend ein Polymer, welches eine Struktureinheit enthaltend eine vernetzbare Gruppe enthält, durchgeführt werden, wobei eine unlösliche Polymerschicht entsteht. Die Vernetzung kann durch Wärme oder durch UV-, Mikrowellen-, Röntgen- oder Elektronenstrahlung unterstützt werden, und gegebenenfalls in Gegenwart eines Initiators stattfinden. "Unlöslich" im Sinne der vorliegenden Anmeldung bedeutet vorzugsweise, dass das Polymer nach der Vernetzungsreaktion, also nach der Reaktion der vernetzbaren Gruppen, bei Raumtemperatur in einem organischen Lösungsmittel eine Löslichkeit aufweist, die mindestens um einen Faktor 3, vorzugsweise mindestens um einen Faktor 10, geringer ist als die des entsprechenden, nicht-vernetzten, erfindungsgemäßen Polymers in demselben organischen Lösungsmittel.

Es ist insbesondere die Aufgabe der vernetzbaren Gruppe, durch eine Vernetzungsreaktion die Polymere miteinander zu verknüpfen. Es gehört zum allgemeinen Fachwissen des Fachmanns auf dem Gebiet der vorliegenden Anmeldung, welche chemischen Gruppen grundsätzlich als vernetzbare Gruppen geeignet sind.

Die Vernetzungsreaktion führt zu einer vernetzten Polymerverbindung, sowie, wenn die Reaktion in einer Polymerschicht durchgeführt wird, zu einer vernetzten Polymerschicht. Unter einer vernetzten Schicht im Sinne der vorliegenden Erfindung wird eine Schicht verstanden, die erhältlich ist durch Durchführung der Vernetzungsreaktion aus einer Schicht des vernetzbaren Polymers. Die Vernetzungsreaktion kann im Allgemeinen durch Wärme und/oder durch UV-, Mikrowellen-, Röntgen- oder Elektronenstrahlung und/oder durch den Einsatz von Radikalbildnern, Anionen, Kationen, Säuren und/oder Photosäuren initiiert werden. Ebenso kann die Anwesenheit von Katalysatoren und/oder Initiatoren sinnvoll oder notwendig sein. Bevorzugt ist die Vernetzungsreaktion eine Reaktion, für die kein Initiator und kein Katalysator zugesetzt werden muss.

Erfindungsgemäß bevorzugte vernetzbare Gruppen Q sind die im Folgenden aufgeführten Gruppen:

### a) Endständige oder cyclische Alkenyl- bzw. endständige Dienyl- und Alkinylgruppen:

Davon umfasst sind Einheiten, die eine endständige oder cyclische Doppelbindung, eine endständige Dienylgruppe oder eine endständige Dreifachbindung enthalten, insbesondere endständige oder cyclische Alkenyl-, endständige Dienyl- bzw. endständige Alkinylgruppen mit 2 bis 40 C-Atomen, vorzugsweise mit 2 bis 10 C-Atomen. Weiterhin eignen sich auch Gruppen, die Vorstufen der oben genannten Gruppen sind und die in situ zu einer Bildung einer Doppel- oder Dreifachbindung in der Lage sind, beispielsweise Aldehydgruppen.

### b) Alkenyloxy-, Dienyloxy- bzw. Alkinyloxygruppen:

Davon umfasst sind Alkenyloxy-, Dienyloxy- bzw. Alkinyloxygruppen, vorzugsweise Alkenyloxygruppen.

### c) Acrylsäuregruppen:

Davon umfasst sind Acrylsäureeinheiten im weitesten Sinne, vorzugsweise Acrylester, Acrylamide, Methacrylester und Methacrylamide. Besonders bevorzugt sind C₁₋₁₀-Alkylacrylat und C₁₋₁₀-Alkylmethacrylat.

Die Vernetzungsreaktion der oben unter a) bis c) genannten Gruppen kann über einen radikalischen, einen kationischen oder einen anionischen Mechanismus aber auch über Cycloaddition erfolgen.

Es kann sinnvoll sein, einen entsprechenden Initiator für die Vernetzungsreaktion zuzugeben. Geeignete Initiatoren für die radikalische Vernetzung sind beispielsweise Dibenzoylperoxid, AIBN oder TEMPO. Geeignete Initiatoren für die kationische Vernetzung sind beispielsweise AlCl₃, BF₃, Triphenylmethylperchlorat oder Tropyliumhexachlorantimonat. Geeignete Initiatoren für die anionische Vernetzung sind Basen, insbesondere Butyllithium.

In einer bevorzugten Ausführungsform der vorliegenden Erfindung wird die Vernetzung jedoch ohne den Zusatz eines Initiators durchgeführt und ausschließlich thermisch initiiert. Dies hat den Vorteil, dass die Abwesenheit des Initiators Verunreinigungen der Schicht verhindert, die zu einer Verschlechterung der Deviceeigenschaften führen könnten.

### d) Oxetane und Oxirane:

Eine weitere geeignete Klasse vernetzbarer Gruppen Q sind Oxetane und Oxirane, die durch Ringöffnung kationisch vernetzen.

Es kann sinnvoll sein, einen entsprechenden Initiator für die Vernetzungsreaktion zuzugeben. Geeignete Initiatoren sind beispielsweise AlCl₃, BF₃, Triphenylmethylperchlorat oder Tropyliumhexachlorantimonat. Ebenso können Photosäuren als Initiatoren zugegeben werden.

### e) Silane:

Weiterhin geeignet als Klasse vernetzbarer Gruppen sind Silangruppen SiRs, wobei mindestens zwei Gruppen R, bevorzugt alle drei Gruppen R für Cl oder eine Alkoxygruppe mit 1 bis 20 C-Atomen stehen. Diese Gruppe reagiert in der Anwesenheit von Wasser zu einem Oligo- oder Polysiloxan.

### f) Cyclobutangruppen

Hiervon umfasst sind insbesondere Cyclobutangruppen, die eine Aryl- oder Heteroarylgruppe ankondensiert sind, beispielsweise an eine Phenylgruppe ankondensiert sind.

Die oben genannten vernetzbaren Gruppen Q sind dem Fachmann generell bekannt, ebenso wie die geeigneten Reaktionsbedingungen, die zur Reaktion dieser Gruppen verwendet werden.

Besonders bevorzugt unter den oben genannten Gruppen Q sind Gruppen Q gemäß obenstehenden Gruppen a) und f), ganz besonders bevorzugt sind endständige Alkenylgruppen und Cyclobutangruppen.

Besonders bevorzugte vernetzbare Gruppen Q sind die folgenden:

| | |
|---|---|
| 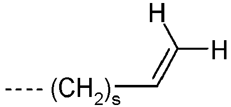 | 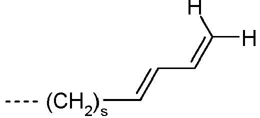 |
| Q1a | Q2a |
| 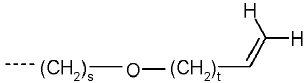 | 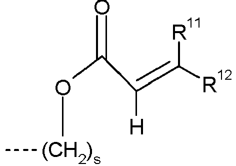 |
| Q4a | Q7a |
| 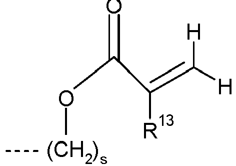 | 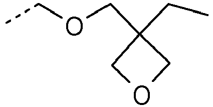 |
| Q7b | Q9a |
| 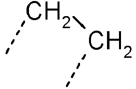 | 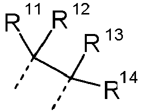 |
| Q12 | Q13 |
| 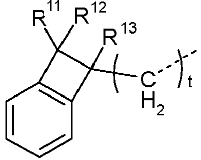 | 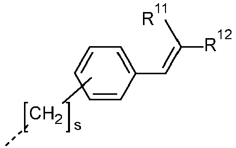 |
| Q14a | Q15a |
| 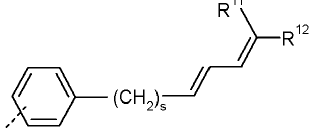 | 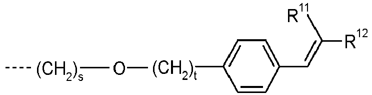 |
| Q16a | Q18a |
| 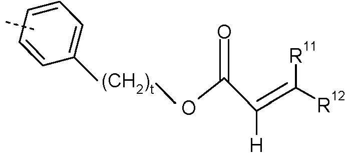 | 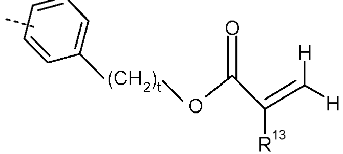 |
| Q21a | Q21b |
| 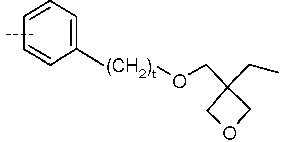 | 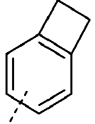 |
| Q23a | Q26a |
| 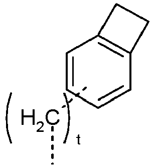 | 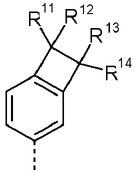 |
| Q27a | Q28a |

Dabei stellen die gestrichelten Linien die Bindungen zu der Struktureinheit dar, an die die betreffende vernetzbare Gruppe gebunden ist.

Die Reste R¹¹, R¹² ,R¹³ und R¹⁴ sind in den oben genannten bevorzugten Formeln für die Gruppe Q bei jedem Auftreten, gleich oder verschieden H oder eine geradkettige oder verzweigte Alkylgruppe mit 1 bis 6 C-Atomen, vorzugsweise 1 bis 4 C-Atomen. Besonders bevorzugt sind die Reste R¹¹, R¹² ,R¹³ und R¹⁴ bei jedem Auftreten gleich oder verschieden Methyl, Ethyl, n-Propyl, iso-Propyl, n-Butyl, sec-Butyl oder tert-Butyl, und ganz besonders bevorzugt Methyl. Die in den oben genannten bevorzugten Formeln für die Gruppe Q verwendeten Indices haben die folgende Bedeutung: s = 0 bis 8 und t = 1 bis 8.

Am stärksten bevorzugte vernetzbare Gruppen Q sind die folgenden:

| | |
|---|---|
| 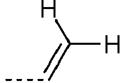 | 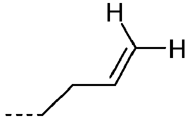 |
| Q1b | Q1c |
| 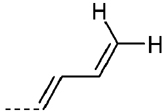 | 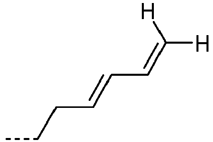 |
| Q2b | Q2c |
| 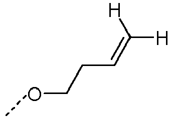 | 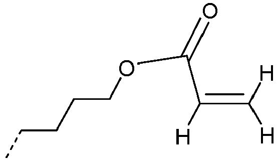 |
| Q4b | Q7c |
| 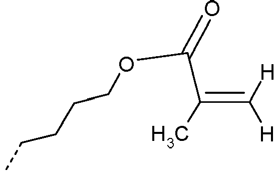 | 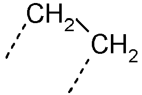 |
| Q7d | Q12b |
| 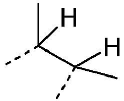 | 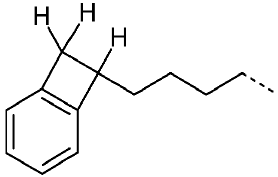 |
| Q13a | Q14b |
| 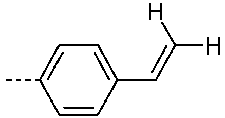 | 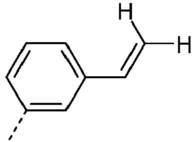 |
| Q15b | Q15c |
| 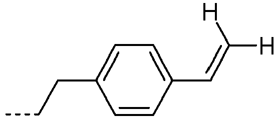 | 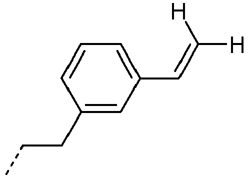 |
| Q15d | Q15e |
| 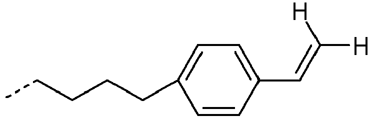 | 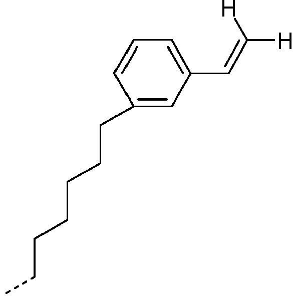 |
| Q15f | Q15g |
| 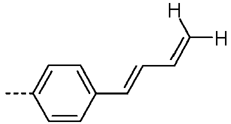 | 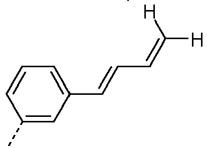 |
| Q16b | Q16c |
| 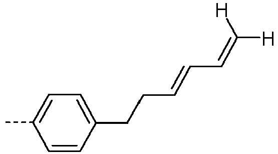 | 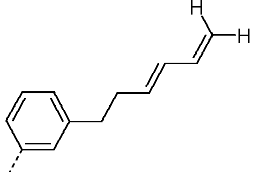 |
| Q16d | Q16e |
| 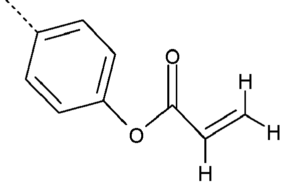 | 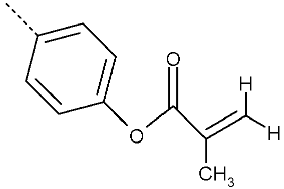 |
| Q21c | Q21d |
| 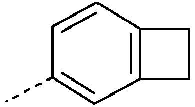 | 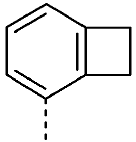 |
| Q26b | Q26c |
| 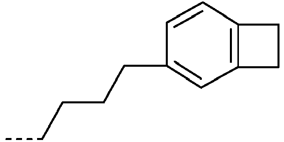 | 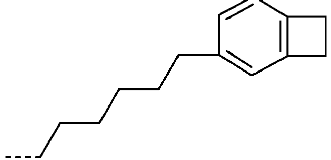 |
| Q27b | Q27c |

Dabei stellen die gestrichelten Linien die Bindungen zu der Struktureinheit dar, an die die betreffende vernetzbare Gruppe gebunden ist.

Bevorzugte Struktureinheiten, die eine Gruppe Q tragen, sind gewählt aus Struktureinheiten der oben definierten Formel (I). Entsprechende Struktureinheiten werden durch die Formel (I-Q) beschrieben, wobei die Anzahl an Gruppen Q pro Struktureinheit nicht beschränkt ist, bevorzugt jedoch 1 oder 2, besonders bevorzugt 1 beträgt, wobei Q wie oben definiert ist, wobei "Formel (I)" eine Einheit der Formel (I), wie oben definiert, darstellt:

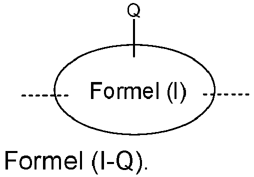

Die Gruppen Q sind hier und allgemein im Folgenden bevorzugt gewählt aus den oben angegebenen bevorzugten Ausführungsformen der Gruppen Q.

Besonders bevorzugte Struktureinheiten der Formel (I-Q) entsprechen der Formel (1-1-Q), wobei die Anzahl an Gruppen Q pro Struktureinheit nicht beschränkt ist, bevorzugt jedoch 1 oder 2, besonders bevorzugt 1 beträgt, wobei Q wie oben definiert ist, und wobei "Formel (I-1)" eine Einheit der Formel (I-1), wie oben definiert, darstellt:

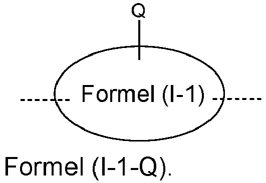

Ganz besonders bevorzugte Ausführungsformen der Formel (I-1-Q) entsprechen der Formel (I-1-A-Q-1) oder (I-1-A-Q-2)

| | |
|---|---|
| 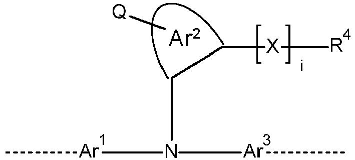 | 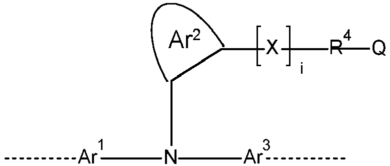 |
| Formel (I-1-A-Q-1) | Formel (I-1-A-Q-2) |

wobei die auftretenden Gruppen wie für Formel (1-1-A) definiert sind, und wobei Q definiert ist wie oben, und bevorzugt den oben angegebenen bevorzugten Ausführungsformen entspricht.

Ganz besonders bevorzugte Ausführungsformen der Formel (I-1-Q) entsprechen einer der Formeln (I-1-B-Q-1), (I-1-B-Q-2), (I-1-B-Q-3) und (I-1-B-Q-4)

| |
|---|
| 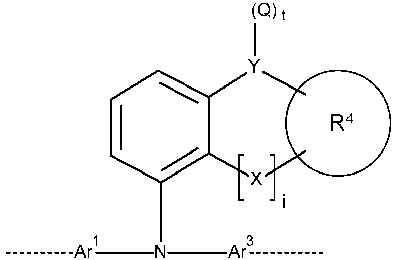 |
| Formel (I-1-B-Q-1) |
| 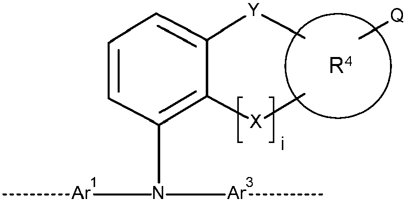 |
| Formel (I-1-B-Q-2) |
| 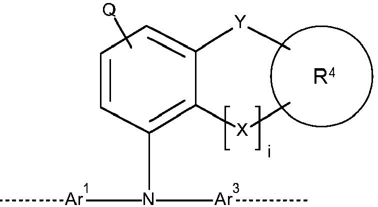 |
| Formel (I-1-B-Q-3) |
| 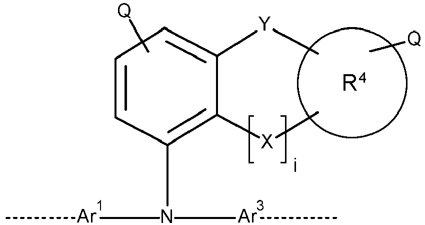 |
| Formel (I-1-B-Q-4) |

wobei die auftretenden Gruppen wie für Formel (I-1-B) definiert sind, und wobei Q definiert ist wie oben, und bevorzugt den oben angegebenen bevorzugten Ausführungsformen entspricht, und wobei t je nach Valenz der Gruppe Y 0, 1 oder 2 ist.

Besonders bevorzugte Struktureinheiten der Formel (I-Q) entsprechen der Formel (I-2-Q), welche entsprechend Formel (I-Q) definiert ist:

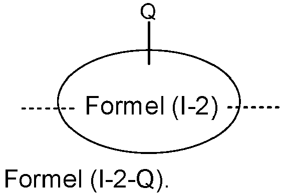

Ganz besonders bevorzugte Ausführungsformen der Formel (I-2-Q) entsprechen der Formel (I-2-A-Q-1) oder (I-2-A-Q-1)

| |
|---|
| 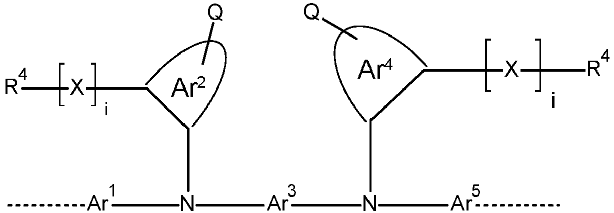 |
| Formel (I-2-A-Q-1) |
| 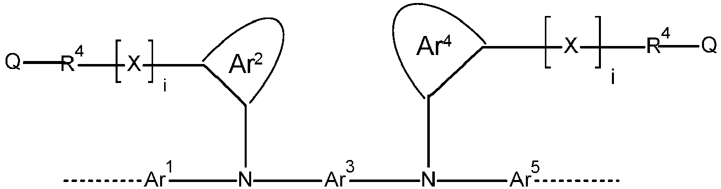 |
| Formel (I-2-A-Q-1) |

wobei die auftretenden Gruppen wie für Formel (I-2-A) definiert sind, und wobei Q definiert ist wie oben, und bevorzugt den oben angegebenen bevorzugten Ausführungsformen entspricht.

Ganz besonders bevorzugte Ausführungsformen der Formel (I-2-Q) entsprechen der Formel (I-2-B-3-Q-1), (I-2-B-3-Q-2) oder (I-2-B-3-Q-3)

| |
|---|
| 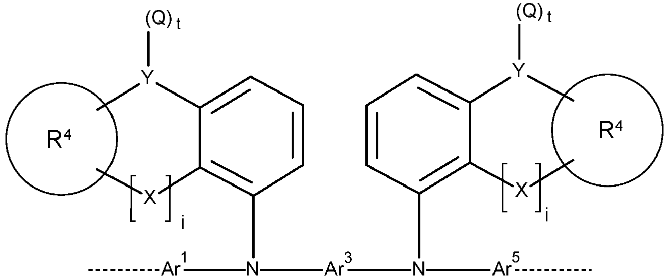 |
| Formel (I-2-B-3-Q-1) |
| 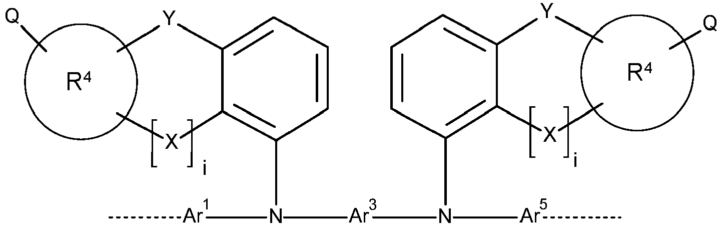 |
| Formel (I-2-B-3-Q-2) |
| 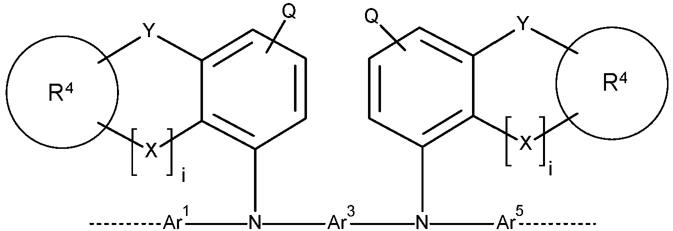 |
| Formel (I-2-B-3-Q-3) |

wobei die auftretenden Gruppen wie für Formel (I-2-B-3) definiert sind, und wobei Q definiert ist wie oben, und bevorzugt den oben angegebenen bevorzugten Ausführungsformen entspricht, und wobei t je nach Valenz der Gruppe Y 0, 1 oder 2 ist.

Ganz besonders bevorzugte Struktureinheiten der Formel (I-Q) sind die in den Tabellen auf S. 30 und 32 der WO 2013/156130 abgebildeten Struktureinheiten (11a) bis (11f) und (11g) bis (11o), wobei R durch R¹ bzw. R² zu ersetzen ist, und k, m, n und p die jeweils mögliche Zahl an Substituenten am betreffenden Ring kennzeichnen.

Bevorzugte Struktureinheiten, die eine Gruppe Q tragen, sind gewählt aus Struktureinheiten der oben definierten Formel (II-A). Entsprechende Struktureinheiten werden durch die Formel (II-A-Q) beschrieben, wobei die Anzahl an Gruppen Q pro Struktureinheit nicht beschränkt ist, bevorzugt jedoch 1 oder 2, besonders bevorzugt 1 beträgt, wobei Q wie oben definiert ist, wobei "Formel (II-A)" eine Einheit der Formel (II-A), wie oben definiert, darstellt:

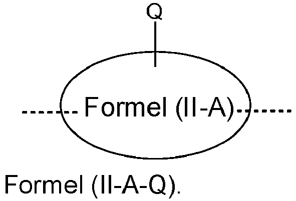

Besonders bevorzugte Struktureinheiten der Formel (II-A-Q) entsprechen der Formel (II-A-1-Q), wobei die Anzahl an Gruppen Q pro Struktureinheit nicht beschränkt ist, bevorzugt jedoch 1 oder 2, besonders bevorzugt 1 beträgt, wobei Q wie oben definiert ist, wobei "Formel (II-A-1)" eine Einheit der Formel (II-A-1), wie oben definiert, darstellt:

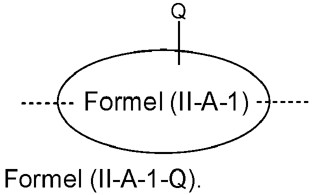

Ganz besonders bevorzugte Ausführungsformen der Formel (II-A-1-Q) entsprechen einer der Formeln (II-A-1-Q-1), (II-A-1-Q-2) und (II-A-1-Q-3)

| | |
|---|---|
| 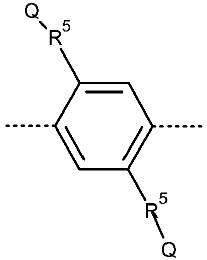 | 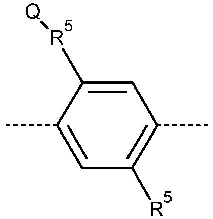 |
| Formel (II-A-1-Q-1) | Formel (II-A-1-Q-2) |
| 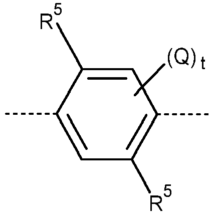 | |
| Formel (II-A-1-Q-3) | |

wobei die auftretenden Gruppen wie für Formel (II-A-1) definiert sind, und wobei Q definiert ist wie oben, und bevorzugt den oben angegebenen bevorzugten Ausführungsformen entspricht, und wobei t gleich 1 oder 2 ist.

Bevorzugte Struktureinheiten, die eine Gruppe Q tragen, sind gewählt aus Struktureinheiten der oben definierten Formel (II-B). Entsprechende Struktureinheiten werden durch die Formel (II-B-Q) beschrieben, wobei die Anzahl an Gruppen Q pro Struktureinheit nicht beschränkt ist, bevorzugt jedoch 1 oder 2, besonders bevorzugt 1 beträgt, wobei Q wie oben definiert ist, wobei "Formel (II-B)" eine Einheit der Formel (II-B), wie oben definiert, darstellt:

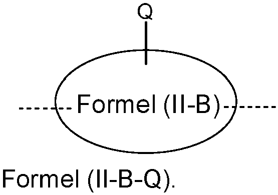

Ganz besonders bevorzugte Ausführungsformen der Formel (II-B-Q) entsprechen einer der Formeln (II-B-Q-1), (II-B-Q-2) und (II-B-Q-3)

| |
|---|
| 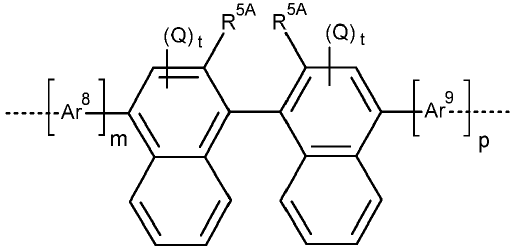 |
| Formel (II-B-Q-1) |
| 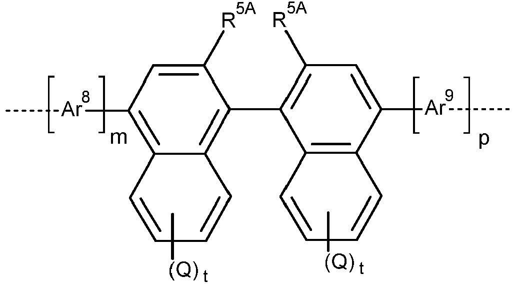 |
| Formel (II-B-Q-2) |
| 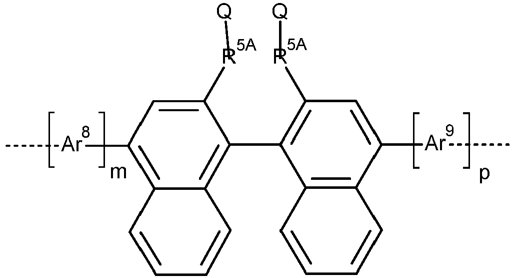 |
| Formel (II-B-Q-3) |

wobei die auftretenden Gruppen wie für Formel (II-B) definiert sind, und wobei Q definiert ist wie oben, und bevorzugt den oben angegebenen bevorzugten Ausführungsformen entspricht, und wobei t gleich 1 bis maximal der Zahl der freien Bindungspositionen an dem betreffenden Ring ist.

Bevorzugte Struktureinheiten, die eine Gruppe Q tragen, sind gewählt aus Struktureinheiten der oben definierten Formel (II-C). Entsprechende Struktureinheiten werden durch die Formel (II-C-Q) beschrieben, wobei die Anzahl an Gruppen Q pro Struktureinheit nicht beschränkt ist, bevorzugt jedoch 1 oder 2, besonders bevorzugt 1 beträgt, wobei Q wie oben definiert ist, wobei "Formel (II-C)" eine Einheit der Formel (II-C), wie oben definiert, darstellt:

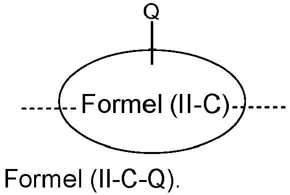

Besonders bevorzugte Struktureinheiten der Formel (II-C-Q) entsprechen der Formel (II-C-1-Q), welche entsprechend Formel (II-C-Q) definiert ist:

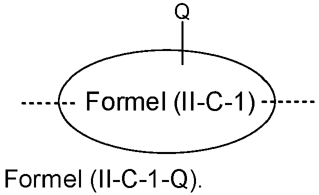

Ganz besonders bevorzugte Ausführungsformen der Formel (II-C-1-Q) entsprechen der Formel (II-C-1-Q-1) 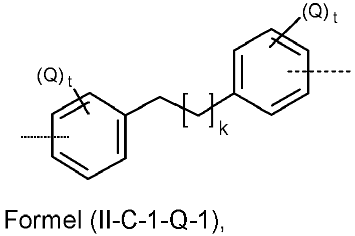 wobei die auftretenden Gruppen wie für Formel (II-C-1) definiert sind, und wobei Q definiert ist wie oben, und bevorzugt den oben angegebenen bevorzugten Ausführungsformen entspricht, und wobei t gleich 0 bis maximal der Zahl der freien Bindungspositionen an dem betreffenden Ring ist, wobei nicht alle t gleich 0 sind.

Weitere bevorzugte Ausführungsformen von Struktureinheiten enthaltend eine Gruppe Q sind die im Folgenden gezeigten Struktureinheiten der Formeln (III-Q-1) und (III-Q-2)

| | |
|---|---|
| 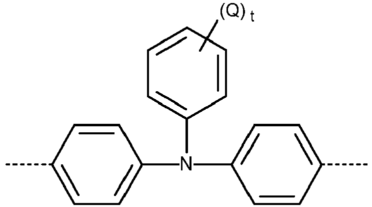 | 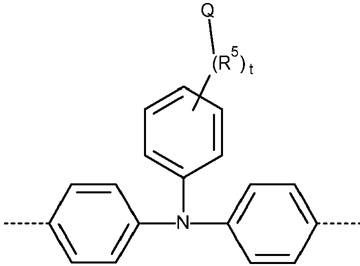 |
| Formel (III-Q-1) | Formel (III-Q-2) |

wobei die Benzolringe an den freien Positionen jeweils mit einem Rest R⁵, wie oben definiert, substituiert sein können, und wobei t einen Wert von 1 bis 5 hat und bevorzugt gleich 1 oder 2, besonders bevorzugt gleich 1 ist.

Weitere bevorzugte Ausführungsformen von Struktureinheiten enthaltend eine Gruppe Q sind die im Folgenden gezeigten Struktureinheiten der Formeln (IV-Q-1) bis (IV-Q-3)

| | |
|---|---|
| 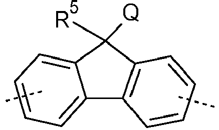 | 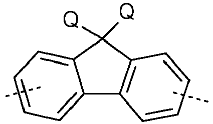 |
| Formel (IV-Q-1) | Formel (IV-Q-2) |

| | |
|---|---|
| 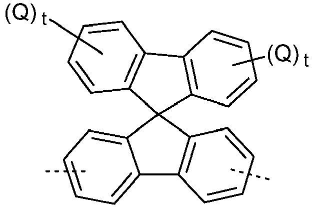 | |
| Formel (IV-Q-3) | |

wobei die Benzolringe an den freien Positionen jeweils mit einem Rest R⁵, wie oben definiert, substituiert sein können, und wobei t einen Wert von 1 bis 5 hat und bevorzugt gleich 1 oder 2, besonders bevorzugt gleich 1 ist.

Bevorzugte konkrete Ausführungsformen von Struktureinheiten enthaltend eine oder mehrere Gruppen Q sind in der folgenden Tabelle aufgeführt:

| | | |
|---|---|---|
| 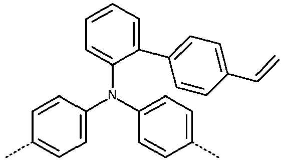 | 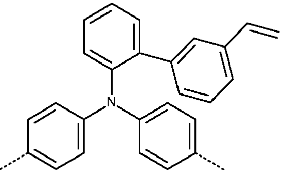 | 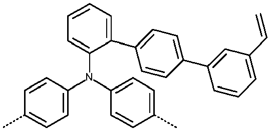 |
| SE-Q-1 | SE-Q-2 | SE-Q-3 |
| 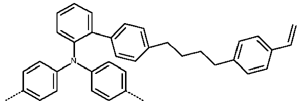 | 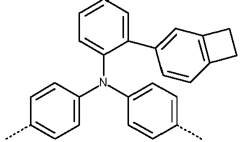 | 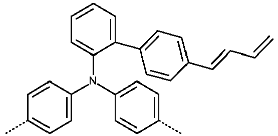 |
| SE-Q-4 | SE-Q-5 | SE-Q-6 |
| 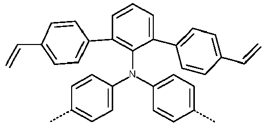 | 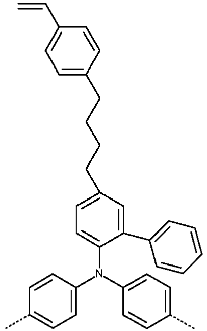 | 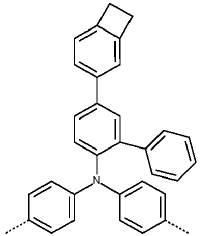 |
| SE-Q-7 | SE-Q-8 | SE-Q-9 |
| 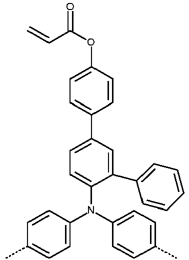 | 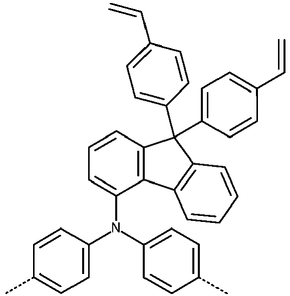 | 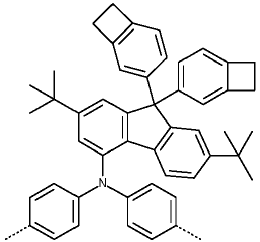 |
| SE-Q-10 | SE-Q-11 | SE-Q-12 |
| 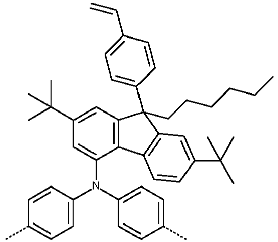 | 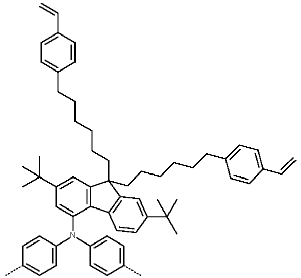 | 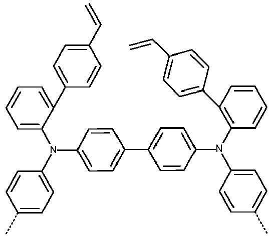 |
| SE-Q-13 | SE-Q-14 | SE-Q-15 |
| 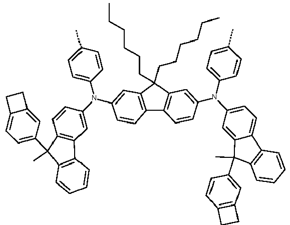 | 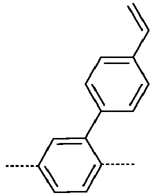 | 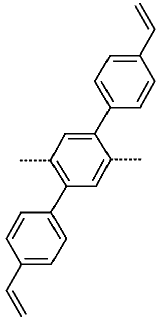 |
| SE-Q-16 | SE-Q-17 | SE-Q-18 |
| 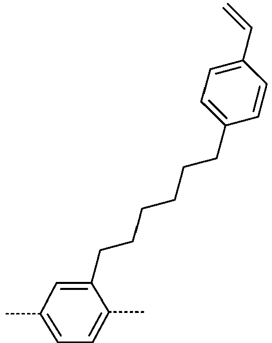 | 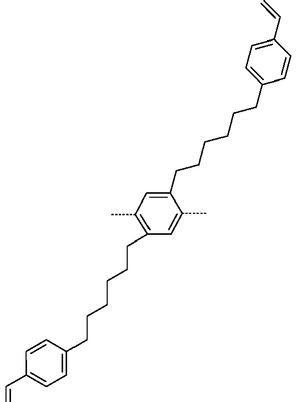 | 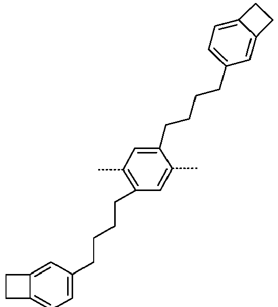 |
| SE-Q-19 | SE-Q-20 | SE-Q-21 |
| 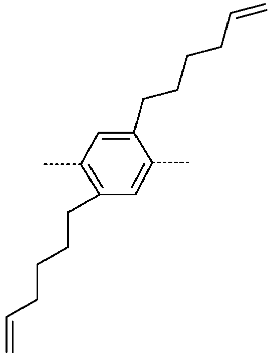 | 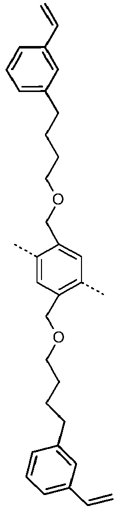 | 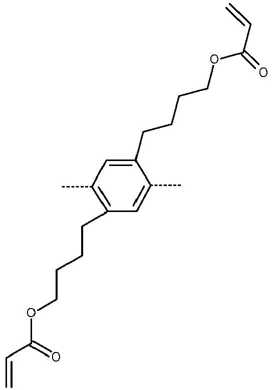 |
| SE-Q-22 | SE-Q-23 | SE-Q-24 |
| 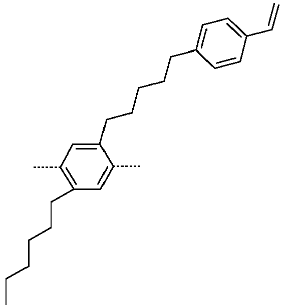 | 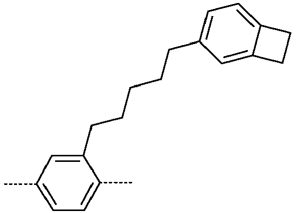 | 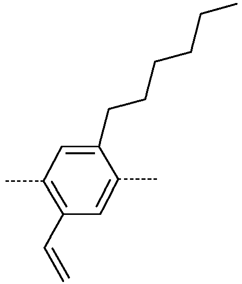 |
| SE-Q-25 | SE-Q-26 | SE-Q-27 |
| 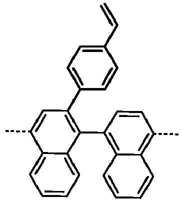 | 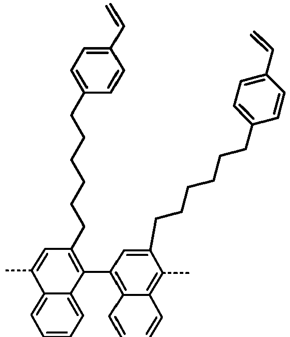 | 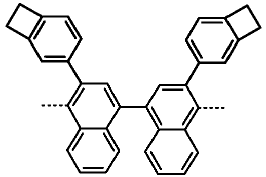 |
| SE-Q-28 | SE-Q-29 | SE-Q-30 |
| 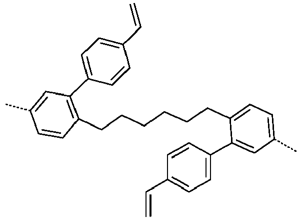 | 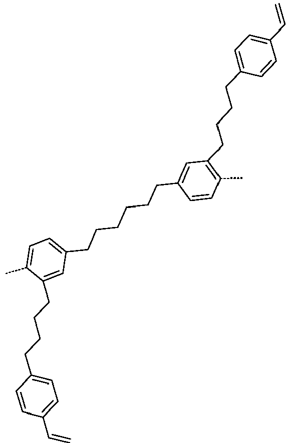 | 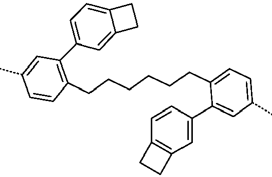 |
| SE-Q-31 | SE-Q-32 | SE-Q-33 |
| 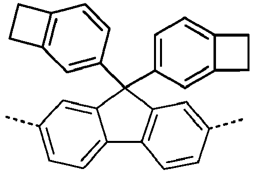 | 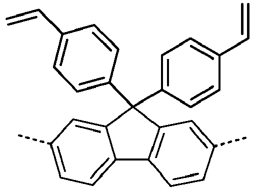 | 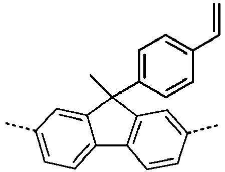 |
| SE-Q-34 | SE-Q-35 | SE-Q-36 |
| 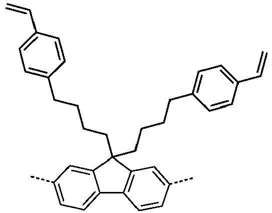 | 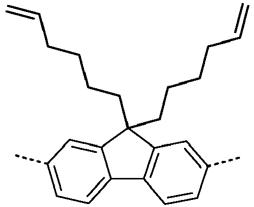 | 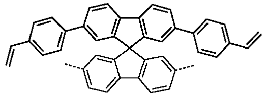 |
| SE-Q-37 | SE-Q-38 | SE-Q-39 |
| 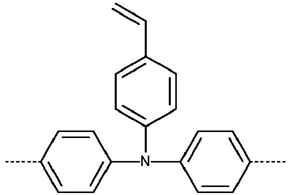 | 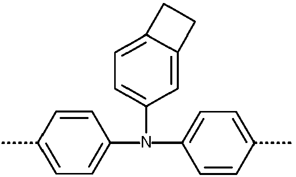 | 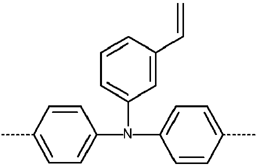 |
| SE-Q-40 | SE-Q-41 | SE-Q-42 |
| 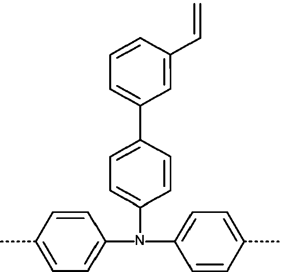 | 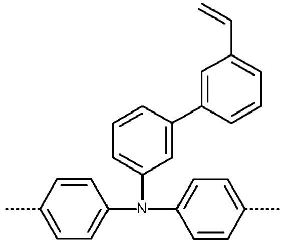 | |
| SE-Q-43 | SE-Q-44 | |

Der Anteil vernetzbarer Struktureinheiten liegt im Polymer im Bereich von 1 bis 50 mol%, vorzugsweise im Bereich von 2 bis 40 mol%, besonders bevorzugt im Bereich von 5 bis 30 mol%, bezogen auf 100 mol% aller copolymerisierten Monomere, die im Polymer als Struktureinheiten enthalten sind.

Zusätzlich zu Struktureinheiten der Formel (I), Struktureinheiten A, B und C, und vernetzbaren Struktureinheiten kann das Polymer noch weitere Struktureinheiten enthalten.

Die weiteren Struktureinheiten können beispielsweise aus den folgenden Klassen stammen:

| | |
|---|---|
| Gruppe 1: | Einheiten, welche die Lochinjektions- und/oder Lochtransporteigenschaften der Polymere beeinflussen; |
| Gruppe 2: | Einheiten, welche die Elektroneninjektions- und/oder Elektronentransporteigenschaften der Polymere beeinflussen; |

| | |
|---|---|
| Gruppe 3: | Einheiten, die Kombinationen von Einzeleinheiten der Gruppe 1 und Gruppe 2 aufweisen; |
| Gruppe 4: | Einheiten, welche typischerweise als Polymergrundgerüst (Backbone) verwendet werden; |
| Gruppe 5: | Einheiten, welche die Filmmorphologie und/oder die rheologischen Eigenschaften der resultierenden Polymere beeinflussen. |

Struktureinheiten aus der Gruppe 1, die Lochinjektions- und/oder Lochtransporteigenschaften aufweisen, sind beispielsweise Triarylamin-, Benzidin-, Tetraaryl-para-phenylendiamin-, Triarylphosphin-, Phenothiazin-, Phenoxazin-, Dihydrophenazin-, Thianthren-, Dibenzo-para-dioxin-, Phenoxathiin-, Carbazol-, Azulen-, Thiophen-, Pyrrol- und Furanderivate und weitere O-, S- oder N-haltige Heterocyclen.

Struktureinheiten aus der Gruppe 2, die Elektroneninjektions- und/oder Elektronentransporteigenschaften aufweisen, sind beispielsweise Pyridin-, Pyrimidin-, Pyridazin-, Pyrazin-, Oxadiazol-, Chinolin-, Chinoxalin-, Anthracen-, Benzanthracen-, Pyren-, Perylen-, Benzimidazol-, Triazin-, Keton-, Phosphinoxid- und Phenazinderivate, aber auch Triarylborane und weitere O-, S- oder N-haltige Heterocyclen.

Es kann bevorzugt sein, wenn in den erfindungsgemäßen Polymeren Einheiten aus der Gruppe 3 enthalten sind, in denen Strukturen, welche die Lochmobilität und welche die Elektronenmobilität erhöhen (also Einheiten aus Gruppe 1 und 2), direkt aneinander gebunden sind oder Strukturen enthalten sind, die sowohl die Lochmobilität als auch die Elektronenmobilität erhöhen. Einige dieser Einheiten können als Emitter dienen und verschieben die Emissionsfarbe ins Grüne, Gelbe oder Rote. Ihre Verwendung eignet sich also beispielsweise für die Erzeugung anderer Emissionsfarben aus ursprünglich blau emittierenden Polymeren.

Struktureinheiten der Gruppe 4 sind Einheiten, die aromatische Strukturen mit 6 bis 40 C-Atomen beinhalten, welche typischerweise als Polymergrundgerüst (Backbone) verwendet werden. Dies sind beispielsweise 4,5-Dihydropyrenderivate, 4,5,9,10-Tetrahydropyrenderivate, Fluorenderivate, 9,9'-Spirobifluorenderivate, Phenanthrenderivate, 9,10-Dihydrophenanthrenderivate, 5,7-Dihydrodibenzooxepinderivate und cis- und trans-Indenofluorenderivate aber auch 1,2-, 1,3- oder 1,4-Phenylen-, 1,2-, 1,3- oder 1,4-Naphthylen-, 2,2`-, 3,3`- oder 4,4'-Biphenylylen-, 2,2"-, 3,3"- oder 4,4"-Terphenylylen, 2,2`-, 3,3`- oder 4,4'-Bi-1,1'-naphthylylen- oder 2,2"`-, 3,3"`- oder 4,4‴-Quarterphenylylenderivate.

Struktureinheiten der Gruppe 5 sind solche, die die Filmmorphologie und/oder die rheologischen Eigenschaften der Polymere beeinflussen, wie z.B. Siloxane, Alkylketten oder fluorierte Gruppen, aber auch besonders steife oder flexible Einheiten, flüssigkristallbildende Einheiten oder vernetzbare Gruppen.

In der vorliegenden Anmeldung sind unter dem Begriff Polymer sowohl polymere Verbindungen, oligomere Verbindungen sowie Dendrimere zu verstehen. Die erfindungsgemäßen polymeren Verbindungen weisen vorzugsweise 10 bis 10000, besonders bevorzugt 10 bis 5000 und ganz besonders bevorzugt 10 bis 2000 Struktureinheiten auf. Die erfindungsgemäßen oligomeren Verbindungen weisen vorzugsweise 3 bis 9 Struktureinheiten auf. Der Verzweigungsfaktor der Polymere liegt dabei zwischen 0 (lineares Polymer, ohne Verzweigungsstellen) und 1 (vollständig verzweigtes Dendrimer).

Die erfindungsgemäßen Polymere weisen vorzugsweise ein Molekulargewicht M_{w} im Bereich von 1.000 bis 2.000.000 g/mol, besonders bevorzugt ein Molekulargewicht M_{w} im Bereich von 10.000 bis 1.500.000 g/mol und ganz besonders bevorzugt ein Molekulargewicht M_{w} im Bereich von 20.000 bis 250.000 g/mol auf. Die Bestimmung des Molekulargewichts M_{w} erfolgt mittels GPC (= Gelpermeationschromatographie) gegen einen internen Polystyrolstandard.

Die erfindungsgemäßen Polymere weisen bevorzugt eine Polydispersität von 1 bis 15, besonders bevorzugt von 2 bis 8 auf. Die Polydispersität wird dabei mittels Gelpermeationschromatographie gegen einen internen Polystyrolstandard gemessen.

Die erfindungsgemäßen Polymere können linear oder verzweigt sein, vorzugsweise sind sie linear. Die erfindungsgemäßen Polymere können statistische, alternierende oder blockartige Strukturen aufweisen oder auch mehrere dieser Strukturen abwechselnd besitzen. Besonders bevorzugt weisen die erfindungsgemäßen Polymere statistische oder alternierende Strukturen auf. Besonders bevorzugt sind die Polymere statistische oder alternierende Polymere. Wie Polymere mit blockartigen Strukturen erhalten werden können und welche weiteren Strukturelemente dafür besonders bevorzugt sind, ist beispielsweise ausführlich in der WO 2005/014688 A2 beschrieben. Diese ist via Zitat Bestandteil der vorliegenden Anmeldung. Ebenso sei an dieser Stelle nochmals hervorgehoben, dass das Polymer auch dendritische Strukturen haben kann.

Die erfindungsgemäßen Polymere enthaltend Struktureinheiten der oben genannten Formeln werden in der Regel durch Polymerisation von entsprechenden Monomeren hergestellt. Dabei führt jeweils ein bestimmtes Monomer zu einer bestimmten Struktureinheit. Geeignete Polymerisationsreaktionen sind dem Fachmann bekannt und in der Literatur beschrieben. Besonders geeignete und bevorzugte Polymerisationsreaktionen, die zu C-C- bzw. C-N-Verknüpfungen führen, sind folgende:

| | |
|---|---|
| (A) | SUZUKI-Polymerisation; |
| (B) | YAMAMOTO-Polymerisation; |
| (C) | STILLE-Polymerisation; |
| (D) | HECK-Polymerisation; |
| (E) | NEGISHI-Polymerisation; |
| (F) | SONOGASHIRA-Polymerisation; |
| (G) | HIYAMA-Polymerisation; und |
| (H) | HARTWIG-BUCHWALD-Polymerisation |

Wie die Polymerisation nach diesen Methoden durchgeführt werden kann und wie die Polymere dann vom Reaktionsmedium abgetrennt und aufgereinigt werden können, ist dem Fachmann bekannt und in der Literatur, beispielsweise in der WO 03/048225 A2, der WO 2004/037887 A2 und der WO 2004/037887 A2 im Detail beschrieben.

Die C-C-Verknüpfungen sind vorzugsweise ausgewählt aus den Gruppen der SUZUKI-Kupplung, der YAMAMOTO-Kupplung und der STILLE-Kupplung, besonders bevorzugt der SUZUKI-Kupplung; die C-N-Verknüpfung ist vorzugsweise eine Kupplung gemäß HARTWIG-BUCHWALD.

Gegenstand der vorliegenden Erfindung ist somit auch ein Verfahren zur Herstellung der erfindungsgemäßen Polymere, das dadurch gekennzeichnet ist, dass sie durch Polymerisation gemäß SUZUKI, Polymerisation gemäß YAMAMOTO, Polymerisation gemäß STILLE oder Polymerisation gemäß HARTWIG-BUCHWALD hergestellt werden, bevorzugt durch Polymerisation gemäß SUZUKI hergestellt werden.

Zur Synthese der erfindungsgemäßen Polymere werden Monomere gewählt aus Monomeren der Formeln (M-I), (M-II-A), (M-II-B) bzw. (M-II-C) benötigt, 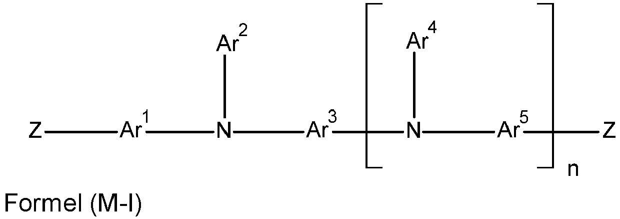 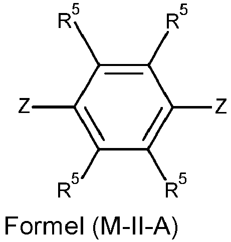 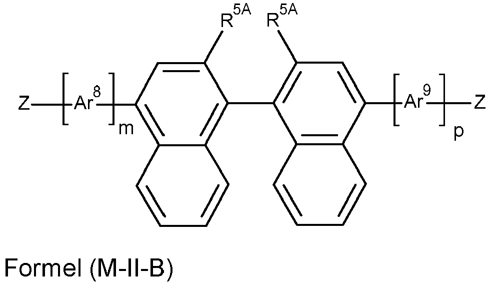 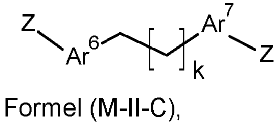 wobei die auftretenden Variablen wie oben definiert sind, und wobei Z bei jedem Auftreten gleich oder verschieden eine für eine Polymerisationsreaktion geeignete Abgangsgruppe darstellt. Bevorzugt ist Z bei jedem Auftreten gleich oder verschieden gewählt aus Halogenen, bevorzugt Chlor, Brom oder Iod, O-Tosylaten, O-Triflaten, O-Sulfonaten, Boronsäure, Borsäureestern, teilfluorierten Silylgruppen, Diazoniumgruppen und zinnorganischen Verbindungen. Besonders bevorzugt ist Z bei jedem Auftreten gleich oder verschieden gewählt aus Halogenen, bevorzugt Chlor, Brom oder Iod, Boronsäure und Boronsäureestern.

Zur Herstellung des erfindungsgemäßen Polymers wird jeweils mindestens ein Monomer gemäß Formel (M-I) und mindestens ein weiteres Monomer gewählt aus Monomeren der Formeln (M-II-A), (M-II-B) und (M-II-C) benötigt.

Eine Mischung enthaltend mindestens ein Monomer gemäß Formel (M-I) und mindestens ein weiteres Monomer gewählt aus Monomeren der Formeln (M-II-A), (M-II-B) und (M-II-C),
wobei die Summe der Anteile der Monomere der Formel (M-1) zwischen 20 und 50 Mol-% beträgt; und
wobei die Summe der Anteile der Monomere der Formeln (M-II-A), (M-II-B) und (M-II-C) zwischen 20 und 75 Mol-% beträgt, ist daher ebenfalls Gegenstand der vorliegenden Erfindung.

Die erfindungsgemäßen Polymere können als Reinsubstanz, aber auch als Mischung zusammen mit weiteren beliebigen polymeren, oligomeren, dendritischen oder niedermolekularen Substanzen verwendet werden. Als niedermolekulare Substanz versteht man in der vorliegenden Erfindung Verbindungen mit einem Molekulargewicht im Bereich von 100 bis 3000 g/mol, vorzugsweise 200 bis 2000 g/mol. Diese weiteren Substanzen können z.B. die elektronischen Eigenschaften verbessern oder selbst emittieren. Als Mischung wird vor- und nachstehend eine Mischung enthaltend mindestens eine polymere Komponente bezeichnet. Auf diese Art können eine oder mehrere Polymerschichten bestehend aus einer Mischung (Blend) aus einem oder mehreren erfindungsgemäßen Polymeren und optional einem oder mehreren weiteren Polymeren mit einer oder mehreren niedermolekularen Substanzen hergestellt werden.

Ein weiterer Gegenstand der vorliegenden Erfindung ist somit eine Mischung enthaltend ein oder mehrere erfindungsgemäße Polymere, sowie eine oder mehrere weitere polymere, oligomere, dendritische und/oder niedermolekulare Substanzen.

In einer möglichen Ausführungsform wird das Polymer mit einem p-dotierenden Salz gemischt in einer Schicht verwendet. Zur Auftragung dieser Schicht kann beispielsweise eine Lösung in Toluol verwendet werden, in der das Polymer und das p-dotierende Salz gelöst sind. Entsprechende p-dotierende Salze sind in WO 2016/107668, WO 2013/081052 und EP2325190 beschrieben.

Gegenstand der Erfindung sind weiterhin Lösungen und Formulierungen enthaltend ein oder mehrere erfindungsgemäße Polymeren sowie ein oder mehrere Lösungsmittel. Wie solche Lösungen hergestellt werden können, ist dem Fachmann bekannt und beispielsweise in der WO 2002/072714 A1, der WO 2003/019694 A2 und der darin zitierten Literatur beschrieben.

Diese Lösungen können verwendet werden, um dünne Polymerschichten herzustellen, zum Beispiel durch Flächenbeschichtungsverfahren (z.B. Spin-coating) oder durch Druckverfahren (z.B. InkJet Printing).

Polymere enthaltend Struktureinheiten, die eine vernetzbare Gruppe Q aufweisen, eignen sich besonders zur Herstellung von Filmen oder Beschichtungen, insbesondere zur Herstellung von strukturierten Beschichtungen, z.B. durch thermische oder lichtinduzierte in-situ-Polymerisation und in-situ-Vernetzung, wie beispielsweise in-situ-UV-Photopolymerisation oder Photopatterning. Dabei können sowohl entsprechende Polymere in Reinsubstanz verwendet werden, es können aber auch Formulierungen oder Mischungen dieser Polymere wie oben beschrieben verwendet werden. Diese können mit oder ohne Zusatz von Lösungsmitteln und/oder Bindemitteln verwendet werden. Geeignete Materialien, Verfahren und Vorrichtungen für die oben beschriebenen Methoden sind z.B. in der WO 2005/083812 A2 beschrieben. Mögliche Bindemittel sind beispielsweise Polystyrol, Polycarbonat, Poly(meth)-acrylate, Polyacrylate, Polyvinylbutyral und ähnliche, optoelektronisch neutrale Polymere.

Geeignete und bevorzugte Lösemittel sind beispielsweise Toluol, Anisol, o-, m- oder p-Xylol, Methylbenzoat, Mesitylen, Tetralin, Veratrol, THF, Methyl-THF, THP, Chlorbenzol, Dioxan, Phenoxytoluol, insbesondere 3-Phenoxytoluol, (-)-Fenchon, 1,2,3,5-Tetramethylbenzol, 1,2,4,5-Tetramethylbenzol, 1-Methylnaphthalin, 2-Methylbenzothiazol, 2-Phenoxyethanol, 2-Pyrrolidinon, 3-Methylanisol, 4-Methylanisol, 3,4-Dimethylanisol, 3,5-Dimethylanisol, Acetophenon, α-Terpineol, Benzothiazol, Butylbenzoat, Cumol, Cyclohexanol, Cyclohexanon, Cyclohexylbenzol, Decalin, Dodecylbenzol, Ethylbenzoat, Indan, Methylbenzoat, NMP, p-Cymol, Phenetol, 1,4-Diisopropylbenzol, Dibenzylether, Diethylenglycolbutylmethylether, Triethylenglycolbutylmethylether, Diethylenglycoldibutylether, Triethylenglycoldimethylether, Diethylenglycolmonobutylether, Tripropylenglycoldimethylether, Tetraethylenglycoldimethylether, 2-Isopropylnaphthalin, Pentylbenzol, Hexylbenzol, Heptylbenzol, Octylbenzol, 1,1-Bis(3,4-Dimethylphenyl)ethan oder Mischungen dieser Lösemittel.

Möglich ist die Verwendung eines Polymers, das Struktureinheiten enthält, die eine vernetzbare Gruppe Q aufweisen, zur Herstellung eines vernetzten Polymers. Die vernetzbare Gruppe, die besonders bevorzugt eine Vinylgruppe oder Alkenylgruppe ist, wird vorzugsweise durch die WITTIG-Reaktion oder eine WITTIG-analoge Reaktion in das Polymer eingebaut. Ist die vernetzbare Gruppe eine Vinylgruppe oder Alkenylgruppe, so kann die Vernetzung durch radikalische oder ionische Polymerisation stattfinden, wobei diese thermisch oder durch Strahlung induziert werden kann. Bevorzugt ist die radikalische Polymerisation, die thermisch induziert wird, vorzugsweise bei Temperaturen von weniger als 250°C, besonders bevorzugt bei Temperaturen von weniger als 200°C.

Wahlweise wird während des Vernetzungsverfahrens ein zusätzliches Styrol-Monomer zugesetzt, um einen höheren Grad der Vernetzung zu erzielen. Vorzugsweise ist der Anteil des zugesetzten Styrol-Monomers im Bereich von 0,01 bis 50 mol%, besonders bevorzugt 0,1 bis 30 mol%, bezogen auf 100 mol% aller copolymerisierten Monomere, die im Polymer als Struktureinheiten enthalten sind.

Ein Verfahren zur Herstellung eines vernetzten Polymers umfasst bevorzugt die folgenden Schritte:
(a) Bereitstellen von Polymeren, die Struktureinheiten enthalten, die eine oder mehrere vernetzbare Gruppen Q aufweisen; und
(b) Radikalische oder ionische Vernetzung, vorzugsweise radikalische Vernetzung, die sowohl thermisch als auch durch Strahlung, vorzugsweise thermisch, induziert werden kann.

Die durch dieses Verfahren hergestellten vernetzten Polymere sind in allen gängigen Lösungsmitteln unlöslich. Auf diese Weise lassen sich definierte Schichtdicken herstellen, die auch durch das Aufbringen nachfolgender Schichten nicht wieder gelöst bzw. angelöst werden.

Das vernetzte Polymer wird - wie vorstehend beschrieben - vorzugsweise in Form einer vernetzen Polymerschicht hergestellt. Auf die Oberfläche einer solchen vernetzten Polymerschicht kann aufgrund der Unlöslichkeit des vernetzten Polymers in sämtlichen Lösungsmitteln eine weitere Schicht aus einem Lösungsmittel mit den oben beschriebenen Techniken aufgebracht werden.

Die erfindungsgemäßen Polymere können in elektronischen oder optoelektronischen Vorrichtungen bzw. zu deren Herstellung verwendet werden.

Ein weiterer Gegenstand der vorliegenden Erfindung ist somit die Verwendung der erfindungsgemäßen Polymere in elektronischen oder optoelektronischen Vorrichtungen, vorzugsweise in organischen Elektrolumineszenzvorrichtungen (OLED), organischen Feld-Effekt-Transistoren (OFETs), organischen integrierten Schaltungen (O-ICs), organischen Dünnfilmtransistoren (TFTs), organischen Solarzellen (O-SCs), organischen Laserdioden (O-Laser), organischen photovoltaischen (OPV) Elementen oder Vorrichtungen oder organischen Photorezeptoren (OPCs), besonders bevorzugt in organischen Elektrolumineszenzvorrichtungen (OLED), sowie die oben genannten Vorrichtungen, enthaltend mindestens ein erfindungsgemäßes Polymer.

Besonders bevorzugt ist die Verwendung der erfindungsgemäßen Polymere in einer organischen Elektrolumineszenzvorrichtung (OLED), enthaltend Anode, Kathode und mindestens eine emittierende Schicht, dadurch gekennzeichnet, dass mindestens eine organische Schicht, die eine emittierende Schicht, eine lochtransportierende Schicht oder eine andere Schicht sein kann, mindestens ein erfindungsgemäßes Polymer enthält. Bevorzugt ist das Polymer dabei in einer lochtransportierenden Schicht enthalten.

Außer Kathode, Anode, emittierender Schicht und lochtransportierender Schicht kann die organische Elektrolumineszenzvorrichtung noch weitere Schichten enthalten. Diese sind beispielsweise gewählt aus jeweils einer oder mehreren Lochinjektionsschichten, Lochtransportschichten, Lochblockierschichten, Elektronentransportschichten, Elektroneninjektionsschichten, Elektronenblockierschichten, Excitonenblockierschichten, Zwischenschichten (Interlayers), Ladungserzeugungsschichten (Charge-Generation Layers) (IDMC 2003, Taiwan; Session 21 OLED (5), T. Matsumoto, T. Nakada, J. Endo, K. Mori, N. Kawamura, A. Yokoi, J. Kido, *Multiphoton Organic EL Device Having Charge Generation Layer*) und/oder organischen oder anorganischen p/n-Übergängen.

Die Abfolge der Schichten der organischen Elektrolumineszenzvorrichtung enthaltend das erfindungsgemäße Polymer ist bevorzugt die folgende: Anode-Lochinjektionsschicht-Lochtransportschicht-wahlweise weitere Lochtransportschicht(en)- emittierende Schicht-wahlweise Lochblockierschicht-Elektronentransportschicht-Kathode. Es können zusätzlich weitere Schichten in der OLED vorhanden sein.

Bevorzugte Ausführungsformen von OLEDs enthaltend das erfindungsgemäße Polymer sind Hybridvorrichtungen, in der eine oder mehrere Schichten, die aus Lösung prozessiert werden, und eine oder mehrere Schichten, die durch Aufdampfen von niedermolekularen Substanzen hergestellt werden, enthalten sind. Diese werden auch als kombinierte PLED/SMOLED (Polymeric Light Emitting Diode/Small Molecule Organic Light Emitting Diode) Systeme bezeichnet. Bevorzugt werden in der erfindungsgemäßen Vorrichtung die Schichten zwischen Anode und emittierender Schicht sowie die emittierende Schicht aus Lösung aufgebracht, und die Schichten zwischen emittierender Schicht und Kathode werden bevorzugt mit einem Sublimationsverfahren aufgebracht.

Wie OLEDs hergestellt werden können, ist dem Fachmann bekannt und wird beispielsweise als allgemeines Verfahren ausführlich in der WO 2004/070772 A2 beschrieben, das entsprechend für den Einzelfall anzupassen ist.

Die erfindungsgemäßen Polymere eigenen sich insbesondere zur Verwendung in einer lochtransportierenden Schicht einer OLED. Unter einer lochtransportierenden Schicht wird dabei insbesondere eine Schicht verstanden, welche anodenseitig an die emittierende Schicht angrenzt. Besonders bevorzugt ist die Verwendung der erfindungsgemäßen Polymere in einer lochtransportierenden Schicht einer OLED, welche eine blau emittierende Schicht enthält, die aus Lösung aufgebracht wurde. Hierdurch werden OLEDs mit einer hohen Effizienz und Lebensdauer erhalten.

Die erfindungsgemäßen Polymere können jedoch auch in einer Lochinjektionsschicht (HIL), einer Elektronenblockierschicht (EBL), und in einer emittierenden Schicht verwendet werden. Wenn die Polymere in einer emittierenden Schicht verwendet werden, ist dies bevorzugt in der Funktion als Matrixmaterial, insbesondere in der Funktion als lochtransportierendes und/oder als wide bandgap-Matrixmaterial. Unter einer Lochinjektionsschicht wird insbesondere eine Schicht verstanden, die unmittelbar an die Anode angrenzt und die zwischen der Anode und einer Lochtransportschicht angeordnet ist. Unter einer Elektronenblockierschicht wird insbesondere eine Schicht verstanden, die anodenseitig direkt an die emittierende Schicht angrenzt, und die zwischen der emittierenden Schicht und einer Lochtransportschicht angeordnet ist.

Im Folgenden werden bevorzugte Ausführungsformen für die unterschiedlichen Funktionsmaterialien der elektronischen Vorrichtung aufgeführt.

Bevorzugte fluoreszierende emittierende Verbindungen sind ausgewählt aus der Klasse der Arylamine. Unter einem Arylamin bzw. einem aromatischen Amin im Sinne dieser Erfindung wird eine Verbindung verstanden, die drei substituierte oder unsubstituierte aromatische oder heteroaromatische Ringsysteme direkt an den Stickstoff gebunden enthält. Bevorzugt ist mindestens eines dieser aromatischen oder heteroaromatischen Ringsysteme ein kondensiertes Ringsystem, besonders bevorzugt mit mindestens 14 aromatischen Ringatomen. Bevorzugte Beispiele hierfür sind aromatische Anthracenamine, aromatische Anthracendiamine, aromatische Pyrenamine, aromatische Pyrendiamine, aromatische Chrysenamine oder aromatische Chrysendiamine. Unter einem aromatischen Anthracenamin wird eine Verbindung verstanden, in der eine Diarylaminogruppe direkt an eine Anthracengruppe gebunden ist, vorzugsweise in 9-Position. Unter einem aromatischen Anthracendiamin wird eine Verbindung verstanden, in der zwei Diarylaminogruppen direkt an eine Anthracengruppe gebunden sind, vorzugsweise in 9,10-Position. Aromatische Pyrenamine, Pyrendiamine, Chrysenamine und Chrysendiamine sind analog dazu definiert, wobei die Diarylaminogruppen am Pyren bevorzugt in 1-Position bzw. in 1,6-Position gebunden sind. Weitere bevorzugte emittierende Verbindungen sind Indenofluorenamine bzw. - diamine, beispielsweise gemäß WO 2006/108497 oder WO 2006/122630, Benzoindenofluorenamine bzw. -diamine, beispielsweise gemäß WO 2008/006449, und Dibenzoindenofluorenamine bzw. -diamine, beispielsweise gemäß WO 2007/140847, sowie die in WO 2010/012328 offenbarten Indenofluorenderivate mit kondensierten Arylgruppen.

Ebenfalls bevorzugt sind die in WO 2012/048780 und die in WO 2013/185871 offenbarten Pyren-Arylamine. Ebenfalls bevorzugt sind die in WO 2014/037077 offenbarten Benzoindenofluoren-Amine, die in WO 2014/106522 offenbarten Benzofluoren-Amine, die in WO 2014/111269 und in WO 2017/036574 offenbarten erweiterten Benzoindenofluorene, die in WO 2017/028940 und WO 2017/028941 offenbarten Phenoxazine, und die in WO 2016/150544 offenbarten Fluoren-Derivate, die mit Furan-Einheiten oder mit Thiophen-Einheiten verbunden sind.

Besonders bevorzugt sind die in der WO 2014/111269 offenbarten erweiterten Benzoindenofluorene zur Verwendung als fluoreszierende Emitter in der emittierenden Schicht.

Bevorzugte fluoreszierende Emitter, zur Verwendung in der emittierenden Schicht von Vorrichtungen enthaltend die erfindungsgemäßen Polymere, sind im Folgenden gezeigt:

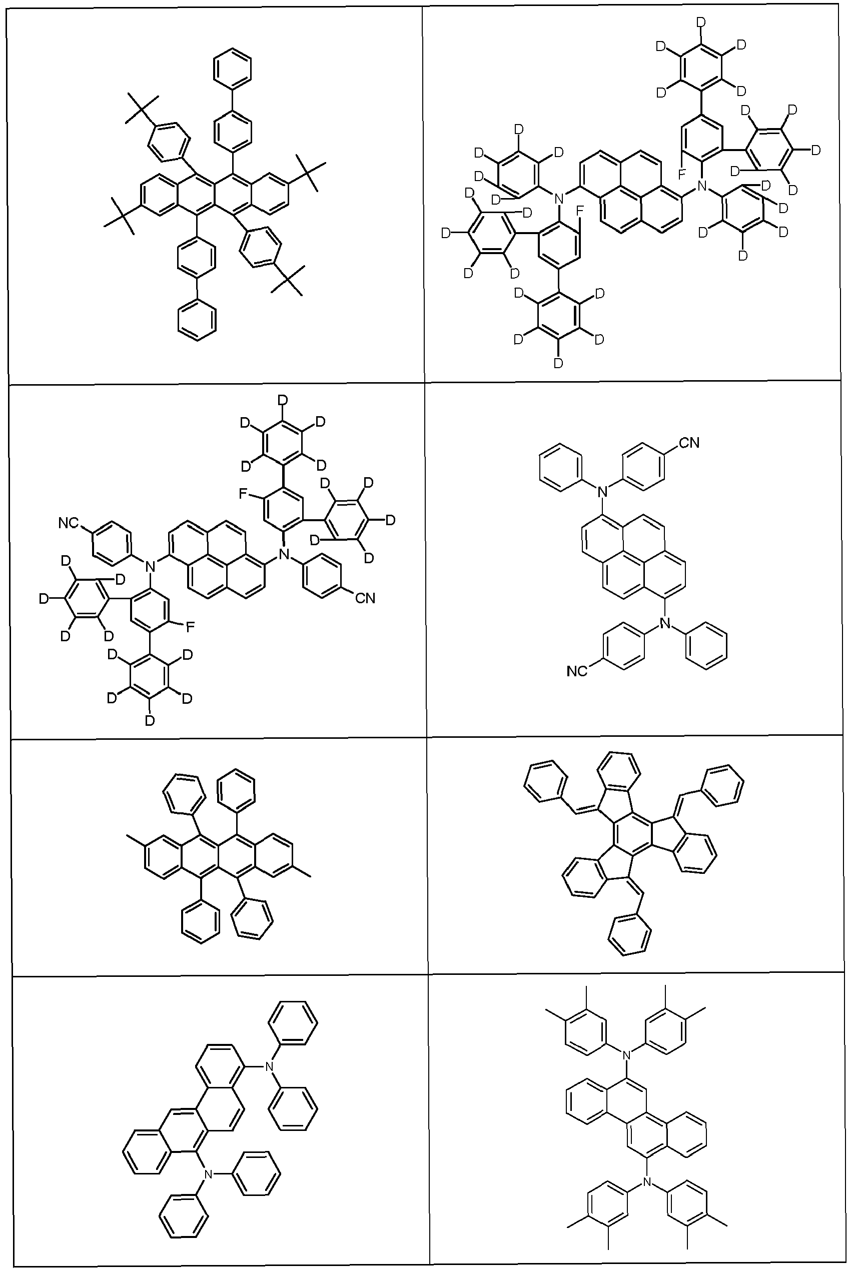

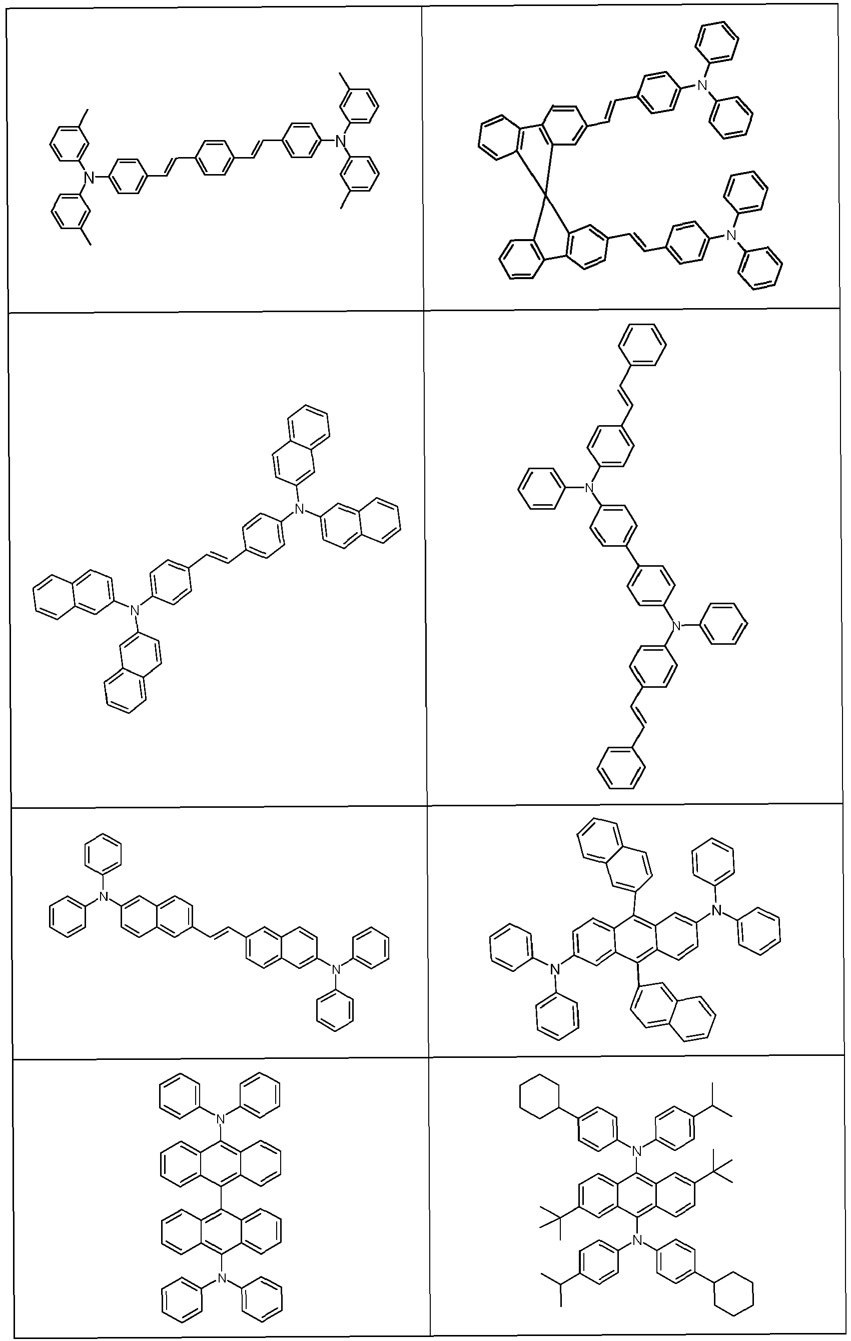

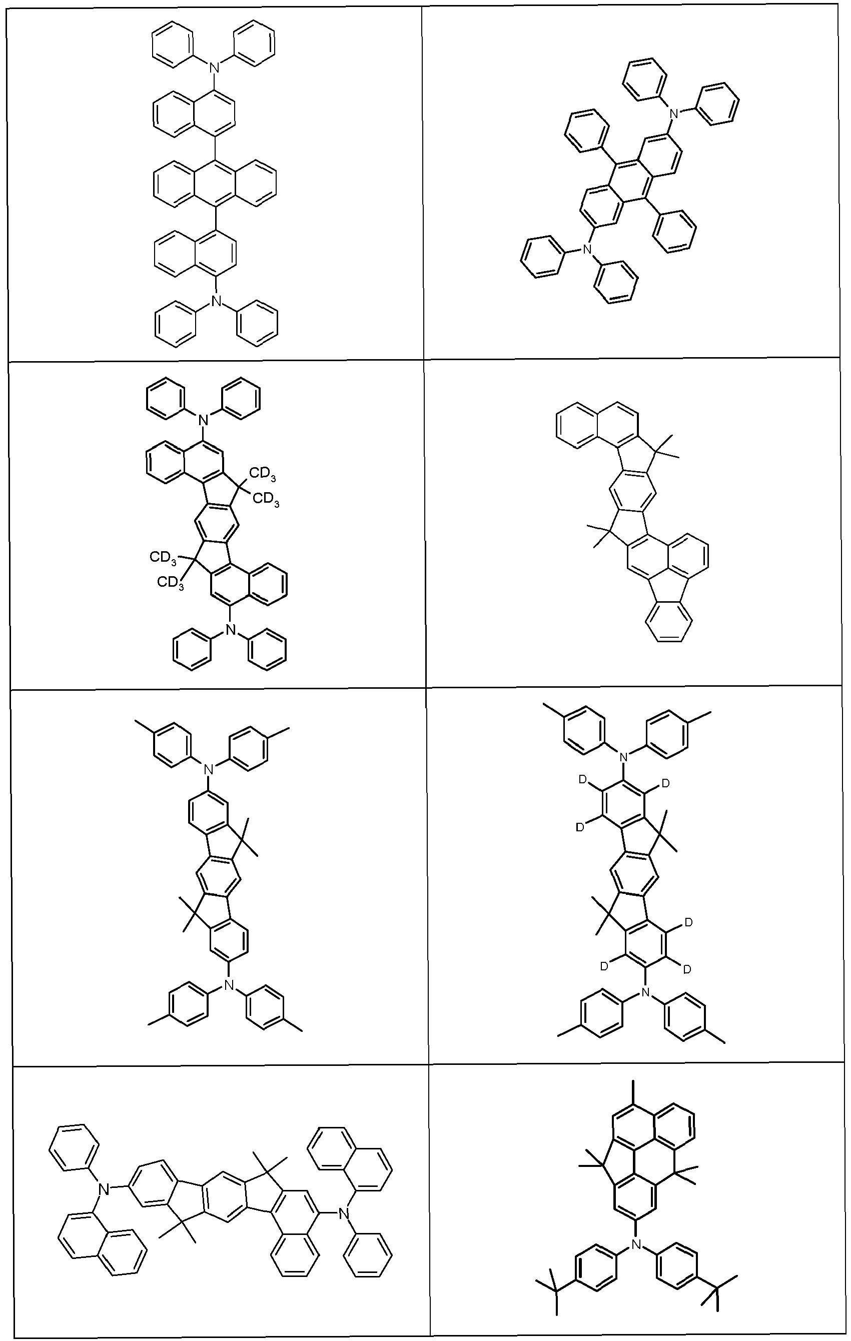

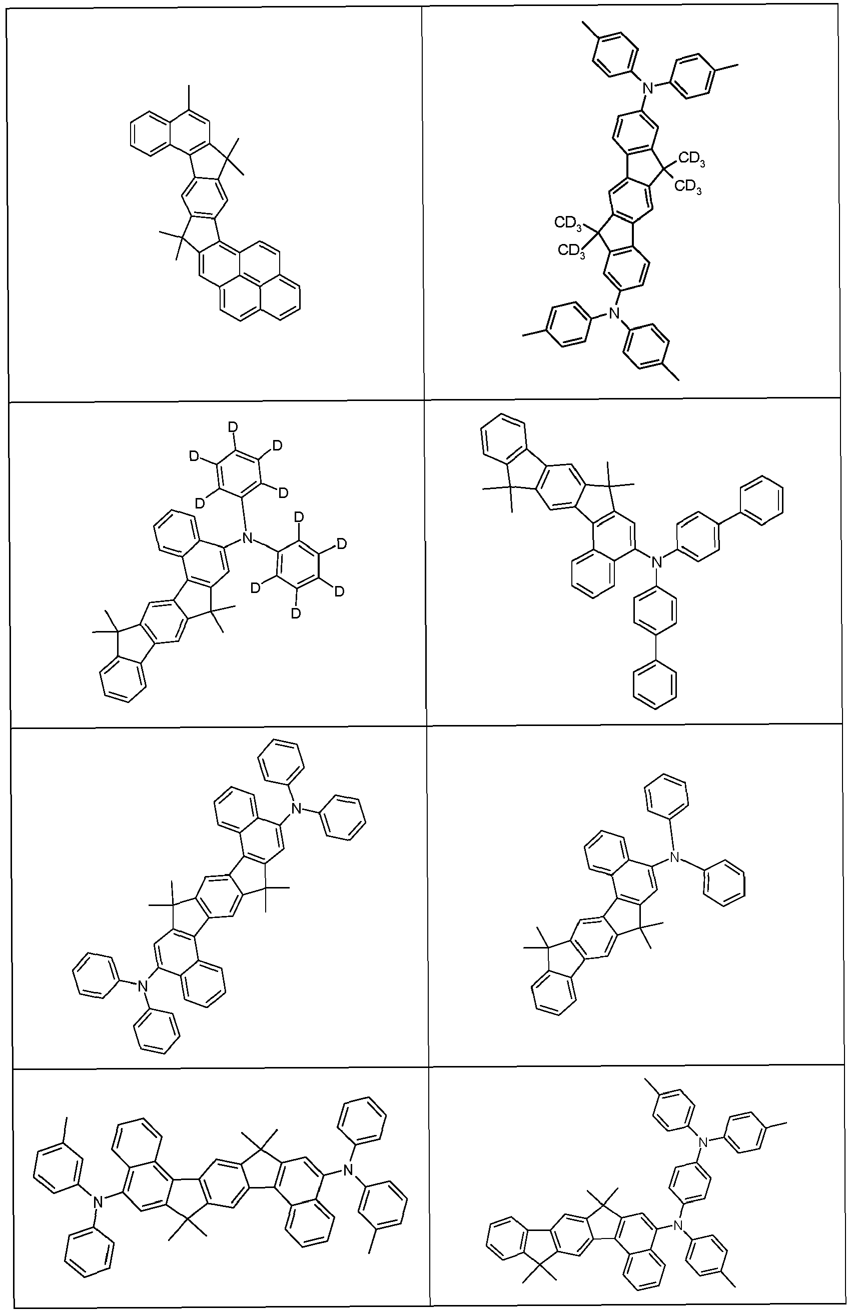

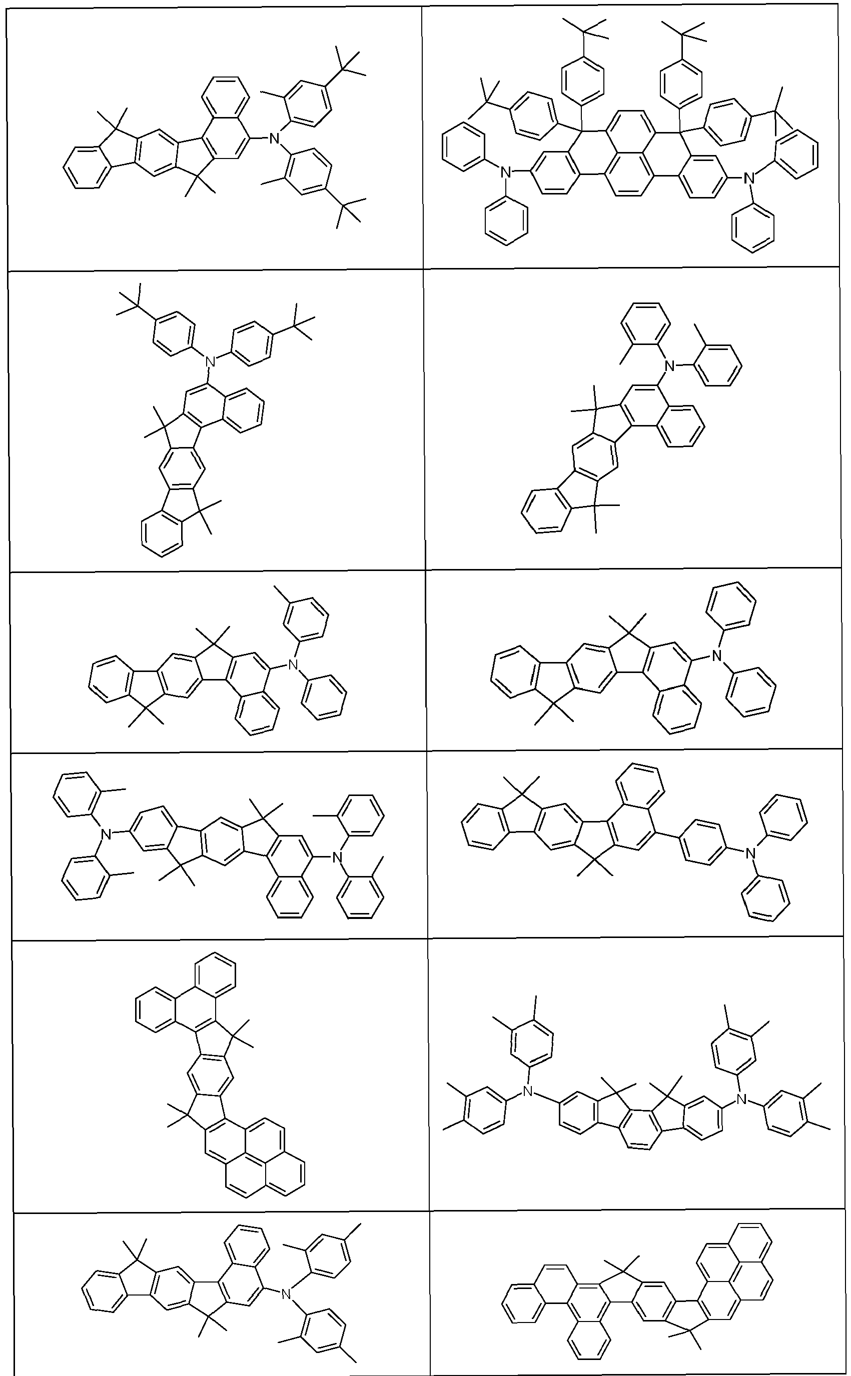

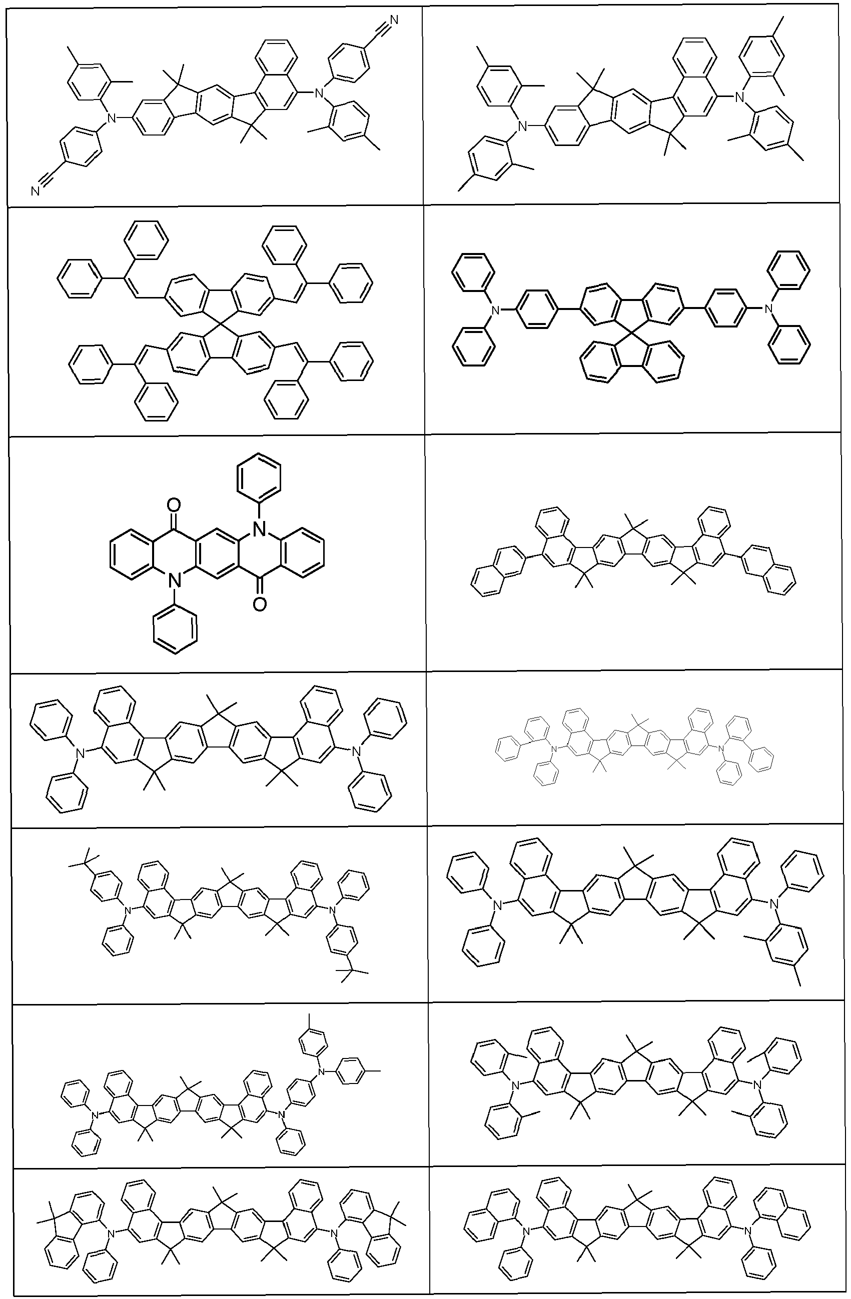

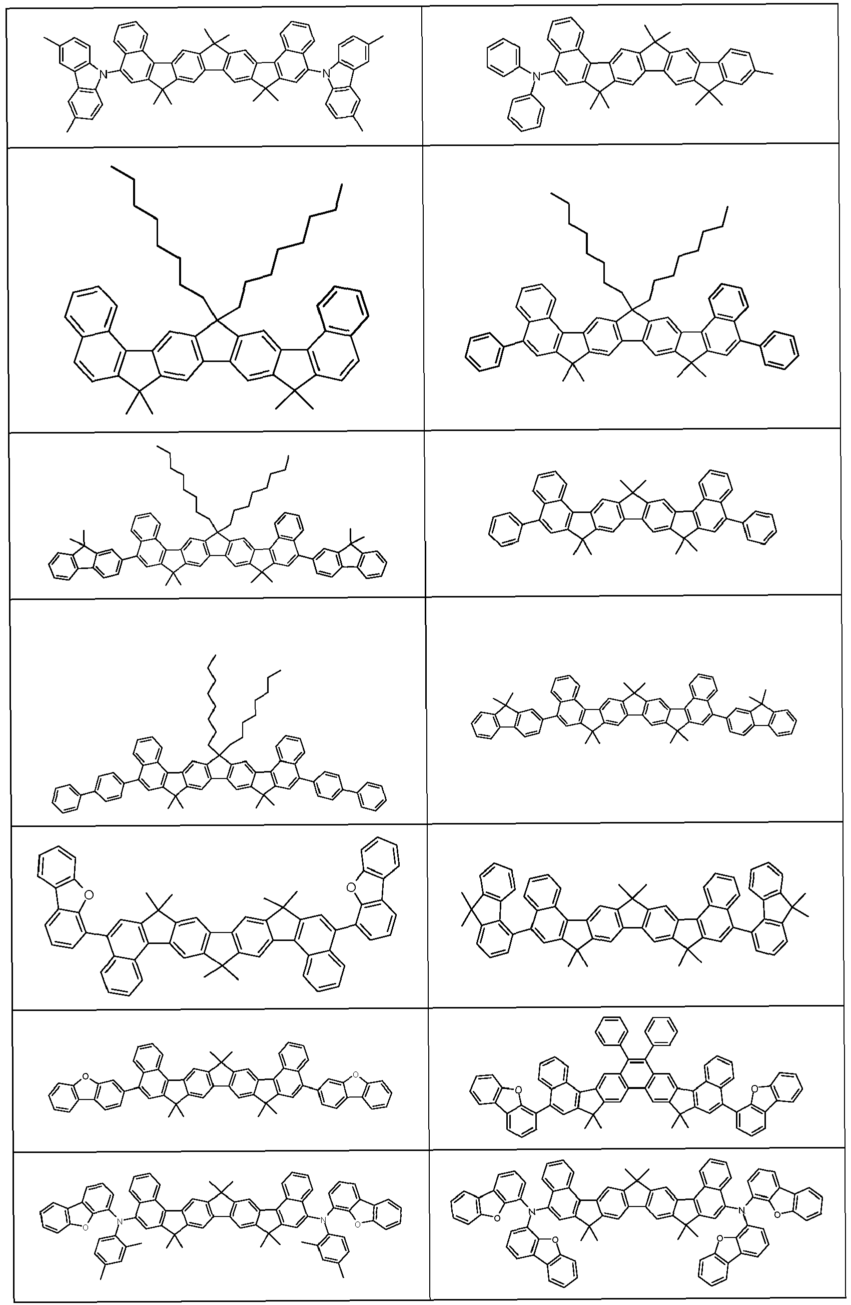

Als Matrixmaterialien, bevorzugt für fluoreszierende emittierende Verbindungen, kommen Materialien verschiedener Stoffklassen in Frage.

Bevorzugte Matrixmaterialien sind ausgewählt aus den Klassen der Oligoarylene (z. B. 2,2',7,7'-Tetraphenylspirobifluoren gemäß EP 676461 oder Dinaphthylanthracen), insbesondere der Oligoarylene enthaltend kondensierte aromatische Gruppen, der Oligoarylenvinylene (z. B. DPVBi oder Spiro-DPVBi gemäß EP 676461), der polypodalen Metallkomplexe (z. B. gemäß WO 2004/081017), der lochleitenden Verbindungen (z. B. gemäß WO 2004/058911), der elektronenleitenden Verbindungen, insbesondere Ketone, Phosphinoxide, Sulfoxide, etc. (z. B. gemäß WO 2005/084081 und WO 2005/084082), der Atropisomere (z. B. gemäß WO 2006/048268), der Boronsäurederivate (z. B. gemäß WO 2006/117052) oder der Benzanthracene (z. B. gemäß WO 2008/145239). Besonders bevorzugte Matrixmaterialien sind ausgewählt aus den Klassen der Oligoarylene, enthaltend Naphthalin, Anthracen, Benzanthracen und/oder Pyren oder Atropisomere dieser Verbindungen, der Oligoarylenvinylene, der Ketone, der Phosphinoxide und der Sulfoxide. Ganz besonders bevorzugte Matrixmaterialien sind ausgewählt aus den Klassen der Oligoarylene, enthaltend Anthracen, Benzanthracen, Benzphenanthren und/oder Pyren oder Atropisomere dieser Verbindungen. Unter einem Oligoarylen im Sinne dieser Erfindung soll eine Verbindung verstanden werden, in der mindestens drei Aryl- bzw. Arylengruppen aneinander gebunden sind. Bevorzugt sind weiterhin die in WO 2006/097208, WO 2006/131192, WO 2007/065550, WO 2007/110129, WO 2007/065678, WO 2008/145239, WO 2009/100925, WO 2011/054442, und EP 1553154 offenbarten Anthracenderivate, die in EP 1749809, EP 1905754 und US 2012/0187826 offenbarten Pyren-Verbindungen, die in WO 2015/158409 offenbarten Benzanthracenyl-Anthracen-Verbindungen, die in WO 2017/025165 offenbarten Indeno-Benzofurane, und die in WO 2017/036573 offenbarten Phenanthryl-Anthracene.

Bevorzugte Matrixmaterialien für fluoreszierende Emitter, zur Verwendung in der emittierenden Schicht von Vorrichtungen enthaltend die erfindungsgemäßen Polymere, sind im Folgenden gezeigt:

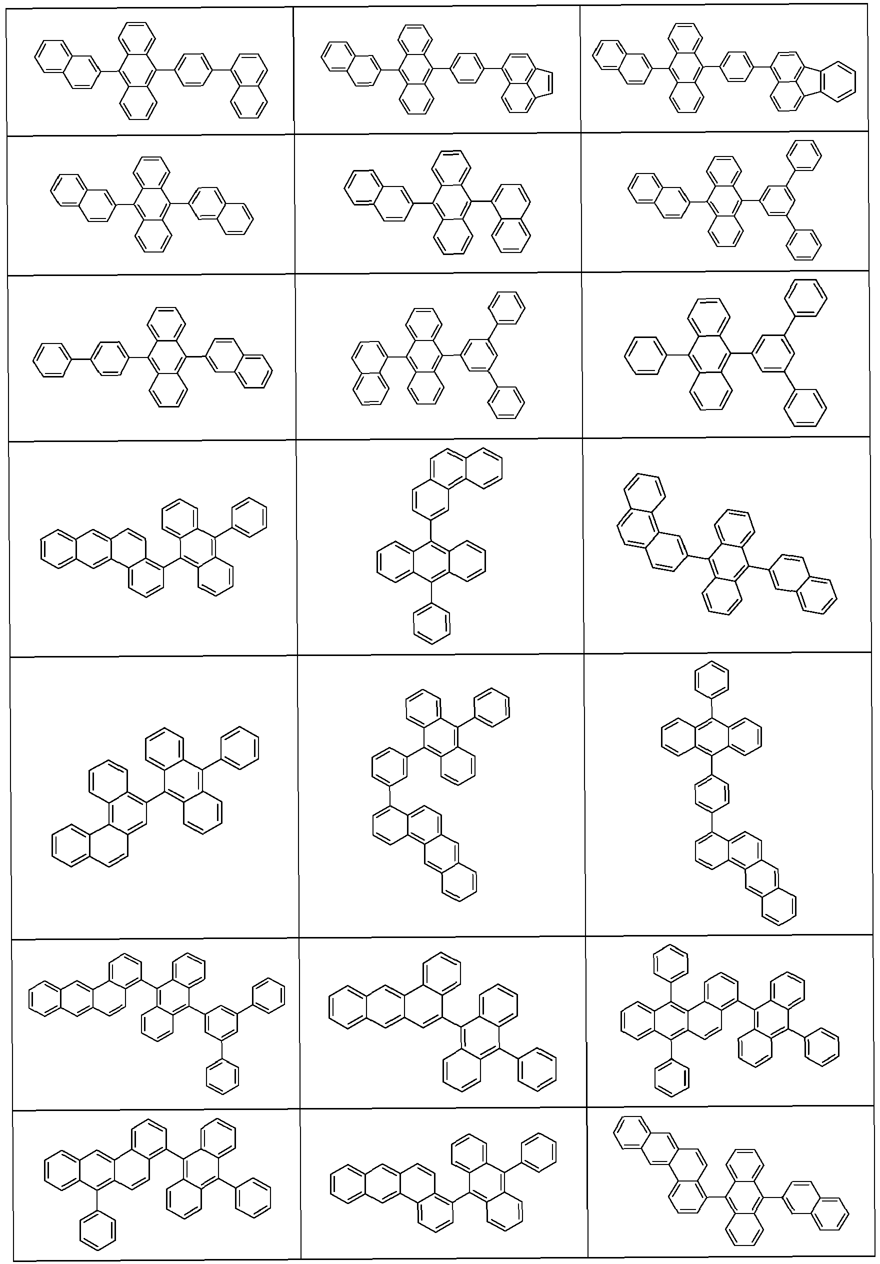

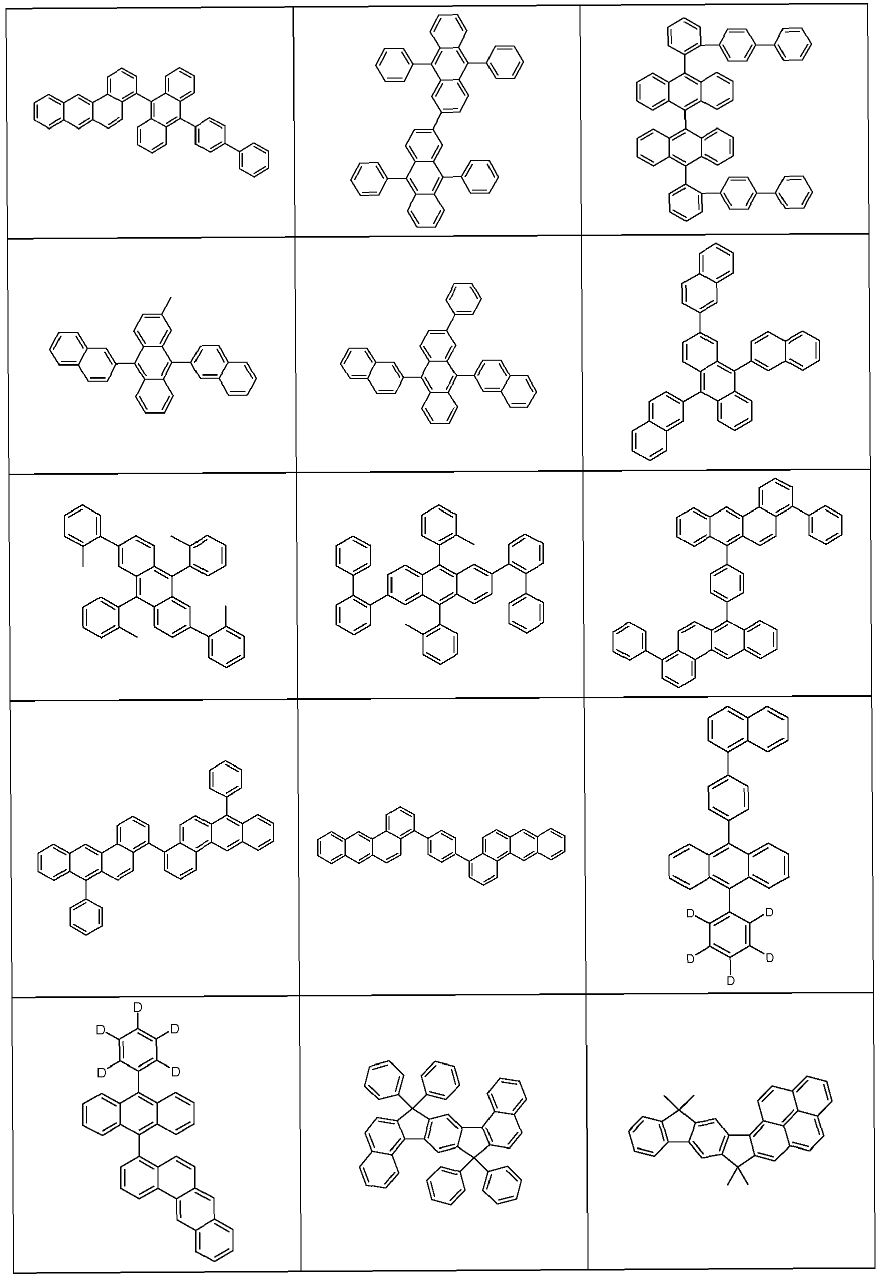

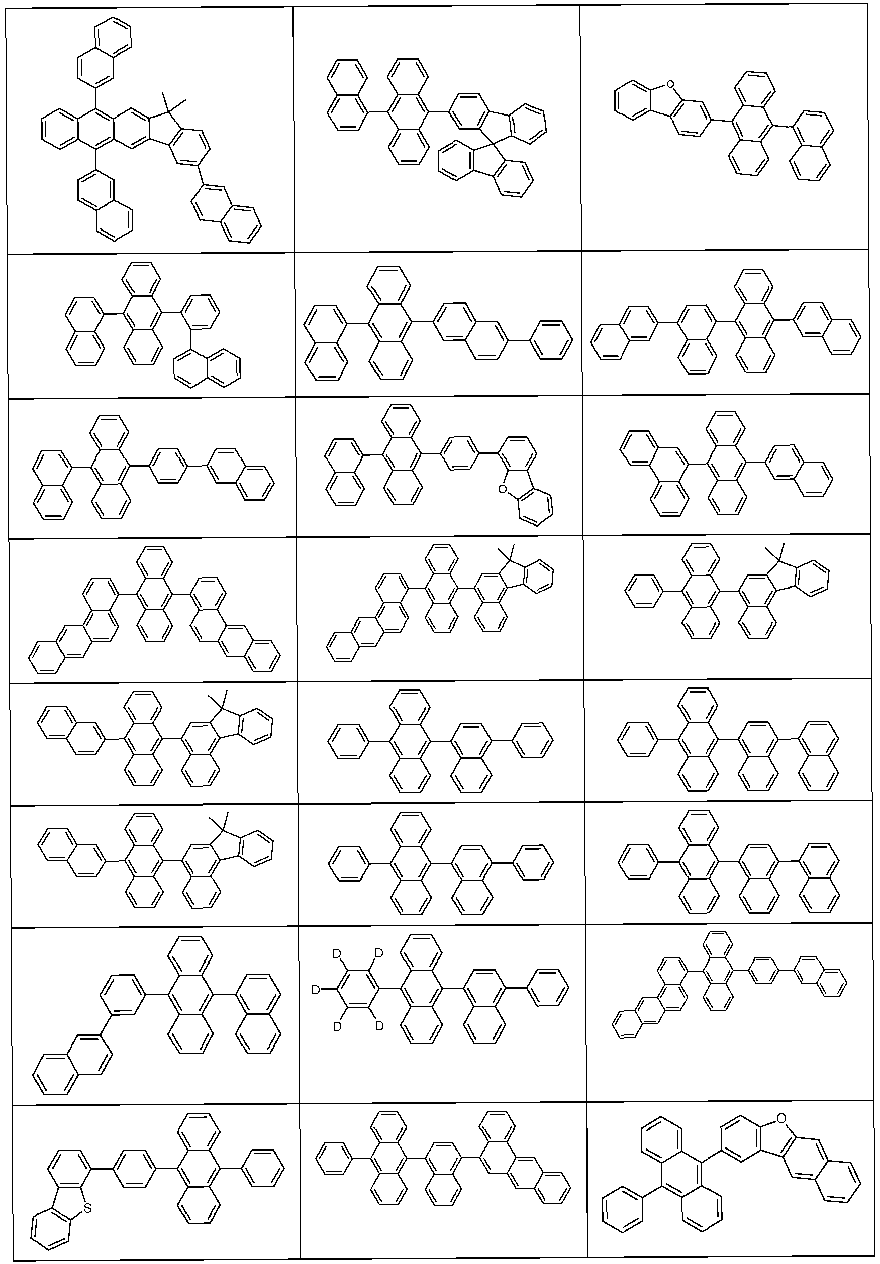

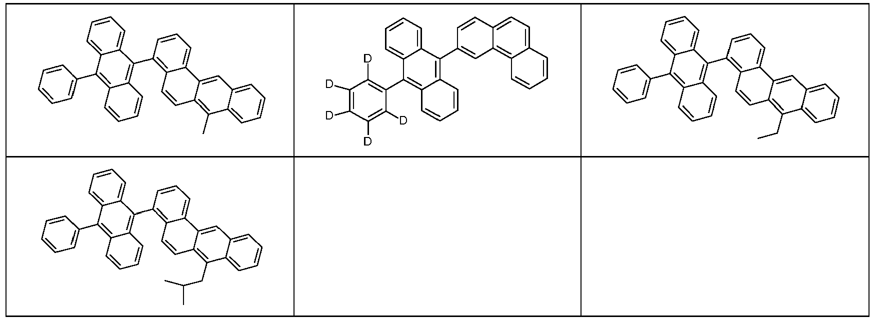

Als phosphoreszierende emittierende Verbindungen (= Triplettemitter) eignen sich insbesondere Verbindungen, die bei geeigneter Anregung Licht, vorzugsweise im sichtbaren Bereich, emittieren und außerdem mindestens ein Atom der Ordnungszahl größer 20, bevorzugt größer 38 und kleiner 84, besonders bevorzugt größer 56 und kleiner 80 enthalten. Bevorzugt werden als phosphoreszierende emittierende Verbindungen Verbindungen, die Kupfer, Molybdän, Wolfram, Rhenium, Ruthenium, Osmium, Rhodium, Iridium, Palladium, Platin, Silber, Gold oder Europium enthalten, verwendet, insbesondere Verbindungen, die Iridium, Platin oder Kupfer enthalten. Dabei werden im Sinne der vorliegenden Erfindung alle lumineszierenden Iridium-, Platin- oder Kupferkomplexe als phosphoreszierende emittierende Verbindungen angesehen.

Beispiele für die oben beschriebenen emittierenden Verbindungen können den Anmeldungen WO 00/70655, WO 01/41512, WO 02/02714, WO 02/15645, EP 1191613, EP 1191612, EP 1191614, WO 05/033244, WO 05/019373 und US 2005/0258742 entnommen werden. Generell eignen sich alle phosphoreszierenden Komplexe, wie sie gemäß dem Stand der Technik für phosphoreszierende OLEDs verwendet werden und wie sie dem Fachmann auf dem Gebiet der organischen Elektrolumineszenzvorrichtungen bekannt sind.

Bevorzugte Matrixmaterialien für phosphoreszierende emittierende Verbindungen sind aromatische Ketone, aromatische Phosphinoxide oder aromatische Sulfoxide oder Sulfone, z. B. gemäß WO 2004/013080, WO 2004/093207, WO 2006/005627 oder WO 2010/006680, Triarylamine, Carbazolderivate, z. B. CBP (N,N-Biscarbazolylbiphenyl) oder die in WO 2005/039246, US 2005/0069729, JP 2004/288381, EP 1205527 oder WO 2008/086851 offenbarten Carbazolderivate, Indolocarbazolderivate, z. B. gemäß WO 2007/063754 oder WO 2008/056746, Indenocarbazolderivate, z. B. gemäß WO 2010/136109, WO 2011/000455 oder WO 2013/041176, Azacarbazolderivate, z. B. gemäß EP 1617710, EP 1617711, EP 1731584, JP 2005/347160, bipolare Matrixmaterialien, z. B. gemäß WO 2007/137725, Silane, z. B. gemäß WO 2005/111172, Azaborole oder Boronester, z. B. gemäß WO 2006/117052, Triazinderivate, z. B. gemäß WO 2010/015306, WO 2007/063754 oder WO 2008/056746, Zinkkomplexe, z. B. gemäß EP 652273 oder WO 2009/062578, Diazasilol- bzw. Tetraazasilol-Derivate, z. B. gemäß WO 2010/054729, Diazaphosphol-Derivate, z. B. gemäß WO 2010/054730, überbrückte Carbazol-Derivate, z. B. gemäß US 2009/0136779, WO 2010/050778, WO 2011/042107, WO 2011/088877 oder WO 2012/143080, Triphenylenderivaten, z. B. gemäß WO 2012/048781, oder Lactame, z. B. gemäß WO 2011/116865 oder WO 2011/137951.

Geeignete Ladungstransportmaterialien, wie sie in der Lochinjektions- bzw. Lochtransportschicht bzw. Elektronenblockierschicht oder in der Elektronentransportschicht der erfindungsgemäßen elektronischen Vorrichtung verwendet werden können, sind neben den erfindungsgemäßen Polymeren beispielsweise die in Y. Shirota et al., Chem. Rev. 2007, 107(4), 953-1010 offenbarten Verbindungen oder andere Materialien, wie sie gemäß dem Stand der Technik in diesen Schichten eingesetzt werden.

Als Materialien für die Elektronentransportschicht können neben den erfindungsgemäßen Verbindungen alle Materialien verwendet werden, wie sie gemäß dem Stand der Technik als Elektronentransportmaterialien in der Elektronentransportschicht verwendet werden. Insbesondere eignen sich Aluminiumkomplexe, beispielsweise Alq₃, Zirkoniumkomplexe, beispielsweise Zrq₄, Lithiumkomplexe, beispielsweise Liq, Benzimidazolderivate, Triazinderivate, Pyrimidinderivate, Pyridinderivate, Pyrazinderivate, Chinoxalinderivate, Chinolinderivate, Oxadiazolderivate, aromatische Ketone, Lactame, Borane, Diazaphospholderivate und Phosphinoxidderivate. Weiterhin geeignete Materialien sind Derivate der oben genannten Verbindungen, wie sie in JP 2000/053957, WO 2003/060956, WO 2004/028217, WO 2004/080975 und WO 2010/072300 offenbart werden.

Als Kathode der elektronischen Vorrichtung sind Metalle mit geringer Austrittsarbeit, Metalllegierungen oder mehrlagige Strukturen aus verschiedenen Metallen bevorzugt, wie beispielsweise Erdalkalimetalle, Alkalimetalle, Hauptgruppenmetalle oder Lanthanoide (z. B. Ca, Ba, Mg, Al, In, Mg, Yb, Sm, etc.). Weiterhin eignen sich Legierungen aus einem Alkali- oder Erdalkalimetall und Silber, beispielsweise eine Legierung aus Magnesium und Silber. Bei mehrlagigen Strukturen können auch zusätzlich zu den genannten Metallen weitere Metalle verwendet werden, die eine relativ hohe Austrittsarbeit aufweisen, wie z. B. Ag oder Al, wobei dann in der Regel Kombinationen der Metalle, wie beispielsweise Ca/Ag, Mg/Ag oder Ba/Ag verwendet werden. Es kann auch bevorzugt sein, zwischen einer metallischen Kathode und dem organischen Halbleiter eine dünne Zwischenschicht eines Materials mit einer hohen Dielektrizitätskonstante einzubringen. Hierfür kommen beispielsweise Alkalimetall- oder Erdalkalimetallfluoride, aber auch die entsprechenden Oxide oder Carbonate in Frage (z. B. LiF, Li₂O, BaF₂, MgO, NaF, CsF, Cs₂CO₃, etc.). Weiterhin kann dafür Lithiumchinolinat (LiQ) verwendet werden. Die Schichtdicke dieser Schicht beträgt bevorzugt zwischen 0.5 und 5 nm.

Als Anode sind Materialien mit hoher Austrittsarbeit bevorzugt. Bevorzugt weist die Anode eine Austrittsarbeit größer 4.5 eV vs. Vakuum auf. Hierfür sind einerseits Metalle mit hohem Redoxpotential geeignet, wie beispielsweise Ag, Pt oder Au. Es können andererseits auch Metall/Metalloxid-Elektroden (z. B. Al/Ni/NiOₓ, Al/PtOₓ) bevorzugt sein. Für einige Anwendungen muss mindestens eine der Elektroden transparent oder teiltransparent sein, um entweder die Bestrahlung des organischen Materials (organische Solarzelle) oder die Auskopplung von Licht (OLED, O-LASER) zu ermöglichen. Bevorzugte Anodenmaterialien sind hier leitfähige gemischte Metalloxide. Besonders bevorzugt sind Indium-ZinnOxid (ITO) oder Indium-Zink Oxid (IZO). Bevorzugt sind weiterhin leitfähige, dotierte organische Materialien, insbesondere leitfähige dotierte Polymere. Weiterhin kann die Anode auch aus mehreren Schichten bestehen, beispielsweise aus einer inneren Schicht aus ITO und einer äußeren Schicht aus einem Metalloxid, bevorzugt Wolframoxid, Molybdänoxid oder Vanadiumoxid.

Die Vorrichtung wird entsprechend (je nach Anwendung) strukturiert, kontaktiert und schließlich versiegelt, um schädigende Effekte von Wasser und Luft auszuschließen.

In einer bevorzugten Ausführungsform ist die elektronische Vorrichtung dadurch gekennzeichnet, dass eine oder mehrere Schichten mit einem Sublimationsverfahren beschichtet werden. Dabei werden die Materialien in Vakuum-Sublimationsanlagen bei einem Anfangsdruck kleiner 10⁻⁵ mbar, bevorzugt kleiner 10⁻⁶ mbar aufgedampft. Dabei ist es jedoch auch möglich, dass der Anfangsdruck noch geringer ist, beispielsweise kleiner 10⁻⁷ mbar.

Bevorzugt ist ebenfalls eine elektronische Vorrichtung, dadurch gekennzeichnet, dass eine oder mehrere Schichten mit dem OVPD (Organic Vapour Phase Deposition) Verfahren oder mit Hilfe einer Trägergassublimation beschichtet werden. Dabei werden die Materialien bei einem Druck zwischen 10⁻⁵ mbar und 1 bar aufgebracht. Ein Spezialfall dieses Verfahrens ist das OVJP (Organic Vapour Jet Printing) Verfahren, bei dem die Materialien direkt durch eine Düse aufgebracht und so strukturiert werden (z. B. M. S. Arnold et al., Appl. Phys. Lett. 2008, 92, 053301).

Weiterhin bevorzugt ist eine elektronische Vorrichtung, dadurch gekennzeichnet, dass eine oder mehrere Schichten aus Lösung, wie z. B. durch Spincoating, oder mit einem beliebigen Druckverfahren, wie z. B. Siebdruck, Flexodruck, Nozzle Printing oder Offsetdruck, besonders bevorzugt aber LITI (Light Induced Thermal Imaging, Thermotransferdruck) oder Ink-Jet Druck (Tintenstrahldruck), hergestellt werden.

Erfindungsgemäß können die elektronischen Vorrichtungen enthaltend ein oder mehrere erfindungsgemäße Polymere in Displays, als Lichtquellen in Beleuchtungsanwendungen sowie als Lichtquellen in medizinischen und/oder kosmetischen Anwendungen (z.B. Lichttherapie) eingesetzt werden.

### Beispiele

### A) Synthesebeispiele

### Verwendete Monomere:

| Monomer | Struktur | Synthese nach Offenlegungsschrift / CAS-Nummer |
|---|---|---|
| **Ortho-substituierte Amine** | | |
| MON-1-Br | 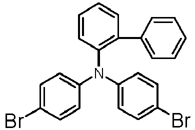 | WO 2013/156130 |
| MON-1-BE | 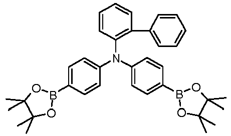 | WO 2013/156130 |
| MON-2-Br | 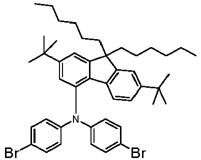 | WO 2013/156130 |
| MON-2-BE | 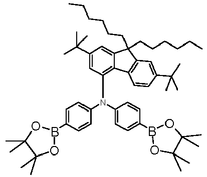 | Borylierung analog Vorschrift WO 2013/156130 |
| MON-3-Br | 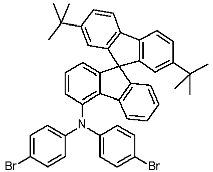 | WO 2013/156130 |
| MON-4-Br | 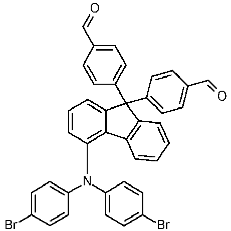 | WO 2013/156130 |
| MON-5-Br | 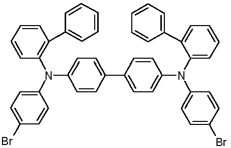 | WO 2013/156129 |
| MON-6-BE | 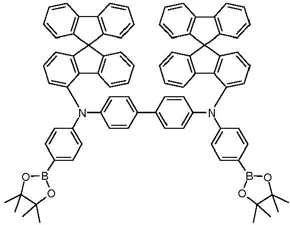 | WO 2013/156129 |
| MON-7-Br | 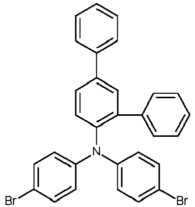 | CAS 2043618-74-0 |
| MON-8-Br | 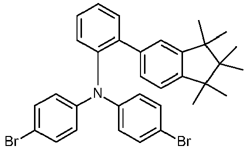 | Synthese gemäß EP17177211.4 |
| MON-8-BE | 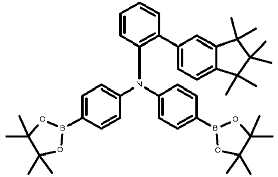 | Synthese gemäß EP17177211.4 |

| **Konjugationsunterbrecher** | | |
|---|---|---|
| MON-20-Br | 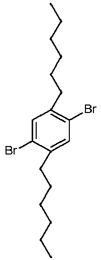 | CAS 117635-21-9 |
| MON-20-BE | 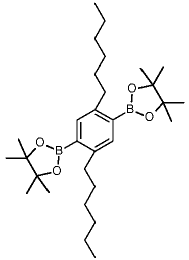 | CAS 374934-77-7 |
| MON-21-Br | 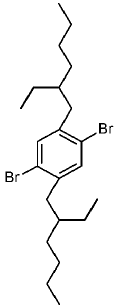 | CAS 255710-07-7 |
| MON-22-BE | 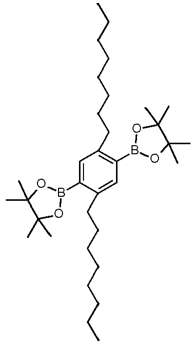 | CAS 897404-05-6 |
| MON-23-Br | 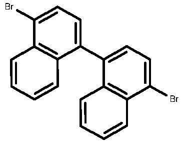 | CAS 49610-35-7 |
| MON-24-BE | 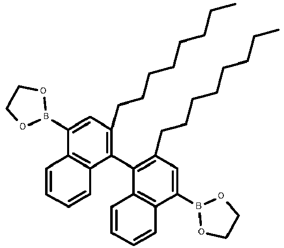 | WO 2006/063852 |
| MON-25-Br | 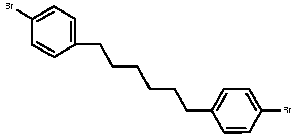 | 101783-96-4 |
| MON-26-Br | 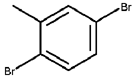 | CAS 615-59-8 |

| **Vernetzer** | | |
|---|---|---|
| MON-30-Br | 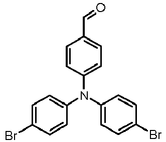 | WO 2010/097155 |
| MON-30-BE | 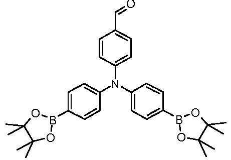 | WO 2010/097155 |
| MON-31-Br | 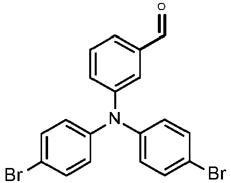 | WO 2013/156130 |
| MON-31-BE | 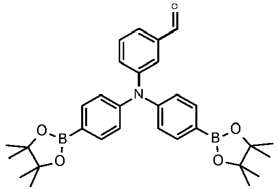 | WO 2013/156130 |
| MON-32-Br | 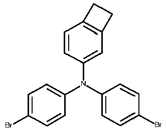 | WO 2009/102027 |
| MON-32-BE | 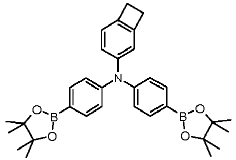 | WO 2009/102027 |
| MON-33-Br | 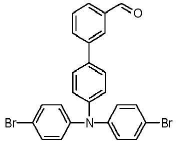 | Synthese siehe unten |
| MON-33-BE | 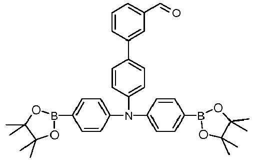 | Borylierung analog Vorschrift WO 2013/156130 |
| MON-34-Br | 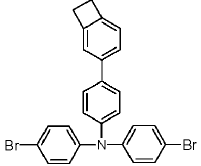 | Synthese siehe unten |
| MON-34-BE | 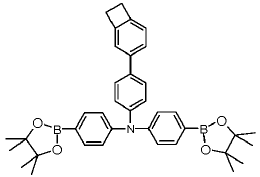 | Borylierung analog Vorschrift WO 2013/156130 |
| MON-35-Br | 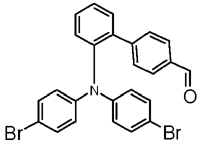 | Synthese siehe unten |
| MON-35-BE | 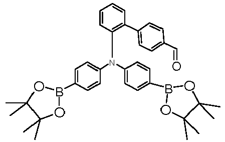 | Borylierung analog Vorschrift WO 2013/156130 |
| MON-36-BE | 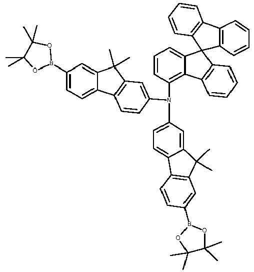 | Synthese siehe unten |

| **Weitere Monomere, zur Herstellung der Vergleichspolymere** | | |
|---|---|---|
| Mon-101-BE | 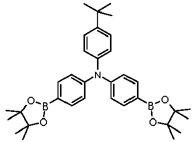 | WO 99/048160 A1 |
| Mon-102-Br | 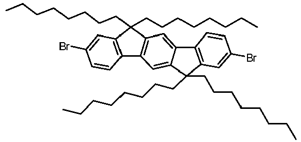 | Macromolecules 2000, 33, 2016-2020 |
| Mon-103-Br | 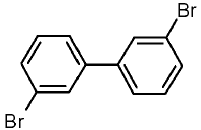 | CAS 16400-51-4 |

### Synthese der Monomere

### Synthese MON-33-Br (und analog MON-034-Br)

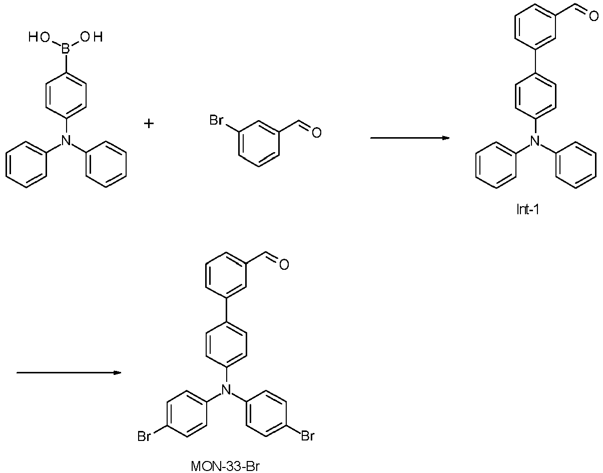

3-Bromobenzaldehyd (75 g, 405 mmol), 4-(diphenylamino)-phenylboronsäure (141 g, 486 mmol) und Cäsiumcarbonat (291 g, 892 mmol) werden in 540 ml Ethylenglycoldimethylethere, 430 ml Toluol und 540 ml Wasser vorgelegt. Nach 30 minütigem Entgasen wird Tetrakis(triphenylphospin)palladium (11.7 g, 10.1 mmol) zugegeben. Die Reaktion wird auf Rückfluss über Nacht erhitzt. Nach Beendigung der Reaktion wird auf Raumtemperatur abgekühlt und mit N-Acetylcysteinlöung gequencht. Anschließend wird über Kieselgel filtriert, die organische Phase abgetrennt und die wässrige Phase mit Toluol extrahiert. Die gesammelten organischen Phasen werden vereinigt, getrocknet und das Lösungsmittel wird im Vakuum entfernt. Das entstehende Öl wird über Zonensublimation aufgereinigt. Ausbeute: 57% (80.2 g, 229 mmol).

Int-1 wird anschließend in 1000 ml THF gelöst, auf 0°C gekühlt und N-Brom-succinimid (81.7 g, 178 mmol) wird portionsweise zugegeben. Die Reaktion wird dann langsam auf Raumtemperatur erwärmt. THF wird im Vakuum entfernt, der Rückstand wird mit Toluol aufgenommen und mit Wasser dreimal gewaschen. Die organische Phase wird getrocknet und das Lösungsmittel erneut im Vakuum entfernt. Anschließend wird mehrmals aus Heptan umkristallisiert. MON-33-Br wird mit einer Ausbeute von 86% (100 g, 200 mmol) erhalten.

MON-034-Br wird analog hergestellt, indem anstatt 3-Bromobenzaldehyd 3-Bromo-bicyclo(4.2.0)octa-1(6),2,4-trien verwendet wird. MON-34-Br wird mit einer Ausbeute von 55% hergestellt.

### Synthese von MON-35-Br

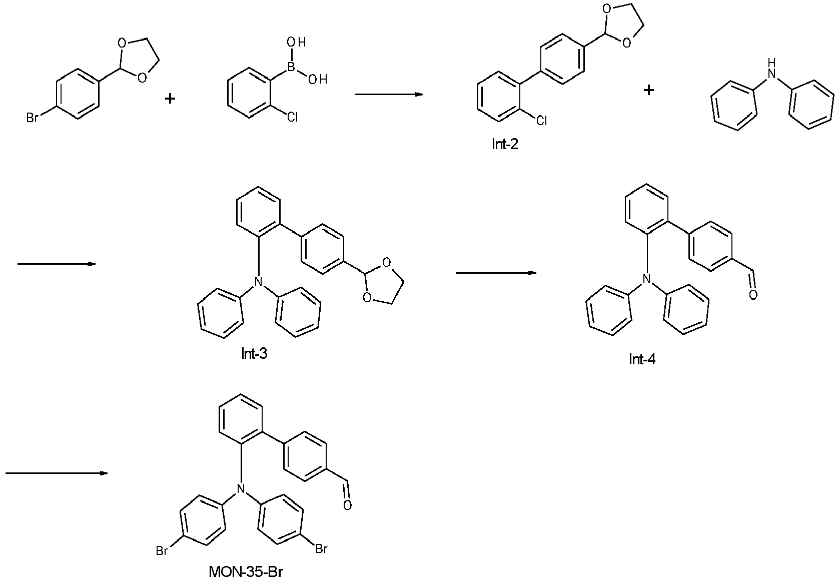

Das Bromphenyl-Derivat (23 g, 100 mmol), 2-Chlorphenylboronsäure (16.5 g, 105 mmol) und Kaliumcarbonat ( 41.6 g, 301 mmol) werden in 140 ml THF und 50 ml Wasser vorgelegt. Die Reaktionsmischung wird entgast und anschließend wird Tetrakis(triphenylphospin)palladium (1.16 g, 1 mmol) zugegeben. Die Reaktion wird über Nacht am Rückfluß gerührt. Danach wird auf Raumtemperatur abgekühlt, mit Toluol und Wasser versetzt, die Phasen werden getrennt und die organische Phase wird mit Wasser gewaschen. Nach Entfernen des Lösungsmittel im Vakuum wird der entstehende Feststoff mittels Heißextraktion (Heptan, Alox) aufgereinigt. Int-2 wird mit einer Ausbeute von 80% (20.7 g, 79 mmol) erhalten.

Int-2 (19.7 g, 76 mmol) und Diphenylamin (12.9 g, 76 mmol) werden in 800 ml Toluol gelöst und Natrium-t-butylat (10.9 g, 113 mmol) wird zugegeben. Anschließend wird 30 min mit Argon entgast und Tris(dibenzylideneacetone)dipalladium (690 mg, 0.76 mmol) wird zugegeben. Das Reaktionsgemisch wird über Nacht am Rückfluß erhitzt, anschließend wird abgekühlt und mit Wasser und Toluol versetzt. Die Phasen werden getrennt, die organische Phase wird mit Wasser gewaschen und anschließend getrocknet. Das Lösungsmittel wird im Vakuum entfernt und das entstandene Rohprodukt über Alox aufgereinigt. Int-3 wird mit einer Ausbeute von 71 % (21.1 g, 53 mmol) erhalten.

Int-3 (20 g, 50 mmol) wird in 400 ml Acetonitril gelöst und mit 75 ml Salzsäure versetzt. Dabei fällt ein Feststoff aus, der abgesaugt wird. Int-4: Ausbeute 68% (12.1 g, 35 mmol).

Int-4 (12 g, 35 mmol) wird in 470 ml THF gelöst, auf 0°C gelöst und N-Bromo-succinimid (12,2 g, 68 mmol) wird portionsweise zugegeben. Das Reaktionsgemisch wird über Nacht auf Raumtemperatur erwärmt. Das Lösungsmittel wird im Vakuum entfernt, mit Toluol wieder aufgenommen und mit wässriger Na₂SO₃ Lösung und anschließend mit Wasser gewaschen. Das Lösungsmittel wird erneut entfernt und der feste Rückstand aus einem Toluol/Heptan Gemisch mehrmals umkristallisiert. MON-35-Br wird mit einer Ausbeute von 67% (11.7 g, 23 mmol) erhalten.

### Synthese von MON-36-BE

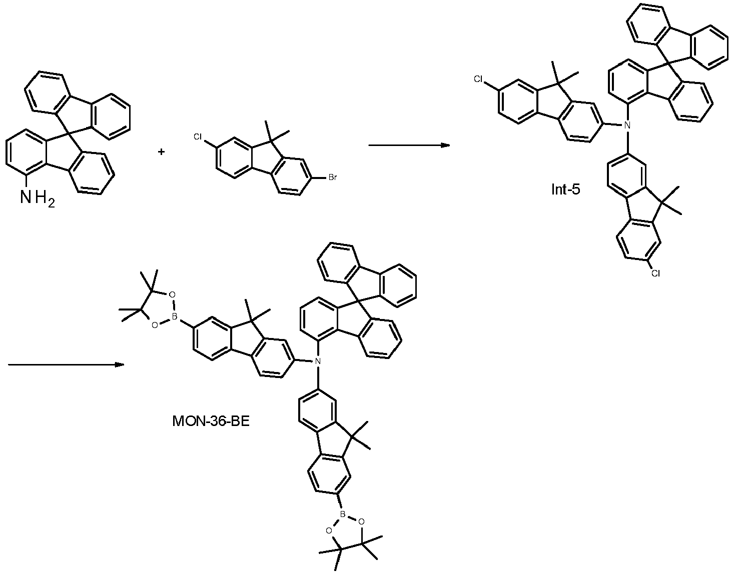

9,9'-Spirobifluoren-4'-amin (25 g, 75 mmol) und 2-Brom-7-chlor-9,9-dimethylfluoren (48.7 g, 160 mmol) wird in 400 ml Toluol gelöst und anschließend wird Natrium-t-butylat (21.7 g, 226 mmol) zugegeben. Die Mischung wird mit Schutzgas gesättigt und nach Zugabe von [1,1'-Bis(diphenylphosphino)ferrocen]dichloropalladium (1.85 g, 0.2 mmol) auf Rückfluß erhitzt. Nach vier Stunden wird die Mischung auf Raumtemperatur abgekühlt, über Celite filtriert und mit Toluol nachgewaschen. Die Phasen werden getrennt und die organische Phase wird mit Wasser gewaschen, getrocknet und das Lösungsmittel wird entfernt. Zur Aufreinigung wird der Feststoff mit Heptan/Toluol über Kieselgel filtriert. Int-5 wird mit einer Ausbeute von 73% (43 g, 54 mmol) erhalten.

41 g Int-5 (52 mmol) werden zusammen mit Bis(pinacolato)diboran (30.6 g, 120 mmol) und Kaliumacetat (25.7 g, 261.8 mmol) in 650 ml Dioxan vorgelegt. Es wird mit Argon inertisiert und anschließend Palladiumacetat (235 mg, 1.05 mmol) und Sphos (860 mg, 2.09 mmol) zugegeben. Die Mischung wird über Nacht am Rückfluß gerührt. Die Mischung wird auf Raumtemperatur abgekühlt, über Celite filtriert und mit Toluol nachgewaschen. Die Phasen werden getrennt und die organische Phase mit Wasser gewaschen, getrocknet und das Lösungsmittel entfernt. Das Rohprodukt wird anschließend umkristallisiert (Toluol/Heptan) und dann säulenchromatographisch aufgereinigt (Heptan/EtOAc). MON-36-Br wird mit einer Ausbeute von 30% (15 g, 15 mmol) erhalten.

### Synthese der Polymere

Die Vergleichspolymere V1 und V2 sowie die erfindungsgemäßen Polymere Po1 bis Po40 werden durch SUZUKI-Kupplung gemäß dem in der WO 2003/048225 beschriebenen Verfahren aus den obenstehend offenbarten Monomeren hergestellt.

Bei der Herstellung der Polymere werden die unten angegeben Monomere in den entsprechenden prozentualen Anteilen, wie unten angegeben, in der Reaktionsmischung eingesetzt. Die auf diese Weise hergestellten Polymere V1 und V2 sowie Po1 bis Po40 enthalten die Struktureinheiten nach Abspaltung der Abgangsgruppen in den in der untenstehenden Tabelle angegebenen prozentualen Anteilen (Prozentangaben = mol%).

Bei den Polymeren, die aus Monomeren hergestellt werden, die Aldehydgruppen aufweisen, werden diese nach der Polymerisation durch WITTIG Reaktion gemäß dem in der WO 2010/097155 beschriebenen Verfahren in vernetzbare Vinylgruppen überführt (Beispiele mit Synthesevorschrift auf Seite 36/37) . Die entsprechend in der untenstehenden Tabelle aufgeführten Polymere weisen somit vernetzbare Vinylgruppen anstelle der ursprünglich vorhandenen Aldehydgruppen auf.

Die Palladium- und Bromgehalte der Polymeren werden per ICP-MS bestimmt. Die ermittelten Werte liegen unter 10 ppm.

Die Molekulargewichte M_{w} sowie die Polydispersitäten D werden mittels Gelpermeationschromatographie (GPC) (Model: Agilent HPLC System Series 1100) ermittelt (Säule: PL-RapidH von Polymer Laboratories; Lösungsmittel: THF mit 0,12 Vol% o-Dichlorbenzol; Detektion: UV und Brechungsindex; Temperatur: 40°C). Kalibriert wird mit Polystyrolstandards.

| **Polymer** | **MONA** | **%** | **MON B** | **%** | **MON C** | **%** | **Mw/D** |
|---|---|---|---|---|---|---|---|
| V1 | MON-102-Br | 50 | MON-1-BE | 30 | MON-30-BE | 20 | 138K/2,1 |
| V2 | MON-101-BE | 30 | MON-20-Br | 50 | MON-30-BE | 20 | 115K/3,4 |
| Po1 | MON-1-Br | 30 | MON-20-BE | 50 | MON-30-Br | 20 | 150K/3,9 |
| Po5 | MON-2-Br | 30 | MON-20-BE | 50 | MON-30-Br | 20 | 65K/2,8 |
| Po18 | MON-3-Br | 30 | MON-20-BE | 50 | MON-30-Br | 20 | 68K/2,5 |

Zusätzlich werden die folgenden erfindungsgemäßen Polymere hergestellt:

| **Polymer** | **MON A** | **%** | **MON B** | **%** | **MON C** | **%** | **MON D** | **%** | **MON E** | **%** | **Mw/D** |
|---|---|---|---|---|---|---|---|---|---|---|---|
| Po2 | MON-2-Br | 30 | MON-20-BE | 50 | MON-32-Br | 20 | - | - | - | - | 50K/2,3 |
| Po3 | MON-5-Br | 40 | MON-22-BE | 50 | MON-30-Br | 10 | - | - | - | - | 85K/3,2 |
| Po4 | MON-3-Br | 30 | MON-24-BE | 50 | MON-31-Br | 20 | - | - | - | - | 43K/3,5 |
| Po6 | MON-1-BE | 40 | MON-23-Br | 50 | MON-32-BE | 10 | - | - | - | - | 78K/2,3 |
| Po7 | - | - | MON-20-BE | 50 | MON-4-Br | 50 | - | - | - | - | 53K/3,3 |
| Po8 | MON-3-Br | 25 | MON-24-BE | 50 | MON-4-Br | 25 | - | - | - | - | 65K/3,7 |
| Po9 | MON-1-BE | 40 | MON-25-Br | 50 | MON-31-BE | 10 | - | - | - | - | 73K/4,2 |
| Po10 | MON-5-Br | 30 | MON-22-BE | 50 | MON-30-Br | 20 | - | - | - | - | 105K/2,3 |
| Po11 | MON-1-Br | 20 | MON-20-BE | 50 | MON-32-Br | 10 | MON-2-Br | 20 | - | - | 95K/2.6 |
| Po12 | MON-6-BE | 30 | MON-25-Br | 50 | MON-30-BE | 10 | MON-32-BE | 10 | - | - | 67K/3,6 |
| Po13 | MON-1-BE | 40 | MON-21-Br | 50 | MON-31-BE | 10 | - | - | - | - | 115K/2,1 |
| Po14 | MON-1-BE | 25 | MON-21-Br | 50 | MON-30-BE | 25 | - | - | - | - | 130K/2,9 |
| Po15 | MON-5-Br | 40 | MON-24-BE | 50 | MON-4-Br | 10 | - | - | - | - | 75K/3,2 |
| Po16 | MON-3-Br | 30 | MON-20-BE | 50 | MON-32-Br | 20 | - | - | - | - | 95K/3,4 |
| Po17 | MON-1-Br | 40 | MON-20-BE | 50 | MON-30-Br | 10 | - | - | - | - | 85K/2.6 |
| Po19 | MON-1-BE | 30 | MON-25-Br | 50 | MON-31-BE | 20 | - | - | - | - | 66K/2,7 |
| Po20 | MON-1-BE | 50 | MON-20-Br | 50 | - | - | - | - | - | - | 60K/2,5 |
| Po21 | MON-1-BE | 50 | MON-25-Br | 50 | - | - | - | - | - | - | 85K/2,8 |
| Po22 | MON-1-Br | 30 | MON-20-BE | 50 | MON-33-Br | 20 | - | - | - | - | 90K/2,4 |
| Po23 | MON-1-Br | 30 | MON-20-BE | 50 | MON-34-Br | 20 | - | - | - | - | 75K/3,4 |
| Po24 | MON-1-Br | 20 | MON-102-Br | 10 | MON-20-BE | 50 | MON-30-Br | 20 | - | - | 88K/2,5 |
| Po25 | MON-2-Br | 30 | MON-20-BE | 50 | MON-30-Br | 10 | MON-32-Br | 10 | - | - | 70K/2,2 |
| Po26 | MON-1-Br | 20 | MON-102-BE | 10 | MON-20-Br | 10 | MON-20-BE | 40 | MON-30-BE | 20 | 37K/1,9 |
| Po27 | MON-2-BE | 30 | MON-26-Br | 50 | Mon-30-BE | 20 | - | - | - | - | 65K/2.4 |
| Po28 | MON-20-BE | 50 | MON-35-Br | 50 | - | - | - | - | - | - | 40K/ 2,3 |
| Po29 | MON-1-Br | 30 | MON-20-BE | 50 | MON-35-Br | 20 | - | - | - | - | 25K/2.4 |
| Po30 | MON-2-Br | 30 | MON-20-BE | 50 | MON-20-Br | 10 | MON-32-Br | 10 | - | - | 70K/2,2 |
| Po31 | MON-102-BE | 10 | MON-1-Br | 30 | MON-20-BE | 40 | MON-30-Br | 20 | - | - | 70K/2,9 |
| Po32 | MON-7-Br | 30 | MON-20-BE | 50 | MON-30-Br | 20 | - | - | - | - | 50K/2,1 |
| Po33 | MON-35-BE | 30 | MON-20-Br | 50 | MON-30-BE | 20 | - | - | - | - | 60K/2,1 |
| Po34 | MON-8-BE | 40 | MON-23-Br | 50 | MON-32-BE | 10 | - | - | - | - | 78K/2,3 |
| Po35 | MON-8-BE | 25 | MON-21-Br | 50 | MON-30-BE | 25 | - | - | - | - | 130K/2,9 |
| Po36 | MON-8-Br | 30 | MON-20-BE | 50 | MON-32-Br | 20 | - | - | - | - | 95K/3,4 |
| Po37 | MON-8-Br | 40 | MON-20-BE | 50 | MON-30-Br | 10 | - | - | - | - | 85K/2,6 |
| Po38 | MON-8-Br | 30 | MON-20-BE | 50 | MON-30-Br | 20 | - | - | - | - | 68K/2,5 |
| Po39 | MON-2-Br | 50 | MON-20-BE | 50 | | | | | | | 80K/2,1 |
| Po40 | MON-102-Br | 10 | MON-1-Br | 40 | MON-20-BE | 50 | | | | | 110K/2,2 |

### B) Device-Beispiele

Das allgemeine Verfahren zur Herstellung von OLEDs enthaltend Schichten, die aus Lösung aufgebracht werden, ist in WO 2004/037887 und WO 2010/097155 beschrieben. Dieses Verfahren wird auf die im Folgenden beschriebenen Gegebenheiten (Schichtdickenvariation, Materialien) angepasst.

Die erfindungsgemäßen Polymere werden in OLEDs mit folgender Schichtabfolge verwendet:
- Substrat,
- ITO (50 nm),
- Lochinjektionsschicht (HIL) (20 nm),
- Lochtransportschicht (HTL) (20 nm),
- Emissionsschicht (EML) (30 nm),
- Lochblockierschicht (HBL) (10 nm)
- Elektronentransportschicht (ETL) (40 nm),
- Kathode (Al) (100 nm).

Als Substrat dienen Glasplättchen, die mit strukturiertem ITO (Indium-ZinnOxid) der Dicke 50 nm beschichtet sind. Die Lochinjektionsschicht wird mittels Spin-Coating in inerter Atmosphäre aufgebracht. Hierzu werden ein lochtransportierendes, vernetzbares Polymer und ein p-dotierendes Salz in Toluol gelöst. Entsprechende Materialien wurden u.a. in WO 2016/107668, WO 2013/081052 und EP2325190 beschrieben. Für eine resultierende Schichtdicke von 20 nm wird ein Feststoffgehalt von 6 mg/ml verwendet. Die Schicht wird anschließend auf einer Heizplatte für 30 Minuten bei 200°C in Inertgasatmosphäre ausgeheizt.

Auf diese beschichteten Glasplättchen werden nun die Lochtransport- und die Emissionsschicht aufgebracht.

Als Lochtransportschicht werden die erfindungsgemäßen Verbindungen sowie Vergleichsverbindungen verwendet, jeweils in Toluol gelöst. Der Feststoffgehalt dieser Lösungen liegt bei 5 mg/ml, da mittels Spincoating Schichtdicken von 20 nm erzielt werden sollen. Die Schichten werden in Inertgasatmosphäre aufgeschleudert und für 30 Minuten bei 240°C auf einer Heizplatte ausgeheizt.

Die Emissionsschicht setzt sich aus dem Hostmaterial H1 und dem emittierenden Dotierstoff D1 zusammen. Die Materialien liegen in einem Gewichtsanteil von 92% H1 und 8% D1 in der Emissionsschicht vor. Die Mischung für die Emissionsschicht wird in Toluol gelöst. Der Feststoffgehalt dieser Lösung liegt bei 9 mg/ml, da mittels Spincoating Schichtdicken von 30 nm erzielt werden sollen. Die Schichten werden in Inertgasatmosphäre aufgeschleudert und für 10 Minuten bei 150°C ausgeheizt.

Die im vorliegenden Fall verwendeten Materialien sind in der untenstehenden Tabelle gezeigt.

| Strukturformeln der in der Emissionsschicht verwendeten Materialien | |
|---|---|
| 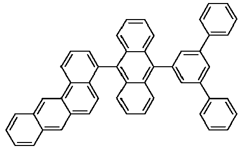 | 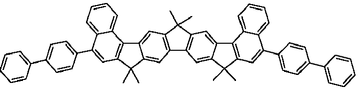 |
| H1 | D1 |

Die Materialien für die Lochblockierschicht und Elektronentransportschicht werden in einer Vakuumkammer thermisch aufgedampft und sind in der untenstehenden Tabelle gezeigt. Die Lochblockierschicht besteht aus ETM1. Die Elektronentransportschicht besteht aus den beiden Materialien ETM1 und ETM2, die einander durch Co-Verdampfung in einem Volumenanteil von jeweils 50% beigemischt werden.

| Verwendete HBL- und ETL-Materialien | |
|---|---|
| 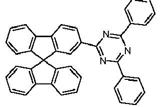 | 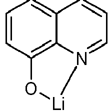 |
| ETM1 | ETM2 |

Die Kathode wird durch die thermische Verdampfung einer 100 nm dicken Aluminiumschicht gebildet.

Die OLEDs werden standardmäßig charakterisiert. Hierfür werden die Elektrolumineszenzspektren und Strom-Spannungs-Leuchtdichte-Kennlinien (IUL-Kennlinien) unter Annahme einer Lambert'schen Abstrahlcharakteristik sowie die (Betriebs-)Lebensdauer bestimmt. Aus den IUL-Kennlinien werden Kennzahlen bestimmt wie z.B. die externe Quanteneffizienz (in %) bei einer bestimmten Helligkeit. LD80 @ 1000cd/m² ist die Lebensdauer, bis die OLED bei einer Starthelligkeit von 1000 cd/m² auf 80 % der Anfangsintensität, also auf 800 cd/m², abgefallen ist.

Die Leistungsdaten und Eigenschaften der hergestellten OLEDs werden im Folgenden beschrieben. Die hergestellten OLEDs sind blau emittierende OLEDs.
1) Für OLEDs enthaltend V1, V2, Po1, Po5 und Po18 werden folgende Ergebnisse für Lebensdauer und Effizienz erhalten:

| Polymer in HTL | Effizienz bei 1000 cd/m² | LD80 bei 1.000 cd/m² |
|---|---|---|
| | % EQE | [h] |
| V1 | 4.4 | 198 |
| V2 | 7.4 | 121 |
| Po1 | 7.6 | 257 |
| Po5 | 7.4 | 279 |
| Po18 | 7.1 | 223 |

Wie die erhaltenen Daten für die Effizienz zeigen, bringt das erfindungsgemäße Polymer Po1 große Verbesserungen gegenüber dem Vergleichspolymer V1. Die Effizienz steigert sich um über 50% gegenüber dem Vergleichspolymer V1. Dies zeigt den Effekt, der durch die Verwendung der konjugationsunterbrechenden substituierten Phenylen-Einheit, abgeleitet vom Monomer MON-20-BE, gegenüber der Verwendung der Indenofluoren-Einheit, abgeleitet vom Monomer MON-102-Br, erzielt wird. Die Indenofluoreneinheit stellt keine konjugationsunterbrechende Einheit dar.

Auch mit Polymeren enthaltend andere konjugationsunterbrechende Einheiten, wie beispielsweise die oben gezeigten Einheiten MON-21 bis MON-26, zeigen sich deutliche Verbesserungen gegenüber Vergleichspolymeren, die keine konjugationsunterbrechende Einheit aufweisen, wie beispielsweise V1 mit der Indenofluoren-Einheit MON-102-Br.

Wie die erhaltenen Daten für die Lebensdauer zeigen, bringen die erfindungsgemäßen Polymere Po1, Po5 und Po18 auch Verbesserungen gegenüber dem Vergleichspolymer V2. Die Effizienz bleibt nahezu unverändert. Dies zeigt den Effekt, der durch die Verwendung der orthosubstituierten Triarylamin-Struktureinheiten, abgeleitet von den Monomeren MON-1-Br, MON-2-Br und MON-3-Br (in Po1, Po5 und Po18), gegenüber der Verwendung der para-substituierten Triarylamin-Struktureinheit, abgeleitet vom Monomer MON-101-BE (in V2), erzielt wird.

Auch mit weiteren erfindungsgemäßen Polymeren, die sich von Po1, Po5 und Po18 dadurch unterscheiden, dass sie anstelle der Struktureinheiten abgeleitet von den Monomeren MON-1-Br, MON-2-Br und MON-3-Br Struktureinheiten abgeleitet von den Monomeren MON-4-Br, MON-5-Br, MON-6-BE, MON-7-Br, MON-8-BE und MON-8-Br enthalten, wird eine verbesserte Lebensdauer verglichen mit V2 erhalten.

2) Zusätzlich zu den oben aufgeführten Beispielen werden OLEDs mit den folgenden erfindungsgemäßen Polymeren vermessen:

| Polymer in HTL | Effizienz bei 1000 cd/m² | LD80 bei 1.000 cd/m² |
|---|---|---|
| | % EQE | [h] |
| Po2 | 7.6 | 143 |
| Po22 | 6.8 | 256 |
| Po23 | 8.0 | 129 |
| Po24 | 7.3 | 397 |
| Po25 | 7.5 | 230 |
| Po26 | 7.4 | 192 |
| Po27 | 6.7 | 234 |
| Po28 | 7.0 | 216 |
| Po37 | 7.5 | 216 |
| Po38 | 7.1 | 223 |

Dabei zeigt sich, dass diese ebenfalls eine sehr gute Effizienz aufweisen. Die relativ niedrige Lebensdauer in Po2 und Po23 sind durch die in diesen Polymeren enthaltenen Monomere MON-32-Br und MON-34-Br bedingt.

3) Schließlich werden OLEDs enthaltend jeweils eines der oben genannten erfindungsgemäßen Polymere Po3, Po4, Po6 bis Po17, Po19 bis Po21, Po29 bis Po36, Po39 und Po40 als Material der HTL hergestellt. Dabei werden ebenfalls gute Ergebnisse für Effizienz und Lebensdauer erzielt. In den erfindungsgemäßen Beispielen werden die erfindungsgemäßen Polymere in einer HTL in Kombination mit einer EML, welche aus Lösung aufgebracht wird und welche einen Singulett-Emitter enthält, eingesetzt. Dabei zeigt sich die hervorragende Eignung der Polymere in diesem speziellen Device-Setup mit aus Lösung aufgebrachter blau emittierender EML.

## Patentansprüche

1. Polymer enthaltend mindestens eine Struktureinheit der Formel (I) 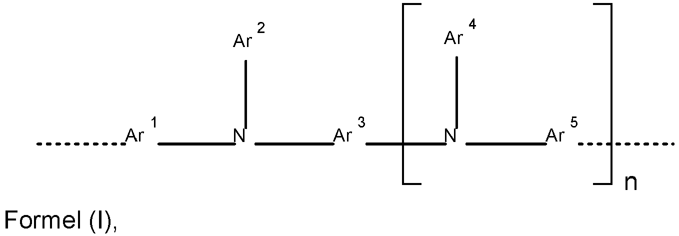 wobei für die auftretenden Variablen gilt:
Ar¹, Ar², Ar³, Ar⁴ und Ar⁵ sind gleich oder verschieden gewählt aus heteroaromatischen Ringsystemen mit 5 bis 40 aromatischen Ringatomen, die mit einem oder mehreren Resten R¹ substituiert sein können, und aus aromatischen Ringsystemen mit 6 bis 40 aromatischen Ringatomen, die mit einem oder mehreren Resten R¹ substituiert sein können; mit der Maßgabe, dass mindestens eine der beiden Gruppen Ar² und Ar⁴ jeweils in mindestens einer ortho-Position zur Bindung an N mit einer Gruppe R⁴ substituiert ist, wobei die Gruppe R⁴ mit der entsprechenden Gruppe Ar² bzw. Ar⁴, an die sie gebunden ist, einen Ring bilden kann, und wobei R⁴ direkt oder über eine Linkergruppe X an die Gruppe gewählt aus Gruppen Ar² und Ar⁴ gebunden ist;
R¹ ist bei jedem Auftreten gleich oder verschieden gewählt aus H, D, F, C(=O)R², CN, Si(R²)₃, N(R²)₂, P(=O)(R²)₂, OR², S(=O)R², S(=O)₂R², geradkettigen Alkyl- oder Alkoxygruppen mit 1 bis 20 C-Atomen, verzweigten oder cyclischen Alkyl- oder Alkoxygruppen mit 3 bis 20 C-Atomen, Alkenyl- oder Alkinylgruppen mit 2 bis 20 C-Atomen, aromatischen Ringsystemen mit 6 bis 40 aromatischen Ringatomen, und heteroaromatischen Ringsystemen mit 5 bis 40 aromatischen Ringatomen; wobei zwei oder mehr Reste R¹ miteinander verknüpft sein können und einen Ring bilden können; wobei die genannten Alkyl-, Alkoxy-, Alkenyl- und Alkinylgruppen und die genannten aromatischen Ringsysteme und heteroaromatischen Ringsysteme jeweils mit einem oder mehreren Resten R² substituiert sein können; und wobei eine oder mehrere CH₂-Gruppen in den genannten Alkyl-, Alkoxy-, Alkenyl- und Alkinylgruppen durch -R²C=CR²-, -C=C-, Si(R²)₂, C=O, C=NR², -C(=O)O-, -C(=O)NR²-, NR², P(=O)(R²), -O-, -S-, SO oder SO₂ ersetzt sein können;
R² ist bei jedem Auftreten gleich oder verschieden gewählt aus H, D, F, C(=O)R³, CN, Si(R³)₃, N(R³)₂, P(=O)(R³)₂, OR³, S(=O)R³, S(=O)₂R³, geradkettigen Alkyl- oder Alkoxygruppen mit 1 bis 20 C-Atomen, verzweigten oder cyclischen Alkyl- oder Alkoxygruppen mit 3 bis 20 C-Atomen, Alkenyl- oder Alkinylgruppen mit 2 bis 20 C-Atomen, aromatischen Ringsystemen mit 6 bis 40 aromatischen Ringatomen, und heteroaromatischen Ringsystemen mit 5 bis 40 aromatischen Ringatomen; wobei zwei oder mehr Reste R¹ bzw. R² miteinander verknüpft sein können und einen Ring bilden können; wobei die genannten Alkyl-, Alkoxy-, Alkenyl- und Alkinylgruppen und die genannten aromatischen Ringsysteme und heteroaromatischen Ringsysteme jeweils mit einem oder mehreren Resten R³ substituiert sein können; und wobei eine oder mehrere CH₂-Gruppen in den genannten Alkyl-, Alkoxy-, Alkenyl- und Alkinylgruppen durch -R³C=CR³-, -C=C-, Si(R³)₂, C=O, C=NR³, -C(=O)O-, -C(=O)NR³-, NR³, P(=O)(R³), -O-, -S-, SO oder SO₂ ersetzt sein können;
R³ ist bei jedem Auftreten gleich oder verschieden gewählt aus H, D, F, CN, Alkyl- oder Alkoxygruppen mit 1 bis 20 C-Atomen, Alkenyl- oder Alkinylgruppen mit 2 bis 20 C-Atomen, aromatischen Ringsystemen mit 6 bis 40 aromatischen Ringatomen und heteroaromatischen Ringsystemen mit 5 bis 40 aromatischen Ringatomen; wobei zwei oder mehr Reste R³ miteinander verknüpft sein können und einen Ring bilden können; und wobei die genannten Alkyl-, Alkoxy-, Alkenyl- und Alkinylgruppen, aromatischen Ringsysteme und heteroaromatischen Ringsysteme mit F oder CN substituiert sein können;
R⁴ ist bei jedem Auftreten gleich oder verschieden gewählt aus heteroaromatischen Ringsystemen mit 5 bis 40 aromatischen Ringatomen, die mit einem oder mehreren Resten R² substituiert sein können, und aus aromatischen Ringsystemen mit 6 bis 40 aromatischen Ringatomen, die mit einem oder mehreren Resten R² substituiert sein können;
X ist bei jedem Auftreten gleich oder verschieden gewählt aus C(R²)₂, Si(R²)₂, NR², O, S, und C=O;
n ist gleich 0 oder 1;
und mindestens eine Struktureinheit gewählt aus
- Struktureinheiten A der Formel (II-A) 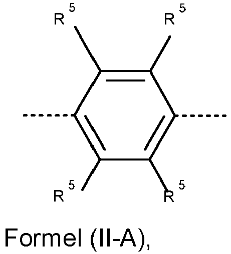
wobei in Formel (II-A) mindestens eine Gruppe R⁵ vorhanden ist, die gewählt ist aus geradkettigen Alkyl- oder Alkoxygruppen mit 1 bis 20 C-Atomen, verzweigten oder cyclischen Alkyl- oder Alkoxygruppen mit 3 bis 20 C-Atomen, Alkenyl- oder Alkinylgruppen mit 2 bis 20 C-Atomen, aromatischen Ringsystemen mit 6 bis 40 aromatischen Ringatomen, und heteroaromatischen Ringsystemen mit 5 bis 40 aromatischen Ringatomen, wobei die genannten Alkyl-, Alkoxy-, Alkenyl- und Alkinylgruppen und die genannten aromatischen Ringsysteme und heteroaromatischen Ringsysteme jeweils mit einem oder mehreren Resten R² substituiert sein können;
- Struktureinheiten B der Formel (II-B) 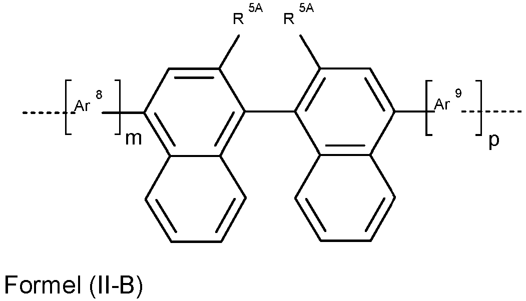 wobei
R^{5A} bei jedem Auftreten gleich oder verschieden gewählt ist aus H, D, F, C(=O)R², CN, Si(R²)₃, N(R²)₂, P(=O)(R²)₂, OR², S(=O)R², S(=O)₂R², geradkettigen Alkyl- oder Alkoxygruppen mit 1 bis 20 C-Atomen, verzweigten oder cyclischen Alkyl- oder Alkoxygruppen mit 3 bis 20 C-Atomen, Alkenyl- oder Alkinylgruppen mit 2 bis 20 C-Atomen, aromatischen Ringsystemen mit 6 bis 40 aromatischen Ringatomen, und heteroaromatischen Ringsystemen mit 5 bis 40 aromatischen Ringatomen; wobei die genannten Alkyl-, Alkoxy-, Alkenyl- und Alkinylgruppen und die genannten aromatischen Ringsysteme und heteroaromatischen Ringsysteme jeweils mit einem oder mehreren Resten R² substituiert sein können; und wobei eine oder mehrere CH₂-Gruppen in den genannten Alkyl-, Alkoxy-, Alkenyl- und Alkinylgruppen durch -R²C=CR²-, -C=C-, Si(R²)₂, C=O, C=NR², -C(=O)O-, -C(=O)NR²-, NR², P(=O)(R²), -O-, -S-, SO oder SO₂ ersetzt sein können;
Ar⁸ und Ar⁹ bei jedem Auftreten gleich oder verschieden gewählt sind aus aromatischen Ringsystemen mit 6 bis 40 aromatischen Ringatomen, die mit einem oder mehreren Resten R⁵ substituiert sein können, und heteroaromatischen Ringsystemen mit 5 bis 40 aromatischen Ringatomen, die mit einem oder mehreren Resten R⁵ substituiert sein können;
m und p bei jedem Auftreten gleich oder verschieden gewählt sind aus 0 und 1;
und die Naphthylgruppen an den unsubstituiert dargestellten Positionen jeweils mit einem Rest R⁵ substituiert sein können; und
- Struktureinheiten C, die der Formel (II-C) entsprechen 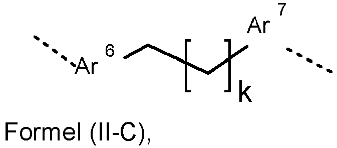
wobei
Ar⁶ und Ar⁷ bei jedem Auftreten gleich oder verschieden gewählt sind aus aromatischen Ringsystemen mit 6 bis 40 aromatischen Ringatomen, die mit einem oder mehreren Resten R⁵ substituiert sein können, und heteroaromatischen Ringsystemen mit 5 bis 40 aromatischen Ringatomen, die mit einem oder mehreren Resten R⁵ substituiert sein können;
R⁵ bei jedem Auftreten gleich oder verschieden gewählt ist aus H, D, F, C(=O)R², CN, Si(R²)₃, N(R²)₂, P(=O)(R²)₂, OR², S(=O)R², S(=O)₂R², geradkettigen Alkyl- oder Alkoxygruppen mit 1 bis 20 C-Atomen, verzweigten oder cyclischen Alkyl- oder Alkoxygruppen mit 3 bis 20 C-Atomen, Alkenyl- oder Alkinylgruppen mit 2 bis 20 C-Atomen, aromatischen Ringsystemen mit 6 bis 40 aromatischen Ringatomen, und heteroaromatischen Ringsystemen mit 5 bis 40 aromatischen Ringatomen; wobei die genannten Alkyl-, Alkoxy-, Alkenyl- und Alkinylgruppen und die genannten aromatischen Ringsysteme und heteroaromatischen Ringsysteme jeweils mit einem oder mehreren Resten R² substituiert sein können; und wobei eine oder mehrere CH₂-Gruppen in den genannten Alkyl-, Alkoxy-, Alkenyl- und Alkinylgruppen durch -R²C=CR²-, -C=C-, Si(R²)₂, C=O, C=NR², -C(=O)O-, -C(=O)NR²-, NR², P(=O)(R²), -O-, -S-, SO oder SO₂ ersetzt sein können;
k einen Wert von 0 bis 9 hat, und
wobei eine oder mehrere Einheiten CH₂ in der Alkylenkette von Formel (II-C) durch eine divalente Einheit gewählt aus C=O,
C=NR⁵, -C(=O)O-, -C(=O)NR⁵-, Si(R⁵)₂, NR⁵, P(=O)(R⁵), O, S, SO und SO₂ ersetzt sein können; und
wobei ein oder mehrere H-Atome in der Alkylenkette von Formel (II-C) jeweils durch einen Rest R⁵ ersetzt sein können;
wobei die Summe der Anteile derjenigen Struktureinheiten, die einer Struktureinheit der Formel (I) entsprechen, im Polymer zwischen 20 und 50 Mol-%, bezogen auf 100 Mol-% aller copolymerisierten Monomere, die im Polymer als Struktureinheiten enthalten sind, beträgt; und
wobei die Summe der Anteile derjenigen Struktureinheiten, die einer Struktureinheit A, B oder C entsprechen, im Polymer zwischen 20 und 75 Mol-%, bezogen auf 100 Mol-% aller copolymerisierten Monomere, die im Polymer als Struktureinheiten enthalten sind, beträgt.

2. Polymer nach Anspruch 1, **dadurch gekennzeichnet, dass** R⁴ bei jedem Auftreten gleich oder verschieden gewählt ist aus aromatischen Ringsystemen mit 6 bis 20 aromatischen Ringatomen, die mit einem oder mehreren Resten R² substituiert sein können.

3. Polymer nach Anspruch 1 oder 2, **dadurch gekennzeichnet, dass** mindestens eine Gruppe gewählt aus Gruppen Ar² und Ar⁴ genau eine oder genau zwei Gruppen R⁴ in ortho-Position zum Stickstoffatom enthält, wobei R⁴ direkt oder über eine Linkergruppe X an die Gruppe gewählt aus Gruppen Ar² und Ar⁴ gebunden ist.

4. Polymer nach einem oder mehreren der Ansprüche 1 bis 3, **dadurch gekennzeichnet, dass** die Struktureinheit der Formel (I) einer der Formeln (I-1-A), (I-2-A-1), (I-2-A-2) und (I-2-A-3) entspricht 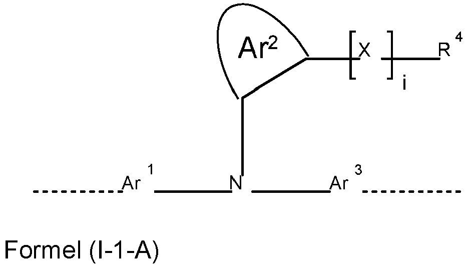 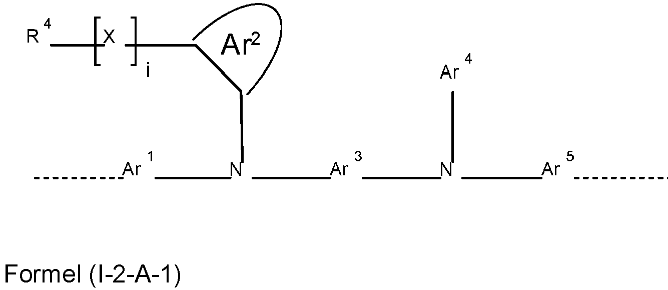 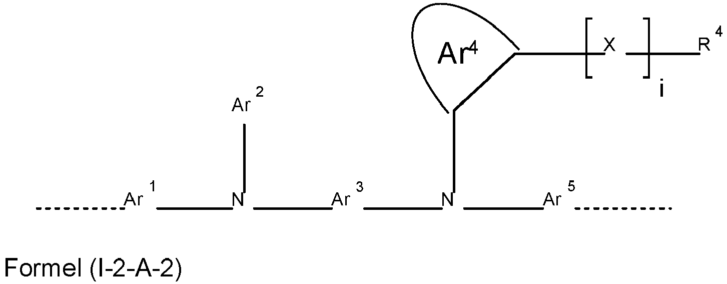 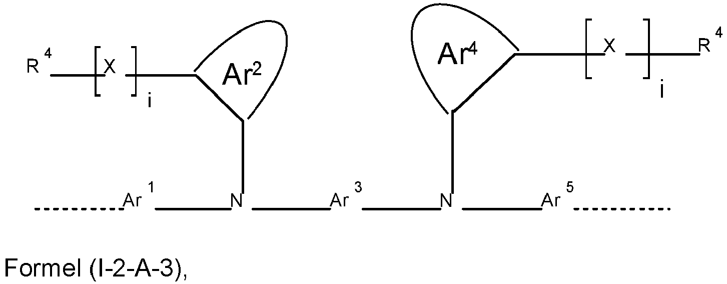 wobei i gleich 0 oder 1 ist, und Ar¹, Ar², Ar³, Ar⁴, Ar⁵, X, und R⁴ definiert sind wie in Anspruch 1 oder 2.

5. Polymer nach einem oder mehreren der Ansprüche 1 bis 4, **dadurch gekennzeichnet, dass** die Struktureinheit der Formel (I) einer der Formeln (I-1-B), (I-2-B-1), (I-2-B-2) und (I-2-B-3) entspricht 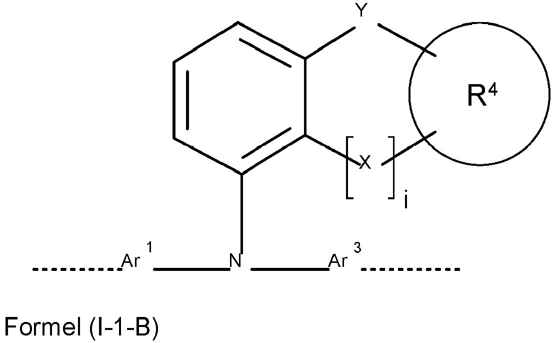 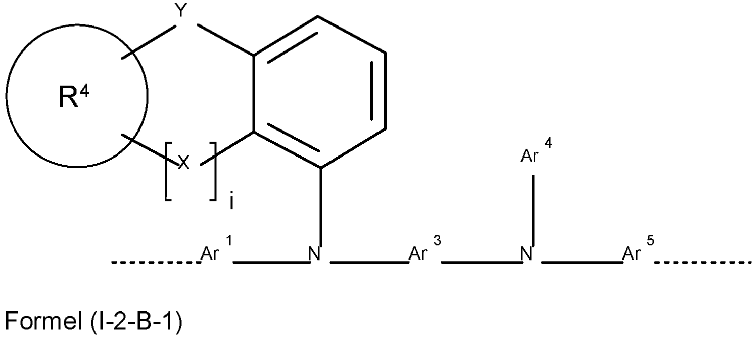 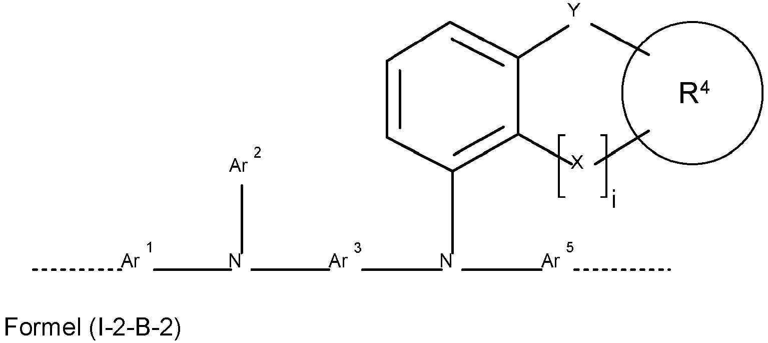 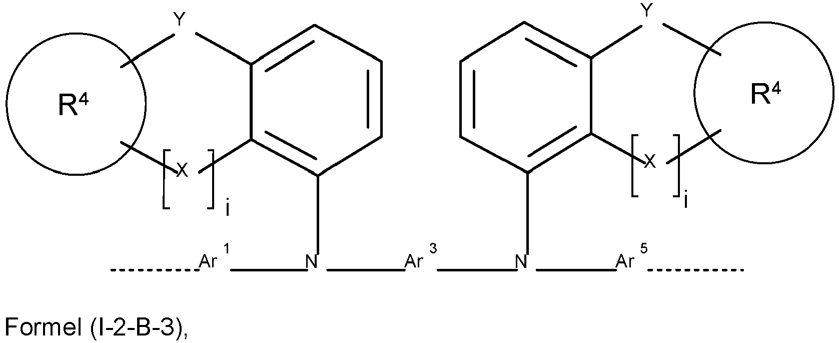 wobei i gleich 0 oder 1 ist, wobei Y bei jedem Auftreten gleich oder verschieden gewählt ist aus Einfachbindung, C(R²)₂, Si(R²)₂, NR², O, S und C=O, und wobei Ar¹, Ar², Ar³, Ar⁴, Ar⁵, X, und R⁴ definiert sind wie in Anspruch 1 oder 2.

6. Polymer nach einem oder mehreren der Ansprüche 1 bis 5, **dadurch gekennzeichnet, dass** die Struktureinheit der Formel (I) einer der Formeln (I-1-A-A), (I-1-A-B) und (I-1-B-A) entspricht 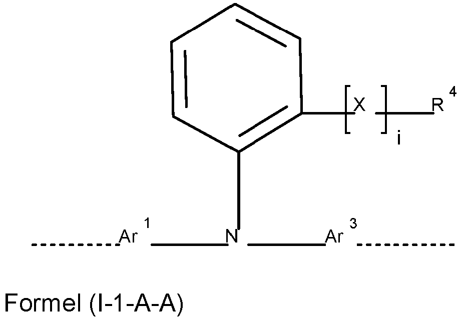 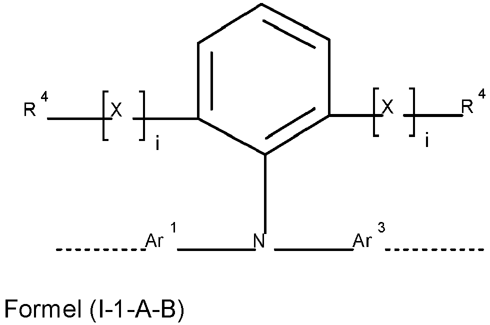 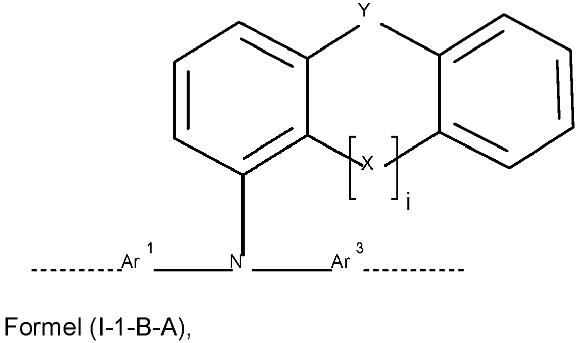 wobei i gleich 0 oder 1 ist, und wobei die aromatischen Sechsringe jeweils an den unsubstituiert gezeichneten Positionen mit einem Rest R¹ bzw. R² substituiert sein können, und wobei Y bei jedem Auftreten gleich oder verschieden gewählt ist aus Einfachbindung, C(R²)₂, Si(R²)₂, NR², O, S und C=O, und wobei Ar¹, Ar³, R⁴, und X definiert sind wie in Anspruch 1 oder 2.

7. Polymer nach einem oder mehreren der Ansprüche 1 bis 6, **dadurch gekennzeichnet, dass** das Polymer mindestens eine Struktureinheit enthält, die eine vernetzbare Gruppe Q aufweist.

8. Polymer nach Anspruch 7, **dadurch gekennzeichnet, dass** die mindestens eine Struktureinheit, die eine vernetzbare Gruppe aufweist, eine Struktureinheit der Formel (I), eine Struktureinheit A, eine Struktureinheit B, eine Struktureinheit C oder eine Struktureinheit gewählt aus Triarylamin-, Fluoren-, Indenofluoren, und Spirobifluoren-Struktureinheiten ist.

9. Polymer nach Anspruch 7 oder 8, **dadurch gekennzeichnet, dass** der Anteil an Struktureinheiten im Polymer, die eine vernetzbare Gruppe aufweisen, im Bereich von 1 bis 50 mol% liegt, bezogen auf 100 mol% aller copolymerisierten Monomere, die im Polymer als Struktureinheiten enthalten sind.

10. Polymer, erhältlich durch Vernetzungsreaktion eines Polymers nach einem oder mehreren der Ansprüche 7 bis 9.

11. Verfahren zur Herstellung eines Polymers nach einem oder mehreren der Ansprüche 1 bis 9, **dadurch gekennzeichnet, dass** eine Polymerisation gewählt aus Polymerisation gemäß Suzuki, Polymerisation gemäß Yamamoto, Polymerisation gemäß Stille, und Polymerisation gemäß Hartwig-Buchwald durchgeführt wird.

12. Mischung enthaltend mindestens ein Monomer der Formel (M-I) und mindestens ein Monomer gewählt aus Monomeren der Formeln (M-II-A), (M-II-B) und (M-II-C) 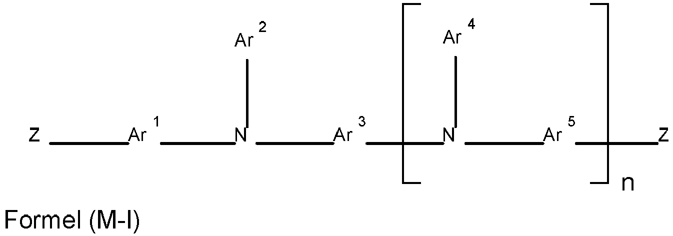 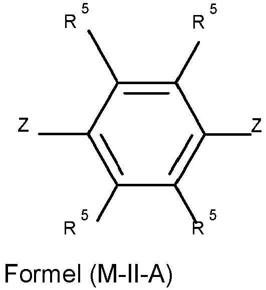 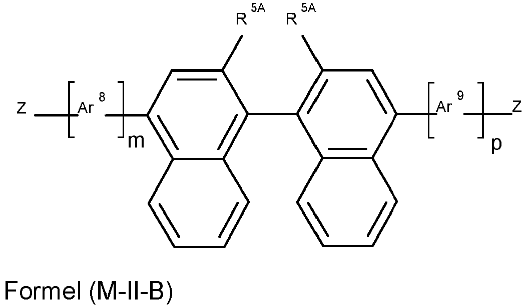 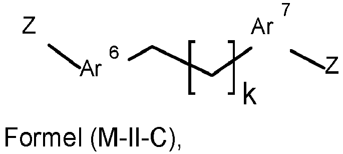
wobei die auftretenden Variablen wie in Anspruch 1 definiert sind, und wobei Z bei jedem Auftreten gleich oder verschieden eine für eine Polymerisationsreaktion geeignete Abgangsgruppe darstellt; und wobei
die Summe der Anteile der Monomere der Formel (M-1) zwischen 20 und 50 Mol-% beträgt; und
wobei die Summe der Anteile der Monomere der Formeln (M-II-A), (M-II-B) und (M-II-C) zwischen 20 und 75 Mol-% beträgt.

13. Mischung enthaltend mindestens ein Polymer nach einem oder mehreren der Ansprüche 1 bis 10, sowie eine oder mehrere weitere polymere, oligomere, dendritische und/oder niedermolekulare Substanzen.

14. Lösung, enthaltend ein oder mehrere Polymere nach einem oder mehreren der Ansprüche 1 bis 10 sowie ein oder mehrere Lösungsmittel.

15. Verwendung eines Polymers nach einem oder mehreren der Ansprüche 1 bis 10 in einer elektronischen Vorrichtung.

16. Elektronische Vorrichtung, enthaltend mindestens ein Polymer nach einem oder mehreren der Ansprüche 1 bis 10.

17. Elektronische Vorrichtung nach Anspruch 16, **dadurch gekennzeichnet, dass** das Polymer nach einem oder mehreren der Ansprüche 1 bis 10 in einer Schicht gewählt aus lochtransportierender Schicht, Lochinjektionsschicht, Elektronenblockierschicht und emittierender Schicht enthalten ist.

18. Elektronische Vorrichtung nach Anspruch 16 oder 17, **dadurch gekennzeichnet, dass** sie eine blau fluoreszierende emittierende Schicht enthält, die aus Lösung aufgebracht wurde.

## Claims

1. Polymer containing at least one structural unit of the formula (I) 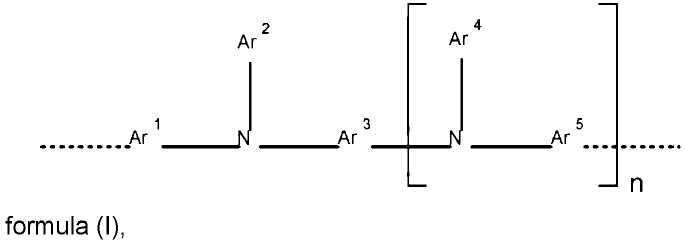 where the following applies to the variables occurring:
Ar¹, Ar², Ar³, Ar⁴ and Ar⁵ are selected, identically or differently, from heteroaromatic ring systems having 5 to 40 aromatic ring atoms, which may be substituted by one or more radicals R¹, and from aromatic ring systems having 6 to 40 aromatic ring atoms, which may be substituted by one or more radicals R¹, with the proviso that at least one of the two groups Ar² and Ar⁴ is in each case substituted by a group R⁴ in at least one ortho position to the bond to N, where the group R⁴ may form a ring with the corresponding group Ar² or Ar⁴ to which it is bonded, and where R⁴ is bonded to the group selected from groups Ar² and Ar⁴ directly or via a linker group X;
R¹ is selected on each occurrence, identically or differently, from H, D, F, C(=O)R², CN, Si(R²)₃, N(R²)₂, P(=O)(R²)₂, OR², S(=O)R², S(=O)₂R², straight-chain alkyl or alkoxy groups having 1 to 20 C atoms, branched or cyclic alkyl or alkoxy groups having 3 to 20 C atoms, alkenyl or alkynyl groups having 2 to 20 C atoms, aromatic ring systems having 6 to 40 aromatic ring atoms, and heteroaromatic ring systems having 5 to 40 aromatic ring atoms; where two or more radicals R¹ may be linked to one another and may form a ring; where the said alkyl, alkoxy, alkenyl and alkynyl groups and the said aromatic ring systems and heteroaromatic ring systems may in each case be substituted by one or more radicals R²; and where one or more CH₂ groups in the said alkyl, alkoxy, alkenyl and alkynyl groups may be replaced by -R²C=CR²-, -C=C-, Si(R²)₂, C=O, C=NR², -C(=O)O-, -C(=O)NR²-, NR², P(=O)(R²), -O-, -S-, SO or SO₂;
R² is selected on each occurrence, identically or differently, from H, D, F, C(=O)R³, CN, Si(R³)₃, N(R³)₂, P(=O)(R³)₂, OR³, S(=O)R³, S(=O)₂R³, straight-chain alkyl or alkoxy groups having 1 to 20 C atoms, branched or cyclic alkyl or alkoxy groups having 3 to 20 C atoms, alkenyl or alkynyl groups having 2 to 20 C atoms, aromatic ring systems having 6 to 40 aromatic ring atoms, and heteroaromatic ring systems having 5 to 40 aromatic ring atoms; where two or more radicals R¹ and/or R² may be linked to one another and may form a ring; where the said alkyl, alkoxy, alkenyl and alkynyl groups and the said aromatic ring systems and heteroaromatic ring systems may in each case be substituted by one or more radicals R³; and where one or more CH₂ groups in the said alkyl, alkoxy, alkenyl and alkynyl groups may be replaced by -R³C=CR³-, -C=C-, Si(R³)₂, C=O, C=NR³, -C(=O)O-, -C(=O)NR³-, NR³, P(=O)(R³), -O-, -S-, SO or SO₂;
R³ is selected on each occurrence, identically or differently, from H, D, F, CN, alkyl or alkoxy groups having 1 to 20 C atoms, alkenyl or alkynyl groups having 2 to 20 C atoms, aromatic ring systems having 6 to 40 aromatic ring atoms and heteroaromatic ring systems having 5 to 40 aromatic ring atoms; where two or more radicals R³ may be linked to one another and may form a ring; and where the said alkyl, alkoxy, alkenyl and alkynyl groups, aromatic ring systems and heteroaromatic ring systems may be substituted by F or CN;
R⁴ is selected on each occurrence, identically or differently, from heteroaromatic ring systems having 5 to 40 aromatic ring atoms, which may be substituted by one or more radicals R², and from aromatic ring systems having 6 to 40 aromatic ring atoms, which may be substituted by one or more radicals R²;
X is selected on each occurrence, identically or differently, from C(R²)₂, Si(R²)₂, NR², O, S, and C=O;
n is equal to 0 or 1;
and at least one structural unit selected from
- structural units A of the formula (II-A) 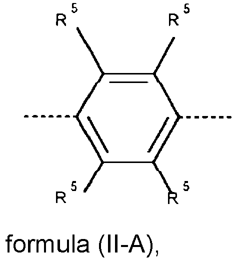
where formula (II-A) contains at least one group R⁵ which is selected from straight-chain alkyl or alkoxy groups having 1 to 20 C atoms, branched or cyclic alkyl or alkoxy groups having 3 to 20 C atoms, alkenyl or alkynyl groups having 2 to 20 C atoms, aromatic ring systems having 6 to 40 aromatic ring atoms, and heteroaromatic ring systems having 5 to 40 aromatic ring atoms; where the said alkyl, alkoxy, alkenyl and alkynyl groups and the said aromatic ring systems and heteroaromatic ring systems may in each case be substituted by one or more radicals R²;
- structural units B of the formula (II-B) 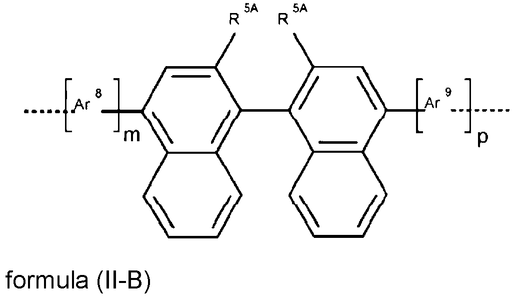 where
R^{5A} is selected on each occurrence, identically or differently, from H, D, F, C(=O)R², CN, Si(R²)₃, N(R²)₂, P(=O)(R²)₂, OR², S(=O)R², S(=O)₂R², straight-chain alkyl or alkoxy groups having 1 to 20 C atoms, branched or cyclic alkyl or alkoxy groups having 3 to 20 C atoms, alkenyl or alkynyl groups having 2 to 20 C atoms, aromatic ring systems having 6 to 40 aromatic ring atoms, and heteroaromatic ring systems having 5 to 40 aromatic ring atoms; where the said alkyl, alkoxy, alkenyl and alkynyl groups and the said aromatic ring systems and heteroaromatic ring systems may in each case be substituted by one or more radicals R²; and where one or more CH₂ groups in the said alkyl, alkoxy, alkenyl and alkynyl groups may be replaced by -R²C=CR²-, -C≡C-, Si(R²)₂, C=O, C=NR², -C(=O)O-, -C(=O)NR²-, NR², P(=O)(R²), -O-, -S-, SO or SO₂;
Ar⁸ and Ar⁹ are selected on each occurrence, identically or differently, from aromatic ring systems having 6 to 40 aromatic ring atoms, which may be substituted by one or more radicals R⁵, and heteroaromatic ring systems having 5 to 40 aromatic ring atoms, which may be substituted by one or more radicals R⁵;
m and p are selected on each occurrence, identically or differently, from 0 and 1;
and the naphthyl groups may in each case be substituted by a radical R⁵ at the positions depicted as unsubstituted; and
- structural units C which correspond to the formula (II-C) 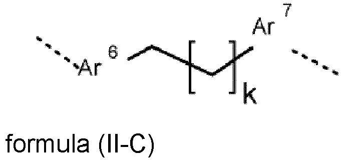 where
Ar⁶ and Ar⁷ are selected on each occurrence, identically or differently, from aromatic ring systems having 6 to 40 aromatic ring atoms, which may be substituted by one or more radicals R⁵, and heteroaromatic ring systems having 5 to 40 aromatic ring atoms, which may be substituted by one or more radicals R⁵;
R⁵ is selected on each occurrence, identically or differently, from H, D, F, C(=O)R², CN, Si(R²)₃, N(R²)₂, P(=O)(R²)₂, OR², S(=O)R², S(=O)₂R², straight-chain alkyl or alkoxy groups having 1 to 20 C atoms, branched or cyclic alkyl or alkoxy groups having 3 to 20 C atoms, alkenyl or alkynyl groups having 2 to 20 C atoms, aromatic ring systems having 6 to 40 aromatic ring atoms, and heteroaromatic ring systems having 5 to 40 aromatic ring atoms; where the said alkyl, alkoxy, alkenyl and alkynyl groups and the said aromatic ring systems and heteroaromatic ring systems may in each case be substituted by one or more radicals R²; and where one or more CH₂ groups in the said alkyl, alkoxy, alkenyl and alkynyl groups may be replaced by -R²C=CR²-, -C≡C-, Si(R²)₂, C=O, C=NR², -C(=O)O-, -C(=O)NR²-, NR², P(=O)(R²), -O-, -S-, SO or SO₂;
k has a value of 0 to 9, and
where one or more CH₂ units in the alkylene chain of formula (II-C) may be replaced by a divalent unit selected from C=O, C=NR⁵, -C(=O)O-, -C(=O)NR⁵-, Si(R⁵)₂, NR⁵, P(=O)(R⁵), O, S, SO and SO₂; and
where one or more H atoms in the alkylene chain of formula (II-C) may in each case be replaced by a radical R⁵.
where the sum of the proportions of the structural units that correspond to a structural unit of the formula (I) in the polymer is between 20 and 50 mol%, based on 100 mol% of all copolymerised monomers that are present as structural units in the polymer; and
where the sum of the proportions of the structural units that correspond to a structural unit A, B or C in the polymer is between 20 and 75 mol%, based on 100 mol% of all copolymerised monomers that are present as structural units in the polymer.

2. Polymer according to Claim 1, **characterised in that** R⁴ is selected on each occurrence, identically or differently, from aromatic ring systems having 6 to 20 aromatic ring atoms, which may be substituted by one or more radicals R².

3. Polymer according to Claim 1 or 2, **characterised in that** at least one group selected from groups Ar² and Ar⁴ contains precisely one or precisely two groups R⁴ in the ortho position to the nitrogen atom, where R⁴ is bonded to the group selected from groups Ar² and Ar⁴ directly or via a linker group X.

4. Polymer according to one or more of Claims 1 to 3, **characterised in that** the structural unit of the formula (I) corresponds to one of the formulae (I-1-A), (I-2-A-1), (I-2-A-2) and (I-2-A-3) 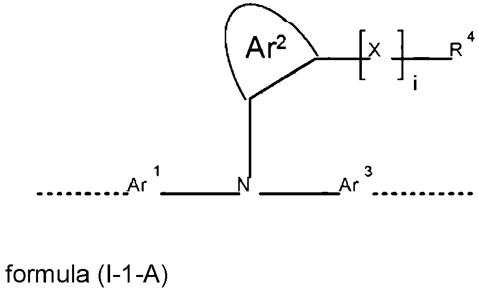 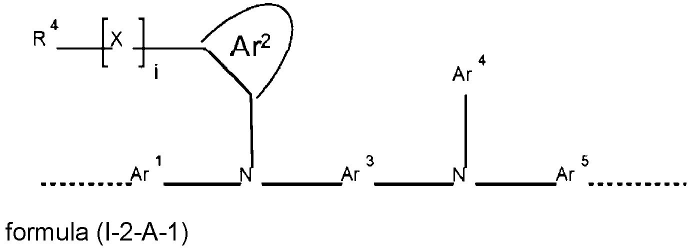 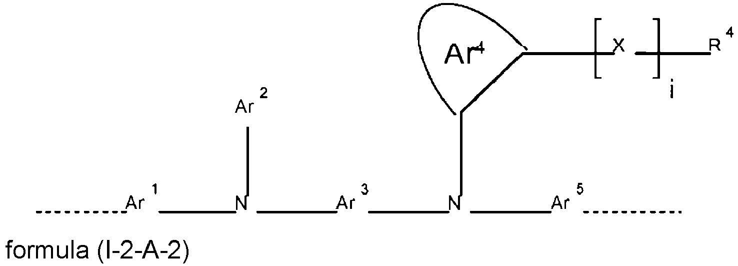 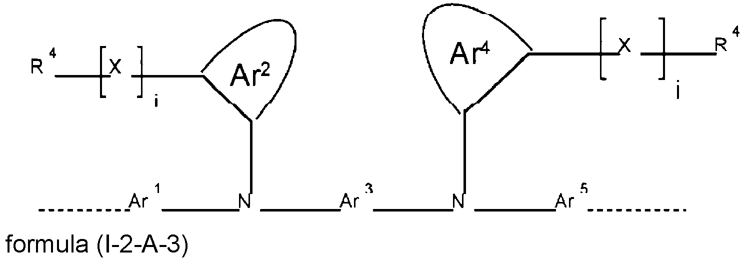 where i is equal to 0 or 1, and Ar¹, Ar², Ar³, Ar⁴, Ar³, X and R⁴ are defined as in Claim 1 or 2.

5. Polymer according to one or more of Claims 1 to 4, **characterised in that** the structural unit of the formula (I) corresponds to one of the formulae (I-1-B), (I-2-B-1), (I-2-B-2) and (I-2-B-3) 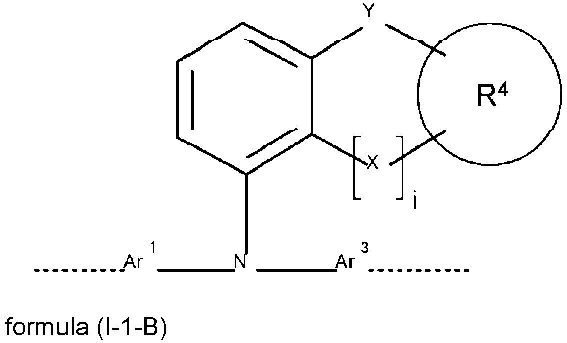 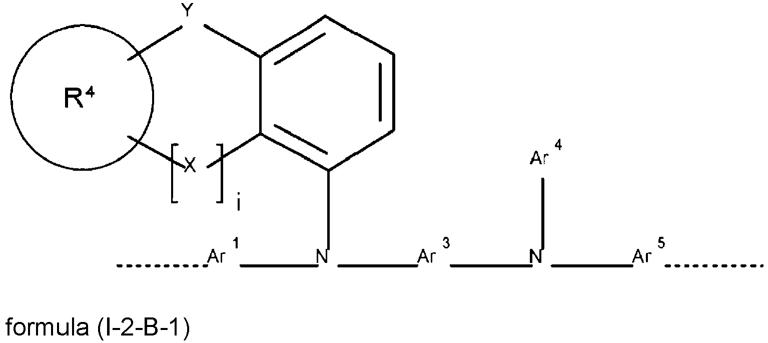 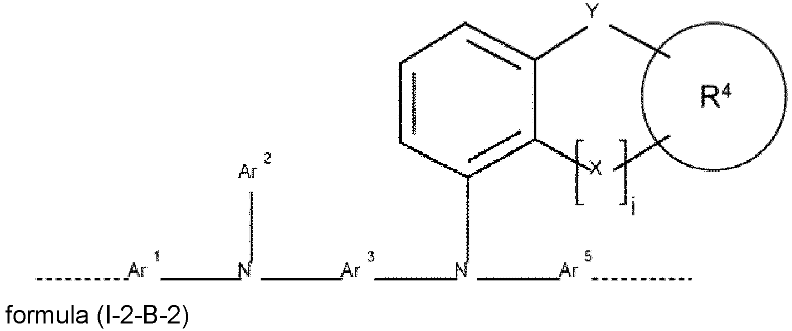 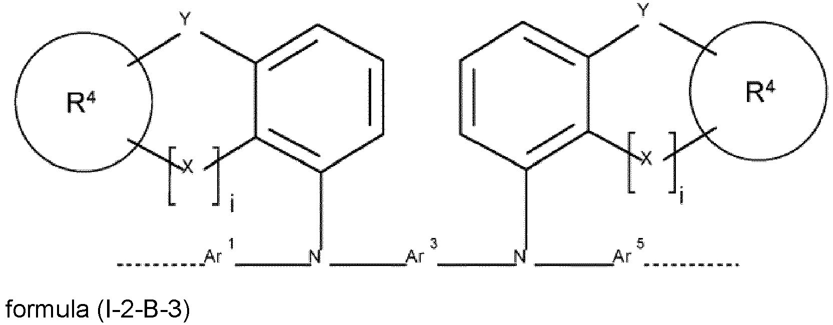 where i is equal to 0 or 1, where Y is selected on each occurrence, identically or differently, from a single bond, C(R²)₂, Si(R²)₂, NR², O, S and C=O, and where Ar¹, Ar², Ar³, Ar⁴, Ar³, X, and R⁴ are defined as in Claim 1 or 2.

6. Polymer according to one or more of Claims 1 to 5, **characterised in that** the structural unit of the formula (I) corresponds to one of the formulae (I-1-A-A), (I-1-A-B) and (I-1-B-A) 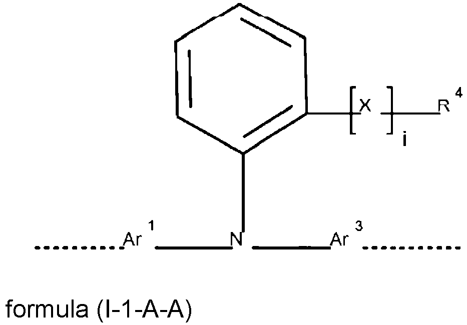 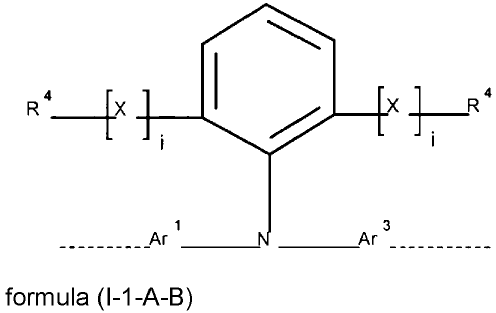 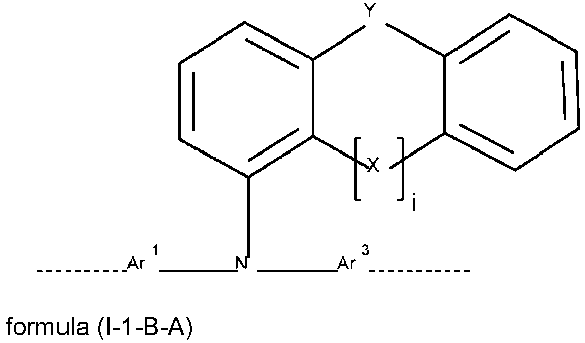 where i is equal to 0 or 1, and where the aromatic six-membered rings may in each case be substituted by a radical R¹ or R² at the positions drawn as unsubstituted, and where Y is selected on each occurrence, identically or differently, from a single bond, C(R²)₂, Si(R²)₂, NR², O, S and C=O, and where Ar¹, Ar³, R⁴ and X are defined as in Claim 1 or 2.

7. Polymer according to one or more of Claims 1 to 6, **characterised in that** the polymer contains at least one structural unit which has a crosslinkable group Q.

8. Polymer according to Claim 7, **characterised in that** the at least one structural unit which has a crosslinkable group is a structural unit of the formula (I), a structural unit A, a structural unit B, a structural unit C or a structural unit selected from triarylamine, fluorene, indenofluorene and spiro-bifluorene structural units.

9. Polymer according to Claim 7 or 8, **characterised in that** the proportion of structural units which have a crosslinkable group in the polymer is in the range from 1 to 50 mol%, based on 100 mol% of all copolymerised monomers that are present as structural units in the polymer.

10. Polymer obtainable by crosslinking reaction of a polymer according to one or more of Claims 7 to 9.

11. Process for the preparation of a polymer according to one or more of Claims 1 to 9, **characterised in that** a polymerisation selected from Suzuki polymerisation, Yamamoto polymerisation, Stille polymerisation and Hartwig-Buchwald polymerisation is carried out.

12. Mixture comprising at least one monomer of the formula (M-I) and at least one monomer selected from monomers of the formulae (M-II-A), (M-II-B) and (M-II-C) 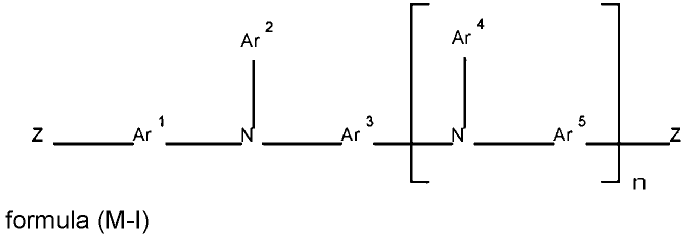 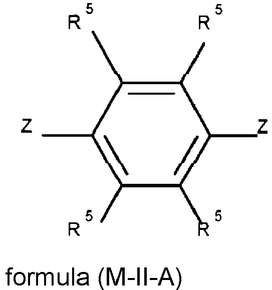 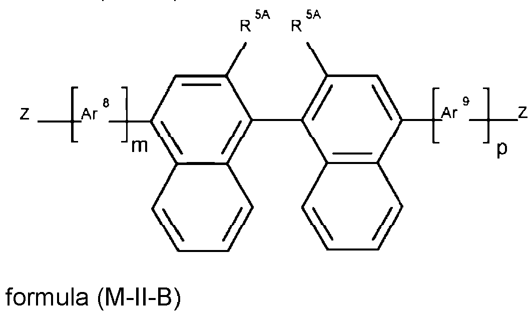 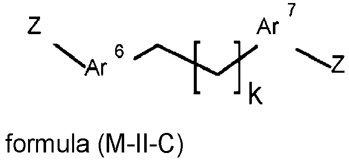
where the variables occurring are as defined in Claim 1, and where Z on each occurrence, identically or differently, represents a leaving group which is suitable for a polymerisation reaction; and where
the sum of the proportions of the monomers of the formula (M-1) is between 20 and 50 mol-%; and
where the sum of the proportions of the monomers of the formulae (M-II-A), (M-II-B) and (M-II-C) is between 20 and 75 mol-%.

13. Mixture comprising at least one polymer according to one or more of Claims 1 to 10 and one or more further polymeric, oligomeric, dendritic and/or low-molecular-weight substances.

14. Solution comprising one or more polymers according to one or more of Claims 1 to 10 and one or more solvents.

15. Use of a polymer according to one or more of Claims 1 to 10 in an electronic device.

16. Electronic device containing at least one polymer according to one or more of Claims 1 to 10.

17. Electronic device according to Claim 16, **characterised in that** the polymer according to one or more of Claims 1 to 10 is present in a layer selected from hole-transporting layer, hole-injection layer, electron-blocking layer and emitting layer.

18. Electronic device according to Claim 16 or 17, **characterised in that** it comprises a blue-fluorescent emitting layer which has been applied from solution.

## Revendications

1. Polymère contenant au moins un motif structurel de formule (I) 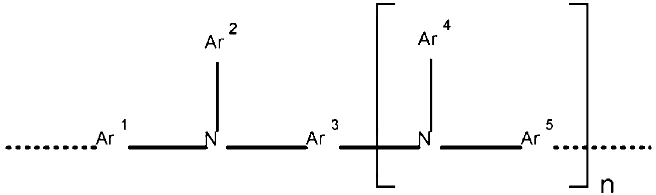 formule (I),
dans laquelle ce qui suit s'applique aux variables présentes :
Ar¹, Ar², Ar³, Ar⁴ et Ar⁵ sont choisis, de manière identique ou différente, parmi des noyaux hétéroaromatiques ayant de 5 à 40 atomes de cycle aromatique, qui peuvent être substitués par un ou plusieurs radicaux R¹, et parmi des noyaux aromatiques ayant de 6 à 40 atomes de cycle aromatique, qui peuvent être substitués par un ou plusieurs radicaux R¹, à condition qu'au moins l'un parmi les deux groupements Ar² et Ar⁴ soit dans chaque cas substitué par un groupement R⁴ dans au moins une position ortho par rapport à la liaison à N, où le groupement R⁴ peut former un cycle avec le groupement Ar² ou Ar⁴ correspondant auquel il est fixé, et où R⁴ est lié au groupement choisi parmi les groupements Ar² et Ar⁴ directement ou via un groupement de bras de liaison X ;
R¹ est choisi à chaque occurrence, de manière identique ou différente, parmi H, D, F, C(=O)R², CN, Si(R²)₃, N(R²)₂, P(=O)(R²)₂, OR², S(=O)R², S(=O)₂R², des groupements alkyle ou alcoxy à chaîne linéaire ayant de 1 à 20 atomes de C, des groupements alkyle ou alcoxy ramifiés ou cycliques ayant de 3 à 20 atomes de C, des groupements alcényle ou alcynyle ayant de 2 à 20 atomes de C, des noyaux aromatiques ayant de 6 à 40 atomes de cycle aromatique, et des noyaux hétéroaromatiques ayant de 5 à 40 atomes de cycle aromatique ; où deux, ou plus, radicaux R¹ peuvent être liés les uns aux autres et peuvent former un cycle ; où lesdits groupements alkyle, alcoxy, alcényle et alcynyle et lesdits noyaux aromatiques et noyaux hétéroaromatiques peuvent dans chaque cas être substitués par un ou plusieurs radicaux R² ; et où un ou plusieurs groupements CH₂ dans lesdits groupements alkyle, alcoxy, alcényle et alcynyle peuvent être remplacés par -R²C=CR²-, -C=C-, Si(R²)₂, C=O, C=NR², -C(=O)O-, -C(=O)NR²-, NR², P(=O)(R²), -O-, -S-, SO ou SO₂ ;
R² est choisi à chaque occurrence, de manière identique ou différente, parmi H, D, F, C(=O)R³, CN, Si(R³)₃, N(R³)₂, P(=O)(R³)₂, OR³, S(=O)R³, S(=O)₂R³, des groupements alkyle ou alcoxy à chaîne linéaire ayant de 1 à 20 atomes de C, des groupements alkyle ou alcoxy ramifiés ou cycliques ayant de 3 à 20 atomes de C, des groupements alcényle ou alcynyle ayant de 2 à 20 atomes de C, des noyaux aromatiques ayant de 6 à 40 atomes de cycle aromatique, et des noyaux hétéroaromatiques ayant de 5 à 40 atomes de cycle aromatique ; où deux, ou plus, radicaux R¹ et/ou R² peuvent être liés les uns aux autres et peuvent former un cycle ; où lesdits groupements alkyle, alcoxy, alcényle et alcynyle et lesdits noyaux aromatiques et noyaux hétéroaromatiques peuvent dans chaque cas être substitués par un ou plusieurs radicaux R³ ; et où un ou plusieurs groupements CH₂ dans lesdits groupements alkyle, alcoxy, alcényle et alcynyle peuvent être remplacés par -R³C=CR³-, -C≡C-, Si(R³)₂, C=O, C=NR³, -C(=O)O-, -C(=O)NR³-, NR³, P(=O)(R³), -O-, -S-, SO ou SO₂ ;
R³ est choisi à chaque occurrence, de manière identique ou différente, parmi H, D, F, CN, des groupements alkyle ou alcoxy ayant de 1 à 20 atomes de C, des groupements alcényle ou alcynyle ayant de 2 à 20 atomes de C, des noyaux aromatiques ayant de 6 à 40 atomes de cycle aromatique et des noyaux hétéroaromatiques ayant de 5 à 40 atomes de cycle aromatique ; où deux, ou plus, radicaux R³ peuvent être liés les uns aux autres et peuvent former un cycle ; et où lesdits groupements alkyle, alcoxy, alcényle et alcynyle, noyaux aromatiques et noyaux hétéroaromatiques peuvent être substitués par F ou CN ;
R⁴ est choisi à chaque occurrence, de manière identique ou différente, parmi des noyaux hétéroaromatiques ayant de 5 à 40 atomes de cycle aromatique, qui peuvent être substitués par un ou plusieurs radicaux R², et parmi des noyaux aromatiques ayant de 6 à 40 atomes de cycle aromatique, qui peuvent être substitués par un ou plusieurs radicaux R² ;
X est choisi à chaque occurrence, de manière identique ou différente, parmi C(R²)₂, Si(R²)₂, NR², O, S, et C=O ;
n est égal à 0 ou 1 ;
et au moins un motif structurel choisi parmi
- des motifs structurels A de formule (II-A) 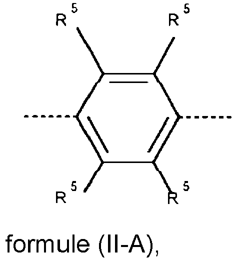
où la formule (II-A) contient au moins un groupement R⁵ qui est choisi parmi des groupements alkyle ou alcoxy à chaîne linéaire ayant de 1 à 20 atomes de C, des groupements alkyle ou alcoxy ramifiés ou cycliques ayant de 3 à 20 atomes de C, des groupements alcényle ou alcynyle ayant de 2 à 20 atomes de C, des noyaux aromatiques ayant de 6 à 40 atomes de cycle aromatique, et des noyaux hétéroaromatiques ayant de 5 à 40 atomes de cycle aromatique ; où lesdits groupements alkyle, alcoxy, alcényle et alcynyle et lesdits noyaux aromatiques et noyaux hétéroaromatiques peuvent dans chaque cas être substitués par un ou plusieurs radicaux R² ;
- des motifs structurels B de formule (II-B) 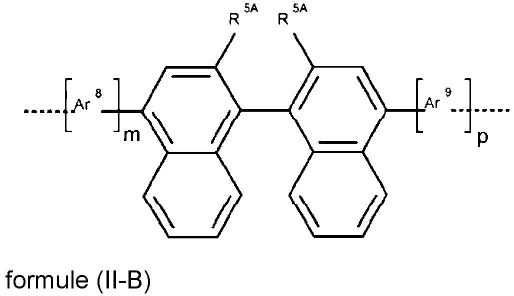
dans laquelle
R^{5A} est choisi à chaque occurrence, de manière identique ou différente, parmi H, D, F, C(=O)R², CN, Si(R²)₃, N(R²)₂, P(=O)(R²)₂, OR², S(=O)R², S(=O)₂R², des groupements alkyle ou alcoxy à chaîne linéaire ayant de 1 à 20 atomes de C, des groupements alkyle ou alcoxy ramifiés ou cycliques ayant de 3 à 20 atomes de C, des groupements alcényle ou alcynyle ayant de 2 à 20 atomes de C, des noyaux aromatiques ayant de 6 à 40 atomes de cycle aromatique, et des noyaux hétéroaromatiques ayant de 5 à 40 atomes de cycle aromatique ; où lesdits groupements alkyle, alcoxy, alcényle et alcynyle et lesdits noyaux aromatiques et noyaux hétéroaromatiques peuvent dans chaque cas être substitués par un ou plusieurs radicaux R² ; et où un ou plusieurs groupements CH₂ dans lesdits groupements alkyle, alcoxy, alcényle et alcynyle peuvent être remplacés par -R²C=CR²-, -C≡C-, Si(R²)₂, C=O, C=NR², -C(=O)O-, -C(=O)NR²-, NR², P(=O)(R²), -O-, -S-, SO ou SO₂ ;
Ar⁸ et Ar⁹ sont choisis à chaque occurrence, de manière identique ou différente, parmi des noyaux aromatiques ayant de 6 à 40 atomes de cycle aromatique, qui peuvent être substitués par un ou plusieurs radicaux R⁵, et des noyaux hétéroaromatiques ayant de 5 à 40 atomes de cycle aromatique, qui peuvent être substitués par un ou plusieurs radicaux R⁵ ;
m et p sont choisis à chaque occurrence, de manière identique ou différente, parmi 0 et 1 ;
et les groupements naphtyle peuvent dans chaque cas être substitués par un radical R⁵ au niveau des positions illustrées comme étant non substituées ; et
- des motifs structurels C qui correspondent à la formule (II-C) 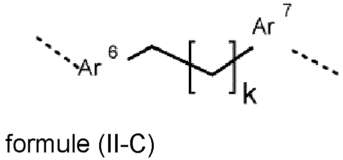
dans laquelle
Ar⁶ et Ar⁷ sont choisis à chaque occurrence, de manière identique ou différente, parmi des noyaux aromatiques ayant de 6 à 40 atomes de cycle aromatique, qui peuvent être substitués par un ou plusieurs radicaux R⁵, et des noyaux hétéroaromatiques ayant de 5 à 40 atomes de cycle aromatique, qui peuvent être substitués par un ou plusieurs radicaux R⁵ ;
R⁵ est choisi à chaque occurrence, de manière identique ou différente, parmi H, D, F, C(=O)R², CN, Si(R²)₃, N(R²)₂, P(=O)(R²)₂, OR², S(=O)R², S(=O)₂R², des groupements alkyle ou alcoxy à chaîne linéaire ayant de 1 à 20 atomes de C, des groupements alkyle ou alcoxy ramifiés ou cycliques ayant de 3 à 20 atomes de C, des groupements alcényle ou alcynyle ayant de 2 à 20 atomes de C, des noyaux aromatiques ayant de 6 à 40 atomes de cycle aromatique, et des noyaux hétéroaromatiques ayant de 5 à 40 atomes de cycle aromatique ; où lesdits groupements alkyle, alcoxy, alcényle et alcynyle et lesdits noyaux aromatiques et noyaux hétéroaromatiques peuvent dans chaque cas être substitués par un ou plusieurs radicaux R² ; et où un ou plusieurs groupements CH₂ dans lesdits groupements alkyle, alcoxy, alcényle et alcynyle peuvent être remplacés par -R²C=CR²-, -C≡C-, Si(R²)₂, C=O, C=NR², -C(=O)O-, -C(=O)NR²-, NR², P(=O)(R²), -O-, -S-, SO ou SO₂ ;
k possède une valeur allant de 0 à 9, et
où un ou plusieurs motifs CH₂ dans la chaîne alkylène de formule (II-C) peuvent être remplacés par un motif divalent choisi parmi C=O, C=NR⁵, -C(=O)O-, -C(=O)NR⁵-, Si(R⁵)₂, NR⁵, P(=O)(R⁵), O, S, SO et SO₂ ; et
où un ou plusieurs atomes de H dans la chaîne alkylène de formule (II-C) peuvent dans chaque cas être remplacés par un radical R⁵ ;
où la somme des proportions des motifs structurels qui correspondent à un motif structurel de formule (I) dans le polymère est comprise entre 20 et 50% molaire, sur la base de 100% molaire de tous les monomères copolymérisés qui sont présents comme motifs structurels dans le polymère ; et
où la somme des proportions des motifs structurels qui correspondent à un motif structurel A, B ou C dans le polymère est comprise entre 20 et 75% molaire, sur la base de 100% molaire de tous les monomères copolymérisés qui sont présents comme motifs structurels dans le polymère.

2. Polymère selon la revendication 1, **caractérisé en ce que** R⁴ est choisi à chaque occurrence, de manière identique ou différente, parmi des noyaux aromatiques ayant de 6 à 20 atomes de cycle aromatique, qui peuvent être substitués par un ou plusieurs radicaux R².

3. Polymère selon la revendication 1 ou 2, **caractérisé en ce qu'**au moins un groupement choisi parmi les groupements Ar² et Ar⁴ contient précisément un ou précisément deux groupements R⁴ en position ortho par rapport à l'atome d'azote, où R⁴ est lié au groupement choisi parmi les groupements Ar² et Ar⁴ directement ou via un groupement de bras de liaison X.

4. Polymère selon l'une ou plusieurs parmi les revendications 1 à 3, **caractérisé en ce que** le motif structurel de formule (I) correspond à l'une des formules (I-1-A), (I-2-A-1), (I-2-A-2) et (I-2-A-3) 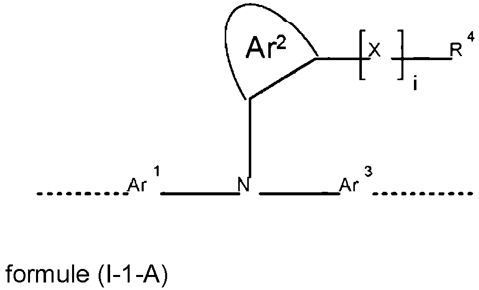 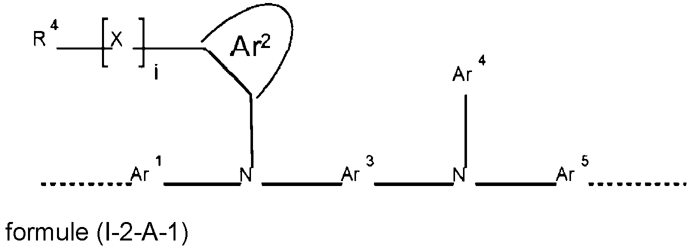 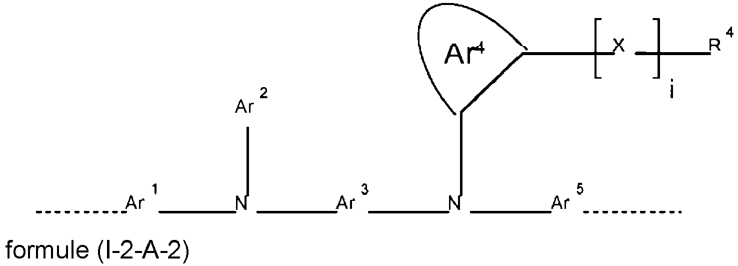 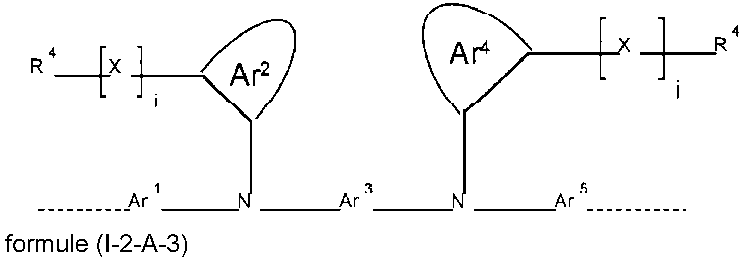 dans lesquelles i est égal à 0 ou 1, et Ar¹, Ar², Ar³, Ar⁴, Ar⁵, X et R⁴ sont tels que définis selon la revendication 1 ou 2.

5. Polymère selon l'une ou plusieurs parmi les revendications 1 à 4, **caractérisé en ce que** le motif structurel de formule (I) correspond à l'une des formules (I-1-B), (I-2-B-1), (I-2-B-2) et (I-2-B-3) 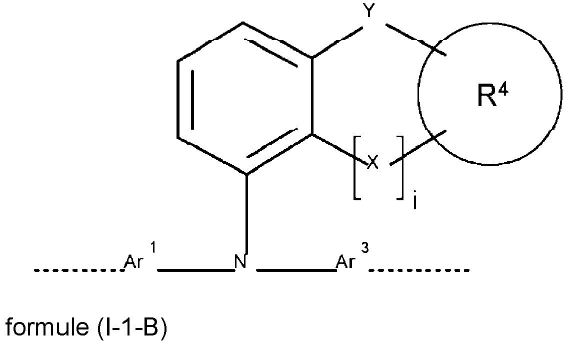 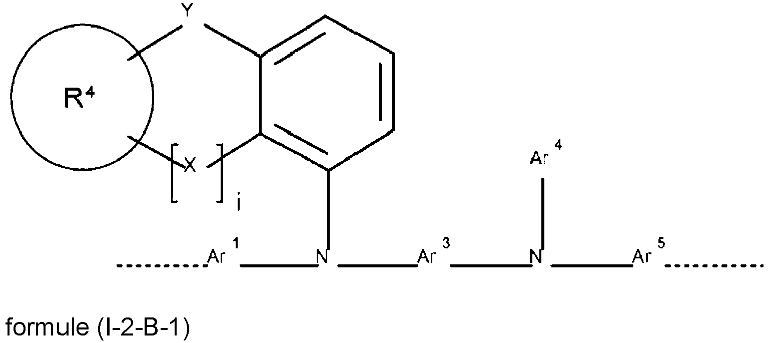 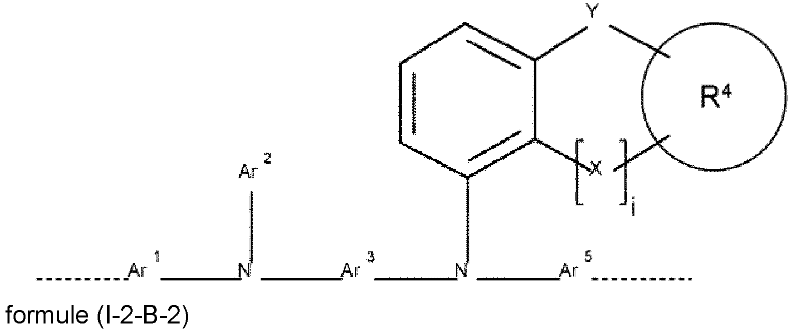 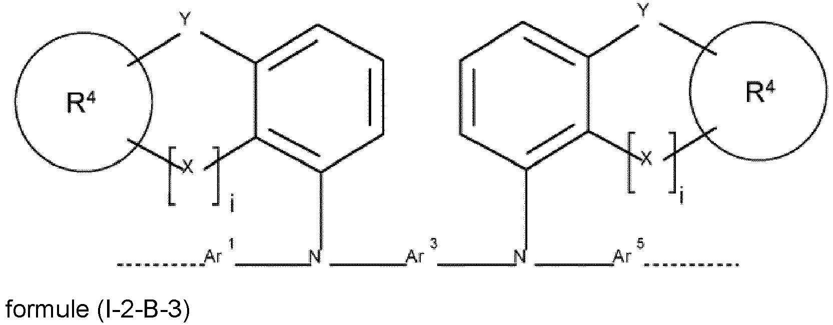 dans lesquelles i est égal à 0 ou 1, où Y est choisi à chaque occurrence, de manière identique ou différente, parmi une liaison simple, C(R²)₂, Si(R²)₂, NR², O, S et C=O, et où Ar¹, Ar², Ar³, Ar⁴, Ar⁵, X, et R⁴ sont tels que définis selon la revendication 1 ou 2.

6. Polymère selon l'une ou plusieurs parmi les revendications 1 à 5, **caractérisé en ce que** le motif structurel de formule (I) correspond à l'une des formules (I-1-A-A), (I-1-A-B) et (I-1-B-A) 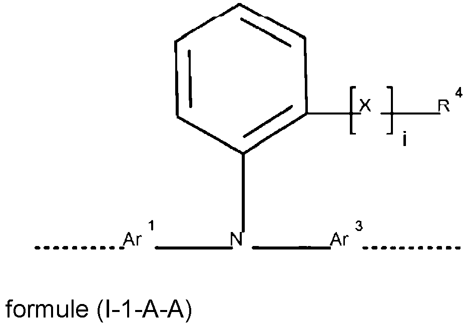 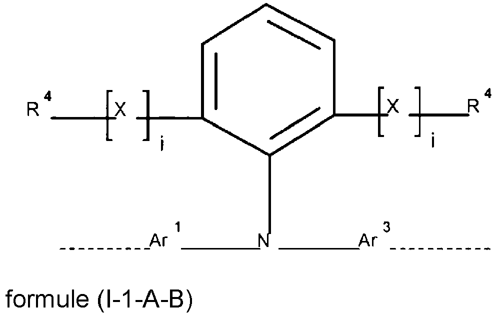 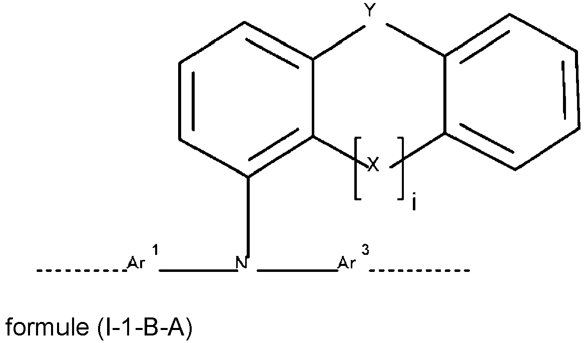 dans lesquelles i est égal à 0 ou 1, et où les cycles aromatiques de six chaînons peuvent dans chaque cas être substitués par un radical R¹ ou R² au niveau des positions illustrées comme étant non substituées, et où Y est choisi à chaque occurrence, de manière identique ou différente, parmi une liaison simple, C(R²)₂, Si(R²)₂, NR², O, S et C=O, et où Ar¹, Ar³, R⁴ et X sont tels que définis selon la revendication 1 ou 2.

7. Polymère selon l'une ou plusieurs parmi les revendications 1 à 6, **caractérisé en ce que** le polymère contient au moins un motif structurel qui possède un groupement réticulable Q.

8. Polymère selon la revendication 7, **caractérisé en ce que** le au moins un motif structurel qui possède un groupement réticulable est un motif structurel de formule (I), un motif structurel A, un motif structurel B, un motif structurel C ou un motif structurel choisi parmi les motifs structurels à base de triarylamine, fluorène, indénofluorène et spirobifluorène.

9. Polymère selon la revendication 7 ou 8, **caractérisé en ce que** la proportion de motifs structurels qui possèdent un groupement réticulable dans le polymère se trouve dans la plage allant de 1 à 50% molaire, sur la base de 100% molaire de tous les monomères copolymérisés qui sont présents comme motifs structurels dans le polymère.

10. Polymère pouvant être obtenu par une réaction de réticulation d'un polymère selon l'une ou plusieurs parmi les revendications 7 à 9.

11. Procédé de préparation d'un polymère selon l'une ou plusieurs parmi les revendications 1 à 9, **caractérisé en ce qu'**une polymérisation choisie parmi la polymérisation de Suzuki, la polymérisation de Yamamoto, la polymérisation de Stille et la polymérisation de Hartwig-Buchwald est mise en oeuvre.

12. Mélange comprenant au moins un monomère de formule (M-I) et au moins un monomère choisi parmi les monomères de formules (M-II-A), (M-II-B) et (M-II-C) 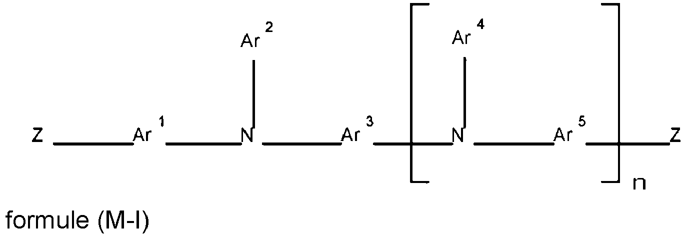 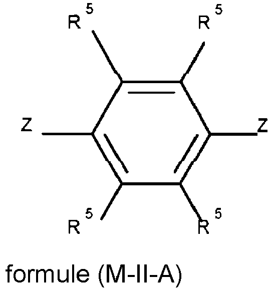 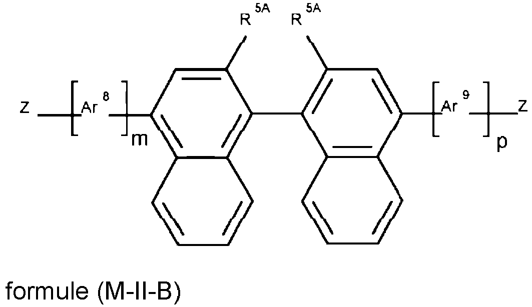 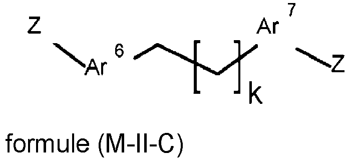
dans lesquelles les variables présentes sont telles que définies selon la revendication 1, et où Z à chaque occurrence, de manière identique ou différente, représente un groupement partant qui est convenable pour une réaction de polymérisation ; et où
la somme des proportions des monomères de formule (M-1) est comprise entre 20 et 50% molaire ; et
où la somme des proportions des monomères de formules (M-II-A), (M-II-B) et (M-II-C) est comprise entre 20 et 75% molaire.

13. Mélange comprenant au moins un polymère selon l'une ou plusieurs parmi les revendications 1 à 10, et une ou plusieurs autres substances polymères, oligomères, dendritiques et/ou de bas poids moléculaire.

14. Solution comprenant un ou plusieurs polymères selon l'une ou plusieurs parmi les revendications 1 à 10, et un ou plusieurs solvants.

15. Utilisation d'un polymère selon l'une ou plusieurs parmi les revendications 1 à 10, dans un dispositif électronique.

16. Dispositif électronique contenant au moins un polymère selon l'une ou plusieurs parmi les revendications 1 à 10.

17. Dispositif électronique selon la revendication 16, **caractérisé en ce que** le polymère selon l'une ou plusieurs parmi les revendications 1 à 10 est présent dans une couche choisie parmi une couche de transport de trous, une couche d'injection de trous, une couche de blocage d'électrons et une couche émettrice.

18. Dispositif électronique selon la revendication 16 ou 17, **caractérisé en ce qu'**il comprend une couche émettrice bleue-fluorescente qui a été appliquée à partir d'une solution.
